(19) Europäisches Patentamt
European Patent Office
Office européen des brevets

(11) EP 2 554 601 A1

(12) **EUROPEAN PATENT APPLICATION**
published in accordance with Art. 153(4) EPC

(43) Date of publication:
**06.02.2013 Bulletin 2013/06**

(21) Application number: **11765365.9**

(22) Date of filing: **18.03.2011**

(51) Int Cl.:
*C08L 83/07* (2006.01) *C08L 83/05* (2006.01)
*C08L 83/14* (2006.01) *H01L 23/29* (2006.01)
*H01L 23/31* (2006.01) *H01L 33/56* (2010.01)

(86) International application number:
**PCT/JP2011/056595**

(87) International publication number:
**WO 2011/125463 (13.10.2011 Gazette 2011/41)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:
**10.03.2011 JP 2011052423**
**14.12.2010 JP 2010277913**
**30.07.2010 JP 2010172091**
**26.07.2010 JP 2010167380**
**06.07.2010 JP 2010153904**
**21.04.2010 JP 2010098086**
**31.03.2010 JP 2010082102**

(71) Applicant: **Sekisui Chemical Co., Ltd.**
**Osaka-shi, Osaka 530-8565 (JP)**

(72) Inventors:
- **TANIKAWA, Mitsuru**
  **Mishima-gun**
  **Osaka 618-8589 (JP)**
- **WATANABE, Takashi**
  **Mishima-gun**
  **Osaka 618-8589 (JP)**
- **MORIGUCHI, Shintaro**
  **Kouka-shi**
  **Shiga 528-8585 (JP)**
- **INUI, Osamu**
  **Mishima-gun**
  **Osaka 618-8589 (JP)**
- **KUNIHIRO, Yoshitaka**
  **Mishima-gun**
  **Osaka 618-8589 (JP)**
- **YAMAZAKI, Ryosuke**
  **Mishima-gun**
  **Osaka 618-8589 (JP)**
- **OKI, Ayuko**
  **Mishima-gun**
  **Osaka 618-8589 (JP)**
- **IEDA, Yasuyuki**
  **Mishima-gun**
  **Osaka 618-8589 (JP)**
- **KIMU, Chizuru**
  **Mishima-gun**
  **Osaka 618-8589 (JP)**
- **KOBAYASHI, Yusuke**
  **Mishima-gun**
  **Osaka 618-8589 (JP)**

(74) Representative: **TER MEER - STEINMEISTER & PARTNER GbR**
**Mauerkircherstraße 45**
**DE-81679 München (DE)**

# (54) SEALANT FOR OPTICAL SEMICONDUCTORS AND OPTICAL SEMICONDUCTOR DEVICE

(57) The present invention provides a sealant for an optical semiconductor device which has high gas barrier property against corrosive gas, and is less likely to crack or is less likely to peel off even when used in harsh environments.

The sealant for an optical semiconductor device includes: a first silicone resin component including at least one of a first silicone resin A represented by formula (1A) shown below and a first silicone resin B represented by formula (1B) shown below, the first silicone resin A not containing a hydrogen atom bound to a silicon atom, but containing an aryl group and an alkenyl group, the first silicone resin B not containing a hydrogen atom bound to a silicon atom, but containing an aryl group and an alkenyl group; a second silicone resin component including at least one of a second silicone resin A represented by formula (51A) shown below and a second silicone resin B represented by formula (51B) shown below, the second silicone resin A containing an aryl group and a hydrogen atom directly bound to a silicon atom, the second silicone resin B containing an aryl group and a hydrogen atom directly bound to a silicon atom; and a catalyst for hydrosilylation reaction.

EP 2 554 601 A1

[FIG. 1]

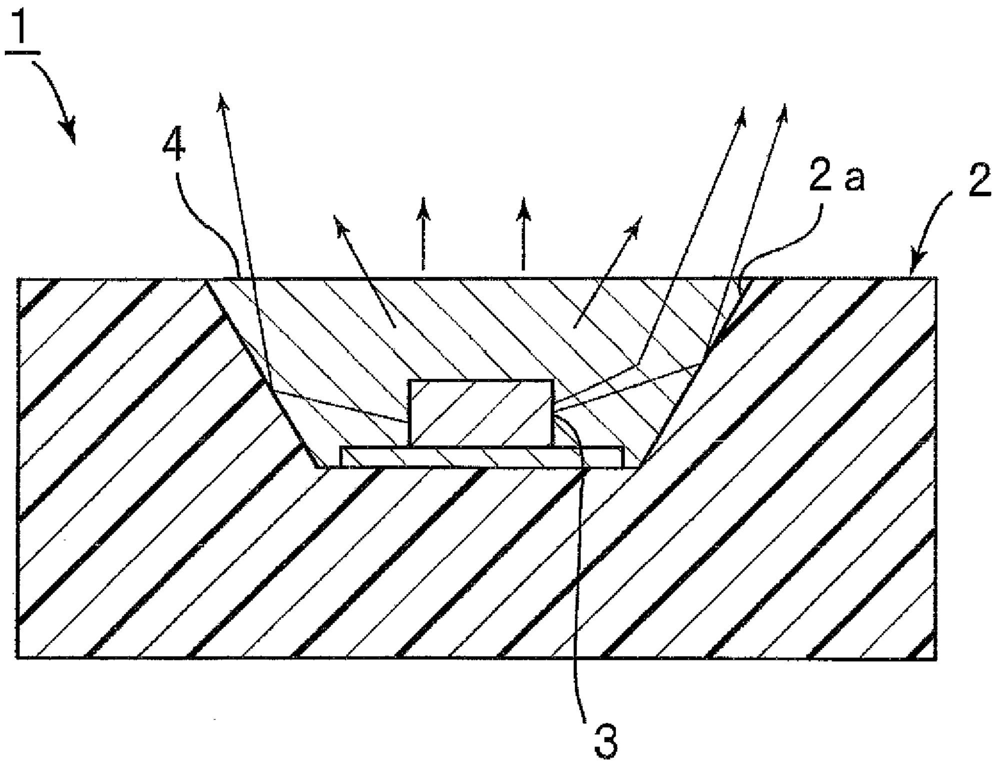

## Description

### TECHNICAL FIELD

The present invention relates to a sealant for an optical semiconductor device that is used for sealing an optical semiconductor element in an optical semiconductor device. The present invention also relates to an optical semiconductor device in which the sealant for an optical semiconductor device is used.

### BACKGROUND ART

Optical semiconductor devices such as light-emitting (LED) diode devices consume low power and have a long life. Moreover optical semiconductor devices can be used under harsh environments. For these reasons, optical semiconductor devices are used in a wide range of applications such as mobile phone backlight, liquid-crystal TV backlight, automobile lamps, lighting apparatuses, and signs.

When optical semiconductor elements (e.g. LED), which are light-emitting elements used in optical semiconductor devices are directly exposed to the atmosphere, the light-emitting performance of the optical semiconductor elements rapidly decreases due to moisture, floating dust, or the like in the atmosphere. To avoid this, such optical semiconductor elements are normally sealed with a sealant for an optical semiconductor device.

Patent Document 1 described below discloses an epoxy resin material including hydrogenated bisphenol A glycidyl ether, an alicyclic epoxy monomer, and a potential catalyst as a sealant for an optical semiconductor device. The epoxy resin material is cured by thermal cationic polymerization.

Patent Document 2 described below discloses an epoxy resin composition containing an epoxy resin, a specific epoxy-modified organopolysiloxane, a hardener, and inorganic oxide particles having a volume-average particle diameter of 1 to 100 nm, as a sealant for an optical semiconductor device. Silicon dioxide particles are exemplified as the inorganic oxide particles.

Meanwhile, sealants for optical semiconductor devices containing a silicone resin are also popularly used as well as sealants for optical semiconductor devices containing an epoxy resin. The silicone resin is highly transmissive to short-wavelength light in blue-to-ultraviolet spectrum, and is excellent in heat resistance and light resistance.

However, the above sealants containing the silicone resin have a problem that surfaces of cured products thereof are sticky, and thus foreign matters such as dirt tend to attach to the surface. Moreover, such sticky surfaces of the cured product cause sticking between packages, and adhesion to a pick-up nozzle upon installation. As a result, productivity of the optical semiconductor device problematically decreases.

Meanwhile, sealants containing a silicone resin having a high-crosslinking density are known, as Patent Document 3 below discloses.

Patent Document 1: JP 2003-73452 A Patent Document 2: JP 2009-227849 A Patent Document 3: JP 2002-314142 A

### SUMMARY OF THE INVENTION

### PROBLEMS TO BE SOLVED BY THE INVENTION

When a conventional sealant for an optical semiconductor device exemplified in Patent Document 1 is used in harsh environments with repeated heating and cooling, the sealant may peel off from a housing material and the like.

In order to reflect light arriving at the back side of a light-emitting element, a silver-plated electrode is provided at the back side of the light-emitting element in some cases. Cracking in the sealant or peeling of the sealant from the housing material causes exposure of the silver-plated electrode to the atmosphere. If this happens, the silver plating may be tarnished by corrosive gas in the atmosphere, such as hydrogen sulfide gas and sulfurous acid gas. The tarnished electrode reduces the reflectivity, problematically leading to reduction in the luminance of the light emitted by the light-emitting element.

In a conventional sealant for an optical semiconductor device exemplified in Patent Document 2, dispensability of inorganic oxide particles such as silicon dioxide particles may be low. For this reason, in the case where a phosphor is added to the sealant, or in the case the sealant contains a phosphor, the phosphor may be deposited due to the high specific gravity of the phosphor. As a result, the luminance of light extracted from the optical semiconductor device may be low.

If optical semiconductor devices are produced using the sealant for an optical semiconductor device in which the phosphor is deposited, the optical semiconductor devices thus obtained may emit different color lights from one another. Moreover, in the case of conventional sealants for an optical semiconductor device having an increased viscosity for preventing deposition of the phosphor, problematically the dispensability of the sealants is low due to the excessively

high viscosity.

With regard to a sealant disclosed in Patent Document 3 in which the silicone resin has high crosslinking density, stickiness of the surfaces of the cured product is relatively low. However, a sealant capable of further reducing stickiness on the surface of the cured product is strongly demanded. Also problematically, a sealant disclosed in Patent Document 3 has remarkably low mechanical strength and adhesiveness. Therefore, repeated heat cycles on the sealant disclosed in Patent Document 3 may cause cracking in the sealant or peeling of the sealant from the housing material and the like.

Moreover, optical semiconductor devices including a conventional sealant for an optical semiconductor device may have low moisture resistance. Namely, when optical semiconductor devices including a conventional sealant for an optical semiconductor device are used in harsh environments of high temperature and high humidity, problematically the luminance of the emitted light gradually decreases.

The present invention aims to provide a sealant for an optical semiconductor device which has a high gas barrier property against corrosive gas, and is less likely to crack or is less likely to peel off even when used in harsh environments. The present invention also aims to provide an optical semiconductor device in which the sealant for an optical semiconductor device is used.

A specific purpose of the present invention is to provide a sealant for an optical semiconductor device, which, when a phosphor is added thereto or included therein, can prevent deposition of the phosphor and has good dispensability. Furthermore, the sealant allows, when used in production of a plurality of optical semiconductor devices, the optical semiconductor devices thus produced to emit highly luminous light with colors hardly different from one device to another. The present invention also aims to provide an optical semiconductor device in which the above sealant for an optical semiconductor device is used.

A further specific porpoise of the present invention is to provide a sealant for an optical semiconductor device capable of preventing occurrence of stickiness on the surface thereof, and to provide an optical semiconductor device in which the sealant for an optical semiconductor device is used. Another specific purpose of the present invention is to provide a sealant for an optical semiconductor device which is highly reliable on the humidity resistance, and to provide an optical semiconductor device in which the sealant for an optical semiconductor device is used.

## MEANS FOR SOLVING THE PROBLEMS

A broad aspect of the present invention provides a sealant for an optical semiconductor device including
a first silicone resin component including at least one of a first silicone resin A represented by formula (1A) shown below and a first silicone resin B represented by formula (1B) shown below,
the first silicone resin A not containing a hydrogen atom bound to a silicon atom, but containing an aryl group and an alkenyl group,
the first silicone resin B not containing a hydrogen atom bound to a silicon atom, but containing an aryl group and an alkenyl group;
a second silicone resin component including at least one of a second silicone resin A represented by formula (51A) shown below and a second silicone resin B represented by formula (51B) shown below,
the second silicone resin A containing an aryl group and a hydrogen atom directly bound to a silicon atom,
the second silicone resin B containing an aryl group and a hydrogen atom directly bound to a silicon atom; and
a catalyst for hydrosilylation reaction,
wherein
an aryl group content in the first silicone resin A calculated based on formula (a1) shown below is from 30 mol% to 70 mol%,
a total content of the aryl group and a phenylene group in the first silicone resin B calculated based on formula (b1) shown below is from 30 mol% to 70 mol%,
an aryl group content in the second silicone resin A calculated based on formula (a51) shown below is from 30 mol% to 70 mol%, and
a total content of the aryl group and a phenylene group in the second silicone resin B calculated based on formula (b1) shown below is from 30 mol% to 70 mol%.

**[Chem. 1]**

$$(R1R2R3SiO_{1/2})_a(R4R5SiO_{2/2})_b(R6SiO_{3/2})_c \qquad \text{Formula(1A)}$$

In the formula (1A), a, b, and c satisfy the following equations: a/(a+b+c) = 0 to 0.50; b/(a+b+c) = 0.40 to 1.0; and c/(a+b+c) = 0 to 0.50, and
at least one of R1 to R6 represents a phenyl group corresponding to an aryl group, at least one of R1 to R6 represents an alkenyl group, and the rest of the R1 to R6 other than phenyl groups and alkenyl groups represent $C_1$ to $C_8$ hydrocarbon groups.

**[Chem. 2]**

$(R1R2R3SiO_{1/2})_a(R4R5SiO_{2/2})_b(R6SiO_{3/2})_c(R7R8R9R10Si_2R11O_{2/2})_d$ Formula(1B)

In the formula (1B), a, b, c and d satisfy the following equations: a/(a+b+c+d) = 0 to 0.40; b/(a+b+c+d) = 0.40 to 0.99; c/(a+b+c+d) = 0 to 0.50; and d/(a+b+c+d) = 0.01 to 0.40, and
at least one of R1 to R6 represents a phenyl group corresponding to an aryl group, at least one of R1 to R6 represents an alkenyl group, and the rest of the R1 to R6 other than phenyl groups and alkenyl groups represents $C_1$ to $C_8$ hydrocarbon groups, R7 to R10 each represent a $C_1$ to $C_8$ hydrocarbon group, and R11 represents a $C_1$ to $C_8$ bivalent hydrocarbon group.

**[Chem. 3]**

$(R51R52R53SiO_{1/2})_p(R54R55SiO_{2/2})_q(R56SiO_{3/2})_r$ Formula(51A)

In the formula (51A), p, q, and r satisfy the following equations: p/(p+q+r) = 0. 05 to 0. 50; q/ (p+q+r) = 0.05 to 0.50; and r/(p+q+r) = 0.20 to 0.80, and
at least one of R51 to R56 represents a phenyl group corresponding to an aryl group, at least one of R51 to R56 represents a hydrogen atom directly bound to a silicon atom, and the rest of the R51 to R56 other than phenyl groups and hydrogen atoms directly bound to a silicon atom represent $C_1$ to $C_8$ hydrocarbon groups.

**[Chem. 4]**

$(R51R52R53SiO_{1/2})_p(R54R55SiO_{2/2})_q(R56SiO_{3/2})_r(R57R58R59R60Si_2R61O_{2/2})_s$ Formula(51B)

In the formula (51B), p, q, r and s satisfy the following equations: p/(p+q+r+s) = 0.05 to 0.50; q/(p+q+r+s) = 0. 05 to 0.50; r/(p+q+r+s) = 0.20 to 0.80; and s/(p+q+r+s) = 0.01 to 0.40, and
at least one of R51 to R56 represents a phenyl group corresponding to an aryl group, at least one of R51 to R56 represents a hydrogen atom directly bound to a silicon atom, and the rest of the R51 to R56 other than phenyl groups and hydrogen atoms directly bound to a silicon atom represent $C_1$ to $C_8$ hydrocarbon groups, R57 to R60 each represent a $C_1$ to $C_8$ hydrocarbon group, and R61 represents a $C_1$ to $C_8$ bivalent hydrocarbon group.

(Formula a1)

[Aryl group content (mol%)] = [(Average number of aryl group included in one molecule of the first silicone resin A × Molecular weight of the aryl group) / (Number average molecular weight of the first silicone resin A)] × 100

(Formula b1)

[A total content of aryl group and phenylene group (mol%)] = [(Average number of aryl group included in one molecule of the first silicone resin B × Molecular weight of the aryl group + Average number of phenylene group included in one molecule of the first silicone resin B × Molecular weight of the phenylene group)/(Number average molecular weight of the first silicone resin B)] × 100

(Formula a51)

[Aryl group content (mol%)] = [(Average number of aryl group included in one molecule of the second silicone resin A × Molecular weight of the aryl group)/(Number average molecular weight of the second silicone resin A)] × 100

(Formula b51)

[A total content of aryl group and phenylene group (mol%)] = [(Average number of aryl group included in one molecule of the second silicone resin B × Molecular weight of the aryl group + Average number of phenylene group included in one molecule of the second silicone resin B × Molecular weight of the phenylene group)/(Number average molecular weight of the second silicone resin B)] × 100

In a specific aspect of the sealant for an optical semiconductor device according to the present invention, the sealant includes at least one of the first silicone resin B and the second silicone resin B.

In another specific aspect of the sealant for an optical semiconductor device according to the present invention, the first silicone resin component is the first silicone resin A,
the first silicone resin A contains a first silicone resin A-1 represented by formula (1A-1) shown below,

the first silicone resin A-1 not containing a hydrogen atom bound to a silicon atom, but containing an aryl group and an alkenyl group, and
an aryl group content in the first silicone resin A-1 calculated based on formula (a1-1) shown below is from 30 mol% to 70 mol%.

**[Chem. 5]**

$$(R1R2R3SiO_{1/2})_a(R4R5SiO_{2/2})_b \qquad \text{Formula(1A-1)}$$

In the formula (1A-1), a, and b satisfy the following equations: a/ (a+b) = 0. 05 to 0.50; and b/(a+b) = 0. 50 to 0.95, at least one of R1 to R5 represents a phenyl group corresponding to an aryl group, at least one of R1 to R5 represents an alkenyl group, and the rest of the R1 to R5 other than phenyl groups and alkenyl groups represent $C_1$ to $C_8$ hydrocarbon groups, provided that, a unit represented by ($R1R2R3SiO_{1/2}$) in the formula (1B) includes a unit in which R1 represents an alkenyl group, R2 and R3 each represent an alkenyl group, an aryl group, or a $C_1$ to $C_8$ hydrocarbon group.

(Formula a1-1)

[Aryl group content (mol%)] = [(Average number of aryl group included in one molecule of the first silicone resin A-1 × Molecular weight of the aryl group) / (Number average molecular weight of the first silicone resin A-1)] × 100

In yet another specific aspect of the sealant for an optical semiconductor devices according to the present invention, the first silicone resin A includes the first silicone resin A-1, and optionally includes a first silicone resin A-2 represented by formula (1A-2) shown below,
the first silicone resin A-2 not being equivalent to the first silicone resin A-1, not containing a hydrogen atom bound to a silicon atom, but containing an aryl group and an alkenyl group,
the aryl group content, in the case where the first silicone resin A-2 is included, in the first silicone resin A-2 calculated based on formula (a1-2) shown below is from 30 mol% to 70 mol%, and the amount of the first silicone resin A-1 in a total 100 wt% of the first silicone resin A-1 and the first silicone resin A-2 is more than 50 wt% and not more than 100 wt%.

**[Chem. 6]**

$$(R1R2R3SiO_{1/2})_a(R4R5SiO_{2/2})_b(R6SiO_{3/2})_c \qquad \text{Formula(1A-2)}$$

In the formula (1A-2), a, b and c satisfy the following equations: a/(a+b+c) = 0 to 0.50; b/(a+b+c) = 0.40 to 1.0; and c/(a+b+c) = 0 to 0.50, at least one of R1 to R6 represents a phenyl group corresponding to an aryl group, at least one of R4 to R6 represents an alkenyl group, and the rest of the R1 to R6 other than phenyl groups and alkenyl groups represent $C_1$ to $C_8$ hydrocarbon groups.

(Formula a1-2)

[Aryl group content (mol%)] = [(Average number of aryl group included in one molecule of the first silicone resin A-2 × Molecular weight of the aryl group) / (Number average molecular weight of the first silicone resin A-2)] × 100

In another specific aspect of the sealant for an optical semiconductor device according to the present invention, the first silicone resin A includes the first silicone resin A-1 and the first silicone resin A-2 represented by the formula (1A-2) shown above, the first silicone resin A-2 not being equivalent to the first silicone resin A-1, not containing a hydrogen atom bound to a silicon atom, but containing an aryl group and an alkenyl group, and
the aryl group content in the first silicone resin A-2 calculated based on the formula (a1-2) shown above is from 30 mol% to 70 mol%.

In yet another specific aspect of the sealant for an optical semiconductor device according to the present invention, the first silicone resin A include the first silicone resin A-1 and the first silicone resin A-2, and
the amount of the first silicone resin A-1 based on 100 parts by weight of the first silicone resin A-2 is from 5 parts by weight to 100 parts by weight.

In another specific aspect of the sealant for an optical semiconductor device according to the present invention, the second silicone resin component is the second silicone resin A.

In yet another specific aspect of the sealant for an optical semiconductor device according to the present invention, a unit represented by ($R51R52R53SiO_{1/2}$) in the formula (51A) includes in which R1 represents a hydrogen atom bound to a silicon atom, and R52 and R53 each represent a hydrogen atom, a phenyl group, or a $C_1$ to $C_8$ hydrocarbon group.

In another specific aspect of the sealant for an optical semiconductor device according to the present invention, the first silicone resin A and the second silicone resin B each include a diphenyl siloxane unit including one silicon atom and two phenyl groups bound to the silicon atom, and
the proportion of the diphenyl siloxane unit comprising one silicon atom and two diphenyl groups bound to the silicon atom in 100 mol% of the total siloxane unit of the first silicone resin A and the second silicone resin B is at least 30 mol%.

In yet another specific aspect of the sealant for an optical semiconductor device according to the present invention, the second silicone resin A and the second silicone resin B each include a unit represented by formula (51-a) shown below, and
the proportion of the unit represented by the formula (51-a) in 100 mol% of the total siloxane unit of the second silicone resin A and the second silicone resin B is at least 5 mol%.

**[Chem. 7]**

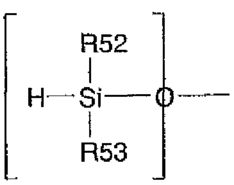

· · · Formula (51-a)

In the formula (51-a), R52 and R53 each represent a hydrogen atom, a phenyl group, or a $C_1$ to $C_8$ hydrocarbon group.

In another specific aspect of the sealant for an optical semiconductor device according to the present invention, silicone oxide particles are further included.

In yet another specific aspect of the sealant for an optical semiconductor device according to the present invention, the silicon oxide particles have undergone a surface treatment with an organic silicon compound.

In another specific aspect of the sealant for an optical semiconductor device, the organic silicon compound is at least one selected from the group consisting of an organic silicon compound containing a dimethyl silyl group, an organic silicon compound containing a trimethyl silyl group, and an organic silicon compound containing a polydimethyl siloxane group.

In yet another specific aspect of the sealant for an optical semiconductor device according to the present invention, each of the first silicone resin A and the first silicone resin B has a viscosity of 500 mPa·s to 20000 mPa·s measured with an E-type viscometer at 5 rpm at a temperature of 25°C, and
each of the second silicone resin A and the second silicone resin B has a viscosity of 500 mPa·s to 5000 mPa·s measured with an E-type viscometer at 5 rpm at a temperature of 25°C.

The sealant for an optical semiconductor device according to the present invention preferably has a viscosity of 1000 mPa·s to 10000 mPa·s measured with an E-type viscometer at 5 rpm at a temperature of 25°C.

The sealant for an optical semiconductor device according to the present invention preferably has a minimum viscosity at a shear rate of 1 $s^{-1}$ of at least 200 mPa·s in a temperature range of 25°C to the curing temperature, when heated in a parallel plate rheometer from 25°C at a temperature increase rate of 20°C/min.

In the sealant for an optical semiconductor device according to the present invention, preferably, the ratio of the viscosity of the sealant measured with an E-type viscometer at 1 rpm at a temperature of 25°C relative to the viscosity

of the sealant measured with an E-type viscometer at 10 rpm at a temperature of 25°C is 1.2 to 2.5.

Another aspect of the sealant for an optical semiconductor device according to the present invention further includes a phosphor.

An optical semiconductor device of the present invention includes an optical semiconductor element, and the sealant for an optical semiconductor device which is constructed according to the present invention and is provided to seal the optical semiconductor element.

## EFFECT OF THE INVENTION

The sealant for an optical semiconductor device according to the present invention includes a first silicone resin component including at least one of a first silicone resin A represented by formula (1A) or a first silicone resin B represented by formula (1B) each containing an aryl group and an alkenyl group; a second silicone resin component including at least one of a second silicone resin A represented by formula (51A) or a second silicone resin B represented by formula (51B) each containing an aryl group and a hydrogen atom directly bound to a silicon atom; and a catalyst for hydrosilylation reaction. In the first silicone resins A, B and the second silicone resins A,B, the content ratio of the aryl group or a total content of the aryl group and the phenylene group is within a specific range. Therefore, the sealant is excellent in gas barrier property.

Moreover, if an optical semiconductor element such as a light-emitting diode is sealed with the sealant for an optical semiconductor device according to the present invention, a crack hardly occurs in the cured sealant, and the cured sealant is less likely to peel off from a housing material and the like.

## BRIEF DESCRIPTION OF DRAWINGS

Fig. 1 is a front cross-sectional view showing an optical semiconductor device according to one embodiment of the present invention.

## MODES FOR CARRYING OUT THE INVENTION

The following description will discuss details of the present invention.
The sealant for an optical semiconductor device according to the present invention has a constitution X below.

Constitution X:

The sealant for an optical semiconductor device according to the present invention includes a first silicone resin component, a second silicone resin component, and a catalyst for hydrosilylation reaction.

The first silicone resin component is at least one of a first silicone resin A represented by formula (1A) which does not contain a hydrogen atom bound to a silicon atom but contains an aryl group and an alkenyl group, and a first silicone resin B represented by formula (1B) which does not contain a hydrogen atom bound to a silicon atom but contains an aryl group and an alkenyl group. The first silicone resin component may be formed only of the first silicone resin A, only of the first silicone resin B, or both of the first silicone resin A and the first silicone resin B.

The second silicone resin component is at least one of a second silicone resin A represented by formula (51A) which contains an aryl group and a hydrogen atom directly bound to a silicon atom and a second silicone resin B represented by formula (51B) which contains an aryl group and a hydrogen atom directly bound to a silicon atom. The second silicone resin component may be formed only of the second silicone resin A, only of the second silicone resin B, or both of the second silicone resin A and the second silicone resin B.

The aryl group content in the first silicone resin A calculated based on the formula (a1) is from 30 mol% to 70 mol%. The total content of the aryl group and a phenylene group in the second silicone resin B calculated based on the formula (b1) is from 30 mol% to 70 mol%. The aryl group content in the second silicone resin A calculated based on the formula (a51) is from 30 mol% to 70 mol%. The total content of the aryl group and the phenylene group in the second silicone resin B calculated based on the formula (b1) is from 30 mol% to 70 mol%.

The sealant having the constitution X has excellent gas barrier property, and is less likely to crack or is less likely to peel off.

The sealant for an optical semiconductor device according to the present invention is preferably provided with the constitution Y below in addition to the aforementioned constitution X.

Constitution Y:

The sealant for an optical semiconductor device according to the present invention preferably includes silicon

oxide particles which have undergone a surface treatment with an organic silicon compound, in addition to the first silicone resin component, the second silicone resin component, and the catalyst for hydrosilylation reaction. The first silicone resin A (which may include the first silicone resin A-1, A-2 described below) and the first silicone resin B having a diphenyl siloxane unit including one silicon atom and two phenyl groups bound to the silicon atom. The proportion of the diphenyl siloxane unit including one silicon atom and two diphenyl groups bound to the silicon atom in 100 mol% of the total siloxane unit of the first silicone resin A and the second silicone resin B is at least 30 mol%. Preferably, each of the first silicone resin A and the first silicone resin B has a viscosity of 500 mPa·s to 20000 mPa·s measured with an E-type viscometer at 5 rpm at a temperature of 25°C, and further, each of the second silicone resin A and the second silicone resin B has a viscosity of 500 mPa·s to 5000 mPa·s measured with an E-type viscometer at 5 rpm at a temperature of 25°C. Alternatively, the sealant for an optical semiconductor device preferably has a viscosity $\eta 1$ of 1000 mPa·s to 10000 mPa·s measured with an E-type viscometer at 5 rpm at a temperature of 25°C, and further, the ratio ($\eta 2/\eta 3$) of the viscosity $\eta 2$ of the sealant measured with an E-type viscometer at 1 rpm at a temperature of 25°C relative to the viscosity $\eta 3$ of the sealant measured with an E-type viscometer at 10 rpm at a temperature of 25°C is preferably 1.2 to 2.5.

If the sealant has the constitution Y, in the sealant added with a phosphor or containing a phosphor, deposition of the phosphor can be prevented. Also, the dispensability (application property) of the sealant can be enhanced. Moreover, when the sealant is used in production of a plurality of optical semiconductor devices, the optical semiconductor devices thus produced can emit highly luminous light with colors hardly different from one device to another.

The sealant for an optical semiconductor device of the present invention is preferably provided with a constitution Z below in addition to the aforementioned constitution X.

Constitution Z:

The sealant for an optical semiconductor device according to the present invention preferably includes the first silicone resin A-1 represented by the formula (1A-1) which does not contain a hydrogen atom bond to a silicon atom but contains an aryl group and an alkenyl group; the second silicone resin component; and the catalyst for hydrosilylation reaction. That is, the sealant for an optical semiconductor device according to the present invention preferably includes the first silicone resin A-1 as an essential component. In this case, the sealant for an optical semiconductor device of the present invention optionally includes the first silicone resin A-2 represented by the formula (1A-2), the first silicone resin A-2 not being equivalent to the first silicone resin A-1, not containing a hydrogen atom bound to a silicon atom, but containing an aryl group and an alkenyl group, contain or does not contain the first silicone resin A-2, may contain the first silicone resin A-2, and may not contain the first silicone resin A-2. The first silicone resin A-1 and the first silicone resin A-2 are included in the first silicone resin A.

If the sealant has the constitution Z including the first silicone resin A-1, the second silicone resin component, and the catalyst for hydrosilylation reaction, especially in the case where a unit represented by ($R1R2R3SiO_{1/2}$) in the formula (1A-1) includes in which R1 represents an alkenyl group, and R2 and R3 each represent an alkenyl group, an aryl group or a $C_1$ to $C_8$ hydrocarbon group, the stickiness on the surface of the sealant can be sufficiently suppressed. The advantage has been found by the inventors of the present invention.

Furthermore, by adopting the constitution Z which includes the first silicone resin A-1, the second silicone resin component, and a catalyst for hydrosilylation reaction, especially use of the first silicone resin A-1, the sealant for an optical semiconductor device can have a higher humidity-resistance reliability. Accordingly, if an optical semiconductor device using the sealant for an optical semiconductor device of the present invention therein is used in harsh environments with high temperature and high humidity, the luminance of the emitted light can be prevented from gradually decreasing. In the case where the amount of the first silicone resin A-1 in a total 100 wt% of the first silicone resin A-1 and the first silicone resin A-2 is more than 50 wt% and not more than 100 wt%, the humidity-resistance reliability of the sealant for an optical semiconductor device can be efficiently enhanced.

Moreover, if the sealant has a composition including the first silicone resin A, the first silicone resin B, the second silicone resin, and a catalyst for hydrosilylation reaction, cracking and peeling of the sealant are far less likely to occur, even if an optical semiconductor device using the sealant therein is used in harsh environments where the optical semiconductor device is repeatedly heated and cooled.

The sealant for an optical semiconductor device according to the present invention is preferably provided with other constitution below in addition to the aforementioned constitution X.

Other constitution:

The sealant for an optical semiconductor device according to the present invention preferably includes at least one of the first silicone resin B and the second silicone resin B in view of achieving a sealant having further enhanced gas barrier property with less chance of cracking and peeling.

The sealant for an optical semiconductor device of the present invention preferably includes the first silicone

resin A-1, the first silicone resin A-2, the second silicone resin component, and a catalyst for hydrosilylation reaction. In this case, cracking in the sealant and peeling of the sealant are far less likely to occur, even if an optical semiconductor device using the sealant therein is used in harsh environments with repeated heating and cooling.

(First silicone resins)

The first silicone resin component included in the sealant for an optical semiconductor device is at least one of a first silicone resin A represented by formula (1A) shown below which does not contain a hydrogen atom bound to a silicon atom but contains an aryl group and an alkenyl group, and a first silicone resin B represented by formula (1B) shown below which does not contain a hydrogen atom bound to a silicon atom but contains an aryl group and an alkenyl group.

The first silicone resin A and the first silicone resin B do not contain a hydrogen atom bound to a silicon atom, and thus are different from the second silicone resin component. In the first silicone resins A and B, preferably the alkenyl group is directly bound to a silicon atom, and the aryl group is directly bound to a silicon atom. Examples of the aryl group include unsubstituted phenyl groups and substituted phenyl groups. Meanwhile, the carbon atom in a carbon-carbon double bond of the alkenyl group may be bound to a silicon atom. Alternatively, a carbon atom different from the carbon atoms in the carbon-carbon double bond may be bound to a silicon atom. The silicone resin B represented by formula (1B) shown below may include a phenylene group or may not include a phenylene group. The first silicone resin A and the first silicone resin B each may be used solely, or in combination of two or more thereof.

**[Chem. 8]**

$$(R1R2R3SiO_{1/2})_a(R4R5SiO_{2/2})_b(R6SiO_{3/2})_c \qquad \text{Formula(1A)}$$

In the formula (1A), a, b, and c satisfy the following equations: a/(a+b+c) = 0 to 0.50; b/(a+b+c) = 0.40 to 1.0; and c/(a+b+c) = 0 to 0.50, and at least one of R1 to R6 represents a phenyl group corresponding to an aryl group; at least one of R1 to R6 represents an alkenyl group; and the rest of the R1 to R6 other than phenyl groups and alkenyl groups represent $C_1$ to $C_8$ hydrocarbon groups. In the formula (1A), a unit represented by ($R4R5SiO_{2/2}$) and a unit represented by ($R6SiO_{3/2}$) each may contain an alkoxy group or may contain a hydroxy group.

**[Chem. 9]**

$$(R1R2R3SiO_{1/2})_a\ (R4R5SO_{2/2})_b\ (R6SiO_{3/2})_c(R7R8R9R10Si_2R11O_{2/2})_d \qquad \text{Formula(1B)}$$

In the formula (1B), a, b, c and d satisfy the following equations: a/ (a+b+c+d) = 0 to 0.40; b/(a+b+c+d) = 0.40 to 0. 99; c/(a+b+c+d) = 0 to 0. 50; and d/(a+b+c+d) = 0.01 to 0.40, and at least one of R1 to R6 represents a phenyl group corresponding to an aryl group, at least one of R1 to R6 represents an alkenyl group, and the rest of the R1 to R6 other than phenyl groups and alkenyl groups represents $C_1$ to $C_8$ hydrocarbon groups, R7 to R10 each represent a $C_1$ to $C_8$ hydrocarbon group, and R11 represents a $C_1$ to $C_8$ bivalent hydrocarbon group. In the formula (1B), a unit represented by ($R4R5SiO_{2/2}$), a unit represented by ($R6SiO_{3/2}$),and a unit represented by ($R7R8R9R10Si_2R11O_{2/2}$) each may contain an alkoxy group or may contain a hydroxy group.

The first silicone resin A preferably includes a first silicone resin A-1 represented by formula (1A-1) which does not contain a hydrogen atom bound to a silicon atom, but contains an aryl group and an alkenyl group. In this case, the first silicone resin component includes the first silicone resin A, and is preferably the first silicone resin A.

**[Chem. 10]**

$$(R1R2R3SiO_{1/2})_a(R4R5SiO_{2/2})_b \qquad \text{Formula(1A-1)}$$

In the formula (1A-1), a, and b satisfy the following equations: a/(a+b) = 0. 05 to 0.50; and b/(a+b) = 0.50 to 0.95, at least one of R1 to R5 represents a phenyl group corresponding to an aryl group, at least one of R1 to R5 represents an alkenyl group, and the rest of the R1 to R5 other than phenyl groups and alkenyl groups represent $C_1$ to $C_8$ hydrocarbon groups, provided that, a unit represented by ($R1R2R3SiO_{1/2}$) in the formula (1A-1) includes an unit in which R1 represents an alkenyl group, R2 and R3 each represent an alkenyl group, an aryl group, or a $C_1$ to $C_8$ hydrocarbon group. Preferably, the unit represented by ($R1R2R3SiO_{1/2}$) in the formula (1A-1) includes a unit in which R1 represents an alkenyl group, and R2 and R3 each represent an alkenyl group, an aryl group, or a C1 to $C_8$ hydrocarbon group. In the formula (1A-1), a unit represented by ($R4R5SiO_{2/2}$) may contain an alkoxy group or may contain a hydroxy group.

Preferably, the first silicone resin A includes the first silicone resin A-1, and optionally includes a first silicone resin A-2 represented by formula (1A-2) shown below, which is not equivalent to the first silicone resin A-1, does not contain a hydrogen atom bound to a silicon atom, but contains an aryl group and an alkenyl group. Moreover, the first

silicone resin A preferably includes the first silicone resin A-2.

**[Chem. 11]**

$$(R1R2R3SiO_{1/2})_a(R4R5SiO_{2/2})_b(R6SiO_{3/2})_c \quad \text{Formula(1A-2)}$$

In the formula (1A-2), a, b and c satisfy the following equations: a/(a+b+c) = 0 to 0.50; b/(a+b+c) = 0.40 to 1.0; and c/(a+b+c) = 0 to 0.50, at least one of R1 to R6 represents a phenyl group corresponding to an aryl group, at least one of R4 to R6 represents an alkenyl group, and the rest of the R1 to R6 other than phenyl groups and alkenyl groups represent $C_1$ to $C_8$ hydrocarbon groups. In the formula (1A-2), a unit represented by $(R4R5SiO_{2/2})$ and a unit represented by $(R6SiO_{3/2})$ each may contain an alkoxy group or may contain a hydroxy group.

The formula (1A), the formula (1A-1), the formula (1A-2), and the formula (1B) each are an average composition formula. Hydrocarbon groups in the formula (1A), the formula (1A-1), the formula (1A-2), and the formula (1B) may be linear or branched chains. R1 to R6 in the formula (1A), the formula (1A-2), and the formula (1B) may be the same or different from one another. R1 to R5 in the formula (1A-1) may be the same or different from one another. R7 to R10 in the formula (1B) may be the same or different from one another.

The oxygen atom part in the unit represented by $(R4R5SiO_{2/2})$, the oxygen atom part in the unit represented by $(R6SiO_{3/2})$, and the oxygen atom part in the unit represented by $(R7R8R9R10Si_2R11O_{2/2})$ in the formula (1A), the formula (1A-1), and the formula (1B) each are an oxygen atom part forming a siloxane bond, an oxygen atom part in the alkoxy group, or an oxygen atom part in the hydroxy group.

Generally, in the respective units of the formula (1A), the formula (1A-1), the formula (1A-2) and the formula (1B), an alkoxy group content is small, and also a hydroxy group content is small as well. This is because, when an organic silicon compound such as an alkoxy silane compound is hydrolyzed and polymerized to provide the first silicone resins A and B, most of the alkoxy groups and the hydroxy groups are normally converted to form a partial structure of a siloxane bond. Namely, the oxygen atom in the alkoxy group and the oxygen atom in the hydroxy group are mostly converted to the oxygen atoms forming the siloxane bond. Presence of an alkoxy group or a hydroxy group in each of the units of the formula (1A), the formula (1A-1), the formula (1A-2) and the formula (1B) indicates that unreacted alkoxy group or hydroxy group not converted to the partial structure of the siloxane bond remains in a small amount. The same is true to the case where respective units of below-mentioned formula (51A) and formula (51B) include an alkoxy group and a hydroxy group.

Examples of the alkenyl group in the formula (1A), the formula (1A-1), the formula (1A-2), and the formula (1B) include a vinyl group, an allyl group, a butenyl group, a pentenyl group, and a hexenyl group. In terms of further enhancing the gas barrier property, the alkenyl group in the formula (1A), the formula (1A-1), the formula (1A-2), and the formula (1B) is preferably a vinyl group or an allyl group, and more preferably a vinyl group.

The $C_1$ to $C_8$ hydrocarbon group in the formula (1A), the formula (1A-1), the formula (1A-2), and the formula (1B) is not particularly limited, and examples thereof include a methyl group, an ethyl group, an n-propyl group, an n-butyl group, an n-pentyl group, an n-hexyl group, an n-heptyl group, an n-octyl group, an isopropyl group, an isobutyl group, a sec-butyl group, a t-butyl group, an isopentyl group, a neopentyl group, a t-pentyl group, an isohexyl group, and a cyclohexyl group. The $C_1$ to $C_8$ bivalent hydrocarbon group in the formula (1B) is not particularly limited, and examples thereof include a methylene group, an ethylene group, a propylene group, a butylene group, a pentylene group, a hexylene group, a cyclohexylene group, and a phenylene group.

The aryl group content in the silicone resin A represented by the formula (1A) calculated by formula (a1) shown below is 30 mol% to 70 mol%.

(Formula a1)

[Aryl group content (mol%)] = [(Average number of aryl group included in one molecule of the first silicone resin A × Molecular weight of the aryl group)/(Number average molecular weight of the first silicone resin A)] × 100

The aryl group content in the silicone resin A-1 represented by the formula (1A-1) calculated by formula (a1-1) shown below is 30 mol% to 70 mol%.

(Formula a1-1)

[Aryl group content (mol%)] = [(Average number of aryl group included in one molecule of the first silicone resin A-1 × Molecular weight of the aryl group) / (Number average molecular weight of the first silicone resin A-1)] × 100

The aryl group content in the silicone resin A-2 represented by the formula (1A-2) calculated by formula (a1-2) shown below is 30 mol% to 70 mol%.

(Formula a1-2)

[Aryl group content (mol%)] = [(Average number of aryl group included in one molecule of the first silicone resin A-2 × Molecular weight of the aryl group) / (Number average molecular weight of the first silicone resin A-2)] × 100

The aryl group content in the first silicone resins A, A-1, and A-2 calculated by the formulae (a1), (a1-1), and (a1-2), respectively, of less than 30 mol% results in insufficient gas barrier property. The aryl group content of more than 70 mol% tends to cause peeling of the sealant. In terms of far more enhancing the gas barrier property, the aryl group content is preferably at least 35 mol%. In terms of further preventing peeling of the sealant, the aryl group content is preferably at most 65 mol%.

A total content of an aryl group and a phenylene group in the first silicone resin B represented by the formula (1B) calculated based on formula (b1) shown below is from 30 mol% to 70 mol%.

(Formula b1)

[A total content of aryl group and phenylene group (mol%)] = [(Average number of aryl group included in one molecule of the first silicone resin B × Molecular weight of the aryl group + Average number of phenylene group included in one molecule of the first silicone resin B × Molecular weight of the phenylene group) / (Number average molecular weight of the first silicone resin B)] × 100

If the total content of the aryl group and the phenylene group in the first silicone resins B calculated by the formula (b1) is less than 30 mol%, the gas barrier property is insufficient. The total content of the aryl group and the phenylene group of more than 70 mol% tends to cause peeling of the sealant. In terms of far more enhancing the gas barrier property, the total content of the aryl group and the phenylene group is preferably at least 35 mol%. In terms of further preventing peeling of the sealant, the total content of the aryl group and the phenylene group is preferably at most 65 mol%.

In the case where the silicone resin represented by the formula (1B) does not include a phenylene group, the total content of the aryl group and the phenylene group means the aryl group content.

The first silicone resins A, A-1, A-2, and B each are preferably organopolysiloxane. The first silicone resins A, A-1, A-2, and B each preferably include a diphenyl siloxane unit containing one silicon atom and two phenyl groups bound to the silicon atom. Proportion of the diphenyl siloxane unit containing one silicone atom and two phenyl groups bound to the silicone atom in 100 mol% of the total siloxane unit of the first silicone resins A, A-1, A-2, and B is preferably at least 30 mol%. The proportion of the diphenyl siloxane unit of at least 30 mol% results in better dispensability of the sealant and, furthermore, higher luminance of light extracted from a plurality of optical semiconductor devices. The proportion of the diphenyl siloxane unit is preferably at least 40 mol% and preferably at most 60 mol%. The proportion of the diphenyl siloxane unit of not more than the upper limit results in better dispensability of the sealant and higher luminance of the light extracted from the semiconductor devices. This effect is exhibited in the same manner between the case where the first silicone resins A, A-1, or A-2 is used and the case where the first silicone resin B is used.

In one preferable example, the first silicone resin component is the first silicone resin A, the first silicone resin A includes a diphenyl siloxane unit containing one silicone atom and two phenyl groups bound to the silicon atom, and the proportion of the biphenyl siloxane unit containing one silicon atom and two phenyl groups bound to the silicon atom in 100 mol% of the total siloxane unit in the first silicone resin A is at least 30 mol%.

The diphenyl siloxane unit is preferably a unit represented by formula (1-b1) shown below. In the unit represented by the formula (1-b1), generally, an oxygen atom at the terminal position and an adjacent silicon atom form a siloxane bond, and the oxygen atom is shared with the adjacent unit. Therefore, one of the terminal oxygen atoms is expressed as "$O_{1/2}$."

**[Chem. 12]**

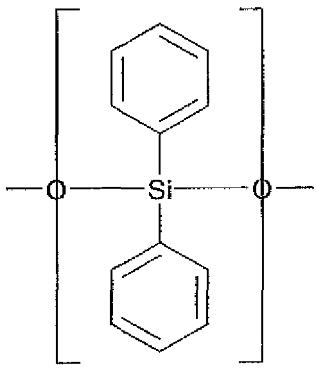
···Formula (1-b1)

In the formulae (1A), (1A-1), (1A-2), and (1B), a unit represented by ($R4R5SiO_{2/2}$) preferably includes the unit represented by the formula (1-b1). The unit represented by ($R4R5SiO_{2/2}$) may include only the unit represented by formula (1-b1) or may include the unit represented by the formula (1-b1) and units other than the unit represented by the formula (1-b1).

The first silicone resins A, A-1, A-2, and B each preferably have a viscosity of 500 mPa·s to 20000 mPa·s measured with an E-type viscometer at 5 rpm at a temperature of 25°C. The first silicone resin A having a viscosity in the above range further prevents deposition of the phosphor, further enhances the dispensability of the sealant, and further increases the luminance of the light extracted from the optical semiconductor devices.

Preferably, a unit represented by ($R1R2R3SiO_{1/2}$) in the formula (1A-1) includes a unit in which R1 represents an alkenyl group, and R2 and R3 each represent an alkenyl group, an aryl group, or a $C_1$ to $C_8$ hydrocarbon group. Namely, the unit represented by the formula ($R1R2R3SiO_{1/2}$) in the formula (1A-1) preferably includes a unit represented by formula (1-a) shown below. The unit represented by ($R1R2R3SiO_{1/2}$) may include only the unit represented by formula (1-a) or may include the unit represented by the formula (1-a) and units other than the unit represented by the formula (1-a). In the unit represented by the formula (1-a), generally, an oxygen atom at the terminal position and an adjacent silicon atom form a siloxane bond, and the oxygen atom is shared with the adjacent unit. Therefore, one of the terminal oxygen atoms is expressed as "$O_{1/2}$."

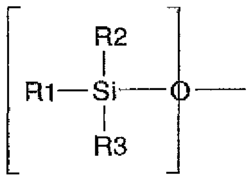

···Formula (1-a)

In the formula (1-a), R1 represents an alkenyl group, and R2 and R3 each represent an alkenyl group, a phenyl group, or a $C_1$ to $C_8$ hydrocarbon group. R2 and R3 each preferably represent a phenyl group, or a $C_1$ to $C_8$ hydrocarbon group.

In terms of further reducing stickiness on the surface of the sealant, the proportion of the unit represented by ($R1R2R3SiO_{1/2}$) in which R1 represents an alkenyl group, and R2 and R3 each represent an alkenyl group, a phenyl group, or a $C_1$ to $C_8$ hydrocarbon group (i.e., the unit represented by the formula (1-a)), in 100 mol% of the total unit in the formula (1A-1) is preferably at least 5 mol%, and preferably at most 50 mol%, more preferably at most 45 mol%, further preferably at most 40 mol%.

In terms of further enhancing the gas barrier property, the unit ($R7R8R9R10Si_2R11O_{2/2}$) in the formula (1B) is preferably a unit represented by formula (1b-1) shown below. The unit represented by the formula (b-1) includes a phenylene group, and the phenylene group is a substituted or unsubstituted phenylene group. The term "phenylene group" used herein also includes a substituted phenylene group in which the $C_1$ to $C_8$ hydrocarbon group is replaced by a benzene ring. In the unit represented by the formula (1b-1), generally an oxygen atom at the terminal position and an adjacent silicon atom form a siloxane bond, and the oxygen atom is shared with the adjacent unit. Therefore, one of the terminal oxygen atoms is expressed as "$O_{1/2}$."

**[Chem. 14]**

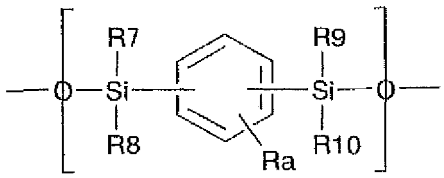

···Formula (1b-1)

In the formula (1b-1), Ra represents a hydrogen atom or a $C_1$ to $C_8$ hydrocarbon group, and R7 to R10 each represent a $C_1$ to $C_8$ hydrocarbon group. The hydrocarbon group may be a linear or branched chain. Binding sites of the three groups to the benzene ring in the formula (1b-1) are not particularly limited.

The unit ($R7R8R9R10Si_2R11O_{2/2}$) in the formula (1B) is preferably a unit represented by formula (1b-2) shown below. The unit represented by the formula (1b-2) includes a phenylene group, and the phenylene group is a substituted or unsubstituted phenylene group. A binding site of the Ra to the benzene ring in the formula (1b-2) is not particularly limited.

**[Chem. 15]**

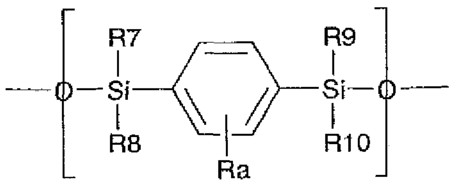

···Formula (1b-2)

In the formula (1b-2), Ra represents a hydrogen atom or a $C_1$ to $C_8$ hydrocarbon group, and R7 to R10 each represent a $C_1$ to $C_8$ hydrocarbon group.

The unit ($R7R8R9R10Si_2R11O_{2/2}$) in the formula (1B) is more preferably a unit represented by formula (1b-3) shown below. The unit represented by the formula (1b-3) includes a phenylene group, and the phenylene group is an unsubstituted phenylene group.

**[Chem. 16]**

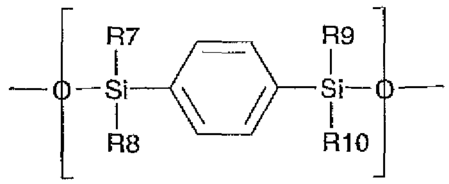

···Formula (1b-3)

In the formula (1b-3), R7 to R10 each represent a $C_1$ to $C_8$ hydrocarbon group.

In the first silicone resins A, A-1, A-2, and B represented by the formulae (1A), (1A-1), (1A-2), and (1B), respectively, a unit represented by ($R4R5SiO_{2/2}$) (hereinafter, also referred to as a bi-functional unit) may include a unit represented by formula (1-2) shown below, i.e., a structure in which one of oxygen atoms bound to a silicon atom in the bi-functional unit constitutes a hydroxy group or an alkoxy group.

(Formula 1-2) ($R4R5SiXO_{1/2}$)

The unit represented by ($R4R5SiO_{2/2}$) may include a moiety surrounded by dashed lines of a unit represented by formula (1-b) shown below, and may also include a moiety surrounded by dashed lines of a unit represented by formula (1-2-b) shown below. Namely, a unit including groups represented by R4 and R5, and an alkoxy group or a hydroxy group remaining at a terminal position is also included in the unit represented by ($R4R5SiO_{2/2}$). Specifically, in the case where the alkoxy group has been converted into a partial skeleton of the siloxane bond, the unit represented by ($R4R5SiO_{2/2}$) corresponds to the moiety surrounded by dashed lines of a unit represented by the formula (1-b) shown below. In the case where an unreacted alkoxy group remains, or where the alkoxy group has been converted into a hydroxy group, the unit represented by ($R4R5SiO_{2/2}$) including the remaining alkoxy group or hydroxy group corresponds to the moiety surrounded by dashed lines of a unit represented by the formula (1-2-b) shown below.

**[Chem. 17]**

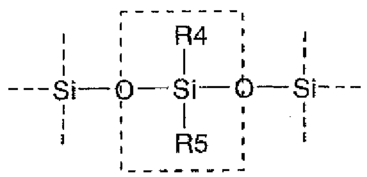

···Formula (1-b)

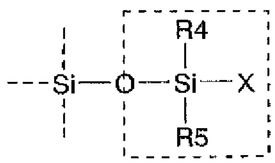

···Formula (1-2-b)

In the formulae (1-2) and (1-2-b), X represents OH or OR, and the OR represents a linear or branched $C_1$ to $C_4$ alkoxy group. R4 and R5 in the formulae (1-b), (1-2), and (1-2-b) are respectively the same groups as the R4 and R5 in the formulae (1A-1), (1A-2), and (1B).

In the first silicone resins A, A-2, and B represented by the formulae (1A), (1A-2), and (1B), respectively, a unit represented by ($R6SiO_{3/2}$) (hereinafter, also referred to as trifunctional unit) may include a structure represented by formula (1-3) or (1-4) shown below, namely a structure in which the two oxygen atoms bound to a silicon atom in the trifunctional unit each constitute a hydroxy group or an alkoxy group, or a structure in which one of the two oxygen atoms bound to a silicon atom in the trifunctional unit constitutes a hydroxy group or an alkoxy group.

Formula (1-3) ($R6SiX_2O_{1/2}$)

Formula (1-4) ($R6SiXO_{2/2}$)

The unit represented by ($R6SiO_{3/2}$) may include a moiety surrounded by dashed lines of a unit represented by formula (1-c) shown below, and may further include a moiety surrounded by dashed lines of a unit represented by formula (1-3-c) or (1-4-c) shown below. Namely, a unit including a group represented by R6 and further including an alkoxy group or a hydroxy group remaining at a terminal position is also included in the unit represented by ($R6SiO_{3/2}$).

**[Chem. 18]**

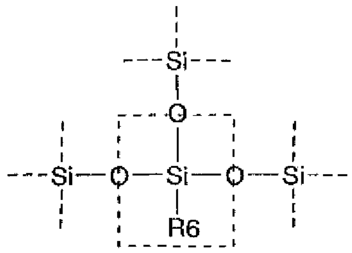
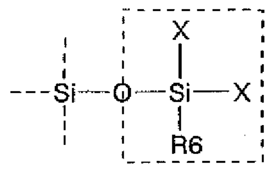
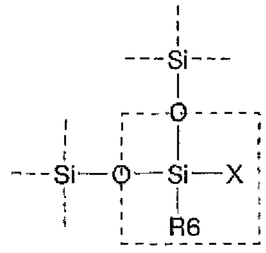

···Formula (1-c) ···Formula (1-3-c) ···Formula (1-4-c)

In the formulae (1-3), (1-3-c), (1-4), and (1-4-c), X represents OH or OR, and the OR represents a linear or branched C1 to C4 alkoxy group. R6 in the formulae (1-c), (1-3), (1-3-c), (1-4), and (1-4-c) is the same group as the R6 in the formulae (1A), (1A-2), and (1B).

In the first silicone resin B represented by the formula (1B), the unit represented by ($R7R8R9R10Si_2R11O_{2/2}$) may include a structure represented by formula (1-5) shown below, namely a structure in which one of oxygen atoms bound to a silicon atom in the unit ($R7R8R9R10Si_2R11O_{2/2}$) constitutes an hydroxy group or an alkoxy group.

Formula (1-5) ($R7R8R9R10Si_2R11XO_{1/2}$)

The unit represented by ($R7R8R9R10Si_2R11O_{2/2}$) may include a moiety surrounded by dashed lines of a unit represented by formula (1-d) shown below, and may further include a moiety surrounded by dashed lines of a unit represented by formula (1-5-d) shown below. Namely, a unit including groups represented by R7, R8, R9, R10, and R11, and further including an alkoxy group or a hydroxy group remaining at a terminal position is also included in the unit represented by ($R7R8R9R10Si_2R11O_{2/2}$).

**[Chem. 19]**

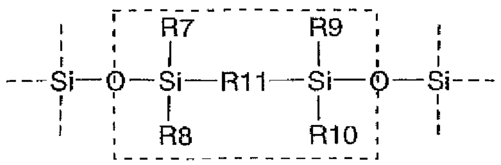
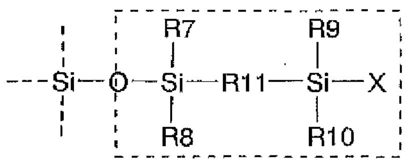

···Formula (1-d) ···Formula (1-5-d)

In the formulae (1-5) and (1-5-d), X represents OH or OR, and the OR represents a linear or branched C1 to C4 alkoxy group. R7 to R11 in the formulae (1-d), (1-5), and (1-5-d) are the same groups as the R7 to R11 in the formula (1B).

The linear or branched $C_1$ to $C_4$ alkoxy group in the formulae (1-b) to (1-d), (1-2) to (1-5), (1-2-b), (1-3-c), (1-4-c), and (1-5-d) is not particularly limited, and examples thereof include a methoxy group, an ethoxy group, an n-propoxy group, an n-butoxy group, an isopropoxy group, an isobutoxy group, a sec-butoxy group, and a t-butoxy group.

In the formula (1A) and the formula (1A-2), a value of a/(a+b+c) is 0 at minimum and 0.50 at maximum. In the case where a/(a+b+c) satisfies the maximum value, the sealant can have further enhanced heat resistance, and can be prevented from peeling off. In the formula (1A) and the formula (1A-2), a preferable maximum value of a/(a+b+c) is 0.45, and more preferably 0.40. In the case where a is 0, and a value of a/(a+b+c) is 0, a unit of ($R1R2R3SiO_{1/2}$) does not exist in the formula (1A) and the formula (1A-2).

In the formula (1A) and the formula (1A-2), a value of b/(a+b+c) is 0.4 at minimum and 1.0 at maximum. In the case where b/(a+b+c) satisfies the minimum value, a cured product of the sealant is not too hard, and thus cracking hardly occurs in the sealant. In the case where b/(a+b+c) satisfies the maximum value, and a unit of ($R4R5SiO_{2/2}$) exists, the sealant has further enhanced gas barrier property. In the formula (1A) and the formula (1A-2), a preferable minimum value of b/ (a+b+c) is 0.50.

In the formula (1A) and the formula (1A-2), a value of c/(a+b+c) is 0 at minimum and 0.50 at maximum. In the case where c/(a+b+c) satisfies the maximum value, the sealant can easily maintain a proper viscosity as sealant, and

can have further enhanced adhesion property. In the formula (1A) and the formula (1A-2), a preferable maximum value of c/(a+b+c) is 0.45, more preferably 0. 40, and still more preferably 0.35. In the case where c is 0, and a value of c/(a+b+c) is 0, a unit of ($R6SiO_{3/2}$) does not exist in the formula (1A) and the formula (1A-2).

In the case where a value of c/(a+b+c) in the formula (1A-2) is 0, a silicone resin which is equivalent to the first silicone resin A-1 is excluded as the first silicone resin A-2. In the case where c/(a+b+c) is 0 in the formula (1A-2), preferably R1, R2, and R3 each are not an alkenyl group, and also at least one of R4 and R5 is an alkenyl group. In the formula (1A-2), c/(a+b+c) may be 0.01 or more.

In the formula (1A), a value of c/(a+b+c) is preferably 0. Namely, the first silicone resin A represented by the formula (1A) is preferably a first silicone resin represented by formula (1Aa) shown below. This preferable configuration leads to better dispensability (application property) of the sealant. Moreover, cracking tends not to occur in the sealant, and the sealant is far less likely to peel from housing materials or the like.

**[Chem. 20]**

$$(R1R2R3SiO_{1/2})_a(R4R5SiO_{2/2})_b \qquad \text{Formula(1Aa)}$$

In the formula (1Aa), a, and b satisfy the following equations: a/(a+b) = 0 to 0.50; and b/(a+b) = 0.50 to 1.0, at least one of R1 to R5 represents a phenyl group corresponding to an aryl group, at least one of R1 to R5 represents an alkenyl group, and the rest of the R1 to R5 other than phenyl groups and alkenyl groups represent $C_1$ to $C_8$ hydrocarbon groups.

A preferably maximum value of a/(a+b) in the formula (1Aa) is 0.45, and more preferably 0.40. A preferable minimum value of b/(a+b) is 0.55, and more preferably 0.60.

A value of a/(a+b+c) in the formula (1A-2) is preferably 0. Namely, the first silicone resin A-2 represented by the formula (1A-2) is preferably a first silicone resin represented by formula (1A-2a) shown below. This preferable configuration further prevents occurrence of cracks in the sealant, and also the sealant is far less likely to peel from housing materials or the like.

**[Chem. 21]**

$$(R1R2R3SiO_{1/2})_a(R4R5SiO_{2/2})_b \qquad \text{Formula(1A-2a)}$$

In the formula (1A-2a), a, and b satisfy the following equations: a/(a+b) = 0 to 0.50; and b/(a+b) = 0.50 to 1.0, at least one of R1 to R5 represents a phenyl group corresponding to an aryl group, at least one of R1 to R5 represents an alkenyl group, and the rest of the R1 to R5 other than phenyl groups and alkenyl groups represent $C_1$ to $C_8$ hydrocarbon groups, provided that a silicone resin equivalent to the first silicone resin A-1 is excluded as the first silicone resin. Preferably, R1, R2, and R3 each are not an alkenyl group, and at least one of R4 and R5 is an alkenyl group in the formula (1A-2a).

A preferably maximum value of a/(a+b) in the formula (1A-2a) is 0.45, and more preferably 0.40. A preferable minimum value of b/(a+b) is 0.55, and more preferably 0.60.

In the formula (1A-1), a value of a/(a+b) is 0.05 at minimum and 0.50 at maximum. In the case where a/(a+b) satisfies the minimum value, stickiness can be suppressed on the surface of a cured product of the sealant. In the case where a/(a+b) satisfies the maximum value, the sealant can have further enhanced heat resistance, and can be prevented from peeling off. In the formula (1A-1), a preferable maximum value of a/(a+b) is 0.45, and more preferably 0.40. For further suppressing stickiness on the surface of the sealant, a still more preferable maximum value of a/(a+b) is 0.30 in the formula (1A-1).

In the formula (1A-1), a value of b/(a+b) is 0.50 at minimum and 0.95 at maximum. In the case where b/(a+b) satisfies the minimum value, a cured product of the sealant is not too hard, and thus cracking is less likely to occur in the sealant. For further suppressing stickiness on the surface of the sealant, a still more preferable minimum value of b/(a+b) is 0.70 in the formula (1A-1).

In the formula (1B), a value of a/(a+b+c+d) is 0 at minimum and 0. 40 at maximum. In the case where a/(a+b+c+d) satisfies the maximum value, the sealant can have further enhanced heat resistance, and can be prevented from peeling off. In the case where a is 0, and a value of a/(a+b+c+d) is 0, a unit of ($R1R2R3SiO_{1/2}$) does not exist in the formula (1B).

In the formula (1B), a value of b/(a+b+c+d) is 0.40 at minimum and 0. 99 at maximum. In the case where b/(a+b+c+d) satisfies the minimum value, a cured product of the sealant is not too hard, and thus cracking is less likely to occur in the sealant. In the case where b/(a+b+c+d) satisfies the maximum value, the sealant has further enhanced gas barrier property.

In the formula (1B), a value of c/(a+b+c+d) is 0 at minimum and 0.50 at maximum. In the case where c/(a+b+c+d) satisfies the maximum value, the sealant can maintain a proper viscosity as sealant, and can have further enhanced adhesion property. In the case where c is 0, and a value of c/(a+b+c+d) is 0, a unit of ($R6SiO_{3/2}$) does not exist in the

formula (1B).

In the formula (1B), a value of d/(a+b+c+d) is 0.01 at minimum and 0.40 at maximum. In the case where d/(a+b+c+d) satisfies the minimum value and the maximum value, a sealant for an optical semiconductor device can be obtained which has high gas barrier property against corrosive gas, and is less likely to crack or is less likely to peel off even when used in harsh environments. In terms of obtaining a sealant for an optical semiconductor device which has higher gas barrier property, and is far less likely to crack or is far less likely to peel off even when used in harsh environments, a preferable minimum value of d/(a+b+c+d) is 0.03, more preferably 0.05, and a preferable maximum value of d/(a+b+c+d) is 0.35, more preferably 0.30.

A value of c/(a+b+c+d) in the formula (1B) is preferably 0. Namely, the second silicone resin B represented by the formula (1B) is preferably a second silicone resin represented by formula (1Bb) shown below. This preferable configuration leads to better dispensability (application property) of the sealant. Moreover, cracking tends not to occur in the sealant, and the sealant is far less likely to peel from housing materials or the like.

**[Chem. 22]**

$$(R1R2R3SiO_{1/2})_a(R4R5SiO_{2/2})_b(R7R8R9R10Si2R11O_{2/2})_d \qquad \text{Formula(1Bb)}$$

In the formula (1Ba), a, b, and d satisfy the following equations: a/(a+b+d) = 0 to 0.40; b/(a+b+d) = 0.40 to 0.99; and d/(a+b+d) = 0.01 to 0.40, at least one of R1 to R5 represents a phenyl group corresponding to an aryl group, at least one of R1 to R5 represents an alkenyl group, and the rest of the R1 to R5 other than phenyl groups and alkenyl groups represents $C_1$ to $C_8$ hydrocarbon groups, R7 to R10 each represent a $C_1$ to $C_8$ hydrocarbon group, and R11 represents a $C_1$ to $C_8$ bivalent hydrocarbon group.

The $^{29}$Si-nuclear magnetic resonance analysis (hereinafter, also referred to as NMR) of the first silicone resins A, A-1, A-2, and B using tetramethylsilane (hereinafter, also referred to as TMS) as standard shows that peaks corresponding to the unit represented by $(R1R2R3SiO_{1/2})_a$ appear in a range of about +10 to -5 ppm in the formula (1A), the formula (1A-1), the formula (1A-2), and the formula (1B); peaks corresponding to the respective bi-functional units represented by $(R4R5SiO_{2/2})_b$ in the formula (1A), the formula (1A-1), the formula (1A-2) and the formula (1B), and (1-2) appear in a range of about -10 to -50 ppm; peaks corresponding to the respective trifunctional units represented by $(R6SiO_{3/2})_b$ in the formula (1A), the formula (1A-2) and the formula (1B), and (1-3) and (1-4) appear in a range of about -50 to -80 ppm; and peaks corresponding to the respective units represented by $(R7R8R9R10Si_2R11O_{2/2})_d$ in the formula (1B), and (1-5) appear in a range of about 0 to -5 ppm.

By the $^{29}$Si-NMR analysis and comparison of the peak areas of respective signals, the ratios of the respective units in the formula (1A), the formula (1A-1), the formula (1A-2), and the formula (1B) can be determined.

If the $^{29}$Si-NMR analysis using TMS as standard does not identify the units in the formula (1A), the formula (1A-1), the formula (1A-2), and the formula (1B), results of $^{1}$H-NMR analysis are optionally used in addition to the result of the $^{29}$Si-NMR analysis so that the ratios of the respective units in the formula (1A), the formula (1A-1), the formula (1A-2), and the formula (1B) can be determined.

The amount of the first silicone resin A-1 in a total 100 wt% of the first silicone resin A-1 and the first silicone resin A-2 is preferably from 5 wt% to 100 wt%. The amount of the first silicone resin A-1 in a total 100 wt% of the first silicone resin A-1 and the first silicone resin A-2 is especially preferably more than 50 wt% and not more than 100 wt%. The amount of the silicone resin exceeding 50 wt% fairly highly enhances the humidity-resistance reliability of the sealant. The amount of the first silicone resin A-1 in a total 100 wt% of the first silicone resin A-1 and the first silicone resin A-2 may be not more than 99.9 wt%.

The amount of the first silicone resin A-1 based on 100 parts by weight of the first silicone resin A-2 is preferably from 5 parts by weight to 100000 parts by weight. The amount of the first silicone resin A-1 based on 100 parts by weight of the first silicone resin A-2 is especially preferably from 5 parts by weight to 100 parts by weight. The amount of the first silicone resin A-1 of 5 parts by weight to 100 parts by weight can further enhance the gas barrier property of the sealant. More preferably, the amount of the first silicone resin A-1 based on 100 parts by weight of the first silicone resin A-2 is 10 parts by weight at minimum and 80 parts by weight at maximum.

(Second silicone resins)

A second silicone resin component contained in the sealant for an optical semiconductor device according to the present invention is at least one of a second silicone resin A represented by formula (51A) shown below, the second silicone resin A containing an aryl group and a hydrogen atom directly bound to a silicon atom, and a second silicone resin B represented by formula (51B) shown below, the second silicone resin B containing an aryl group and a hydrogen atom directly bound to a silicon atom.

In the second silicone resin A and the second silicone resin B, preferably the aryl group is directly bound to the silicone atom. Examples of the aryl group include unsubstituted phenyl groups and substituted phenyl groups. The

silicone resin represented by the formula (51B) shown below may optionally include a phenylene group. The second silicone resin A and the second silicone resin B each may be used solely, or in combination of two or more thereof.

**[Chem. 23]**

$$(R51R52R53SiO_{1/2})_p(R54R55SiO_{2/2})_q(R56SiO_{3/2})_r \quad \text{Formula(51A)}$$

In the formula (51A), p, q, and r satisfy the following equations: p/(p+q+r) = 0.05 to 0.50; q/(p+q+r) = 0.05 to 0.50; and r/(p+q+r) = 0.20 to 0.80, and at least one of R51 to R56 represents a phenyl group corresponding to an aryl group, at least one of R51 to R56 represents a hydrogen atom directly bound to a silicon atom, and the rest of the R51 to R56 other than phenyl groups and hydrogen atoms directly bound to a silicon atom represent $C_1$ to $C_8$ hydrocarbon groups. In the formula (51A), a unit represented by $(R54R55SiO_{2/2})$ and a unit represented by $(R56SiO_{3/2})$ each may contain an alkoxy group or a hydroxy group.

**[Chem. 24]**

$$(R51R52R53SiO_{1/2})_p(R54R55SiO_{2/2})_q(R56SiO_{3/2})_r$$
$$(R57R58R59R60SiO_2R61O_{2/2})_s \quad \text{Formula(51B)}$$

In the formula (51B), p, q, r and s satisfy the following equations: p/(p+q+r+s) = 0.05 to 0.50; q/(p+q+r+s) = 0.05 to 0.50; r/(p+q+r+s) = 0.20 to 0.80; and s/(p+q+r+s) = 0.01 to 0. 40, and at least one of R51 to R56 represents a phenyl group corresponding to an aryl group, at least one of R51 to R56 represents a hydrogen atom directly bound to a silicon atom, and the rest of the R51 to R56 other than phenyl groups and hydrogen atoms directly bound to a silicon atom represent $C_1$ to $C_8$ hydrocarbon groups, R57 to R60 each represent a $C_1$ to $C_8$ hydrocarbon group, and R61 represents a $C_1$ to $C_8$ bivalent hydrocarbon group. In the formula (51B), a unit represented by $(R54R55SiO_{2/2})$, a unit represented by $(R56SiO_{3/2})$, and a unit represented by $(R57R58R59R60Si_2R61O_{2/2})$ may each contain an alkoxy group or may contain a hydroxy group.

The formula (51A) and the formula (51B) each are an average composition formula. Hydrocarbon groups in the formula (51A) and the formula (51B) may be linear or branched chains. R51 to R56 in the formula (51A) and the formula (51B) may be the same or different from one another. R57 to R60 in the formula (51B) may be the same or different from one another.

The oxygen atom part in the unit represented by $(R54R55SiO_{2/2})$ in the formula (51A) and the formula (51B), the oxygen atom part in the unit represented by $(R56SiO_{3/2})$, and the oxygen atom part in the unit represented by $(R57R58R59R60Si_2R61O_2)$ each are an oxygen atom part forming a siloxane bond, an oxygen atom part in the alkoxy group, or an oxygen atom part in the hydroxy group.

The $C_1$ to $C_8$ hydrocarbon group in the formula (51A) and the formula (51B) is not particularly limited, and examples thereof include a methyl group, an ethyl group, an n-propyl group, an n-butyl group, an n-pentyl group, an n-hexyl group, an n-heptyl group, an n-octyl group, an isopropyl group, an isobutyl group, a sec-butyl group, a t-butyl group, an isopentyl group, a neopentyl group, a t-pentyl group, an isohexyl group, a cyclohexyl group, a vinyl group, and an allyl group.

The $C_1$ to $C_8$ bivalent hydrocarbon group in the formula (51B) is not particularly limited, and examples thereof include a methylene group, an ethylene group, a propylene group, a butylene group, a pentylene group, a hexylene group, a cyclohexylene group, and a phenylene group.

The aryl group content in the silicone resin A represented by the formula (51A) calculated by formula (a51) shown below is 30 mol% to 70 mol%.

(Formula a51)

[Aryl group content (mol%)] = [(Average number of aryl group included in one molecule of the second silicone resin A × Molecular weight of the aryl group) / (Number average molecular weight of the second silicone resin A)] × 100

The aryl group content in the second silicone resin A calculated by the formulae (a51) of less than 30 mol%

results in insufficient gas barrier property. The aryl group content of more than 70 mol% tends to cause peeling of the sealant. In terms of achieving more enhanced gas barrier property, the aryl group content is preferably at least 35 mol%. In terms of further preventing peeling of the sealant, the aryl group content is preferably at most 65 mol%.

A total content of an aryl group and a phenylene group in the second silicone resin B represented by the formula (51B) calculated based on formula (b51) shown below is from 30 mol% to 70 mol%.

(Formula b51)

[A total content of aryl group and phenylene group (mol%)] = [(Average number of aryl group included in one molecule of the second silicone resin B × Molecular weight of the aryl group + Average number of phenylene group included in one molecule of the second silicone resin B × Molecular weight of the phenylene group) / (Number average molecular weight of the second silicone resin B)] × 100

If the total content of the aryl group and the phenylene group in the second silicone resins B calculated by the formula (b51) is less than 30 mol%, the gas barrier property is insufficient. The total content of the aryl group and the phenylene group of more than 70 mol% tends to cause peeling of the sealant. In terms of achieving more enhanced gas barrier property, the total content of the aryl group and the phenylene group is preferably at least 35 mol%. In terms of further preventing peeling of the sealant, the total content of the aryl group and the phenylene group is preferably at most 65 mol%.

In the case where the second silicone resin B represented by the formula (51B) does not include a phenylene group, the total content of the aryl group and the phenylene group means the aryl group content.

In terms of enhancing the curability of the sealant, and further preventing the cracking and peeling of the sealant in the heat cycles, the second silicone resin A and the second silicone resin B each preferably include a unit represented by formula (51-a) shown below.

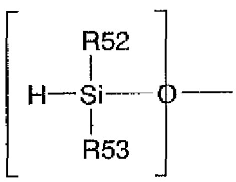

···Formula (51-a)

In the formula (51-a), R52 and R53 each represent a hydrogen atom, a phenyl group, or a $C_1$ to $C_8$ hydrocarbon group. The R52 and R53 each preferably represent a phenyl group, or a $C_1$ to $C_8$ hydrocarbon group.

In terms of enhancing the curability of the sealant, and further preventing the cracking and peeling of the sealant in the heat cycles, preferably a unit represented by ($R51R52R53SiO_{1/2}$) in the formula (51A) and the formula (51B) includes a unit in which R51 represents a hydrogen atom bound to a silicon atom, and R52 and R53 each preferably represent a phenyl group or a $C_1$ to $C_8$ hydrocarbon group.
Namely, the unit represented by ($R51R52R53SiO_{1/2}$) in the formula (51A) and the formula (51B) preferably includes the unit represented by the formula (51-a). The unit represented by ($R51R52R53SiO_{1/2}$) may include only the unit represented

by formula (51-a) or may include the unit represented by the formula (51-a) and units other than the unit represented by the formula (51-a).

The second silicone resins A and B each are preferably organosiloxane. In terms of enhancing the curability of the sealant, and further preventing cracking and peeling of the sealant in the heat cycles, the proportion of the unit represented by the formula (51-a) in 100 mol% of the total siloxane unit of the second silicone resin A and the second silicone resin B is preferably at least 5 mol% and more preferably at least 10 mol%, and preferably at most 50 mol% and more preferably at most 45 mol%.

The proportion of the unit in which R51 represents a hydrogen atom bound to a silicon atom, and R52 and R53 each represent an alkenyl group, a phenyl group, or a $C_1$ to $C_8$ hydrocarbon group (i.e., the unit represented by the formula (51-a)), in 100 mol% of the total unit in the formula (51A) and the formula (51B) is preferably at least 5 mol% and more preferably at least 10 mol%, and preferably at most 50 mol%, and more preferably at most 45 mol%.

The second silicone resins A and B each preferably have a viscosity of 500 mPa·s to 5000 mPa·s measured with an E-type viscometer at 5 rpm at a temperature of 25°C. The second silicone resins A and B each having a viscosity in the above range further prevents deposition of the phosphor, further enhances the dispensability of the sealant, and further increases the luminance of the light output from the optical semiconductor devices.

In terms of further enhancing the gas barrier property, the unit ($R57R58R59R60Si_2R61O_{2/2}$) in the formula (51B) is preferably a unit represented by formula (51b-1) shown below. The unit represented by the formula (51b-1) includes a phenylene group, and the phenylene group is a substituted or unsubstituted phenylene group.

**[Chem. 26]**

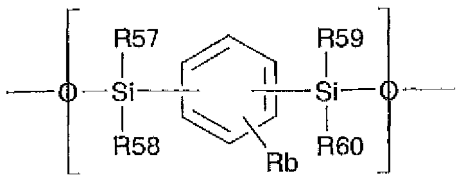

···Formula (51b-1)

In the formula (51b-1), Rb represents a hydrogen atom or a $C_1$ to $C_8$ hydrocarbon group, and R57 to R60 each represent a $C_1$ to $C_8$ hydrocarbon group. The hydrocarbon group may be a linear or branched chain. A binding site of each of the three groups to the benzene ring in the formula (51b-1) is not particularly limited.

The unit ($R57R58R59R60Si_2R61O_{2/2}$) in the formula (5 1B) is preferably a unit represented by formula (51b-2) shown below. The unit represented by the formula (51b-2) includes a phenylene group, and the phenylene group is a substituted or unsubstituted phenylene group. Binding site of the Rb to the benzene ring in the formula (51b-2) is not particularly limited.

**[Chem. 27]**

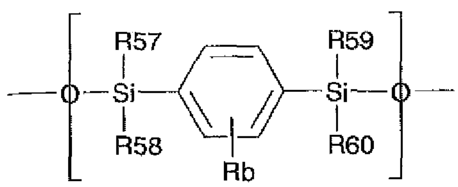

···Formula (51b-2)

In the formula (51b-2), Rb represents a hydrogen atom or a $C_1$ to $C_8$ hydrocarbon group, and R57 to R60 each represent a $C_1$ to $C_8$ hydrocarbon group.

The unit ($R57R58R59R60Si_2R61O_{2/2}$) in the formula (51B) is more preferably a unit represented by formula (51b-3) shown below. The unit represented by the formula (51b-3) includes a phenylene group, and the phenylene group is an unsubstituted phenylene group.

**[Chem. 28]**

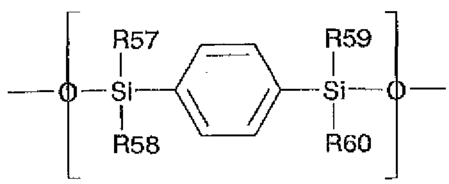

···Formula (51b-3)

In the formula (51b-3), R57 to R60 each represent a $C_1$ to $C_8$ hydrocarbon group.

In the second silicone resin represented by the unit ($R54R55SiO_{2/2}$) (hereinafter, also referred to as a bifunctional unit) in the formula (51A) or (51B) may include a structure represented by formula (51-2) shown below, namely a structure in which one of oxygen atoms bound to a silicon atom constitutes an hydroxy group or an alkoxy group.

Formula (51-2) ($R54R55SiXO_{1/2}$)

The unit represented by ($R54R55SiO_{2/2}$) may include a moiety surrounded by dashed lines of a unit represented by formula (51-b) shown below, and may further include a moiety surrounded by dashed lines of a unit represented by formula (51-2-b) shown below. Namely, a unit including groups represented by R54 and R55, and further including an alkoxy group or a hydroxy group remaining at a terminal position may also be included in the unit represented by ($R54R55SiO_{2/2}$).

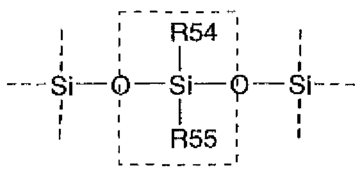

···Formula (51-b)

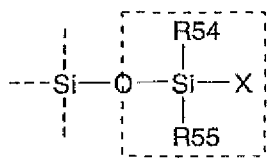

···Formula (51-2-b)

In the formulae (51-2) and (51-2-b), X represents OH or OR, and the OR represents a linear or branched $C_1$ to $C_4$ alkoxy group. R54 and R55 in the formulae (51-b), (51-2), and (51-2-b) are respectively the same groups as the R54 and R55 in the formulae (51A) or (51B).

In the first silicone resin represented by the formula (51A) or (51B), a unit represented by ($R56SiO_{3/2}$) (hereinafter, also referred to as trifunctional unit) may include a structure represented by formula (51-3) or (51-4) shown below, namely a structure in which the two oxygen atoms bound to a silicon atom in the trifunctional unit constitute a hydroxy group or an alkoxy group, or a structure in which one of the two oxygen atoms bound to a silicon atom in the trifunctional unit constitutes a hydroxy group or an alkoxy group.

Formula (51-3) ($R56SiX_2O_{1/2}$)

Formula (51-4) ($R56SiXO_{2/2}$)

The unit represented by ($R56SiO_{3/2}$) may include a moiety surrounded by dashed lines of a unit represented by formula (51-c) shown below, and may further include a moiety surrounded by dashed lines of a unit represented by formula (51-3-c) or (51-4-c) shown below. Namely, a unit including a group represented by R56 and further including an alkoxy group or a hydroxy group remaining at a terminal position is also included in the unit represented by ($R56SiO_{3/2}$).

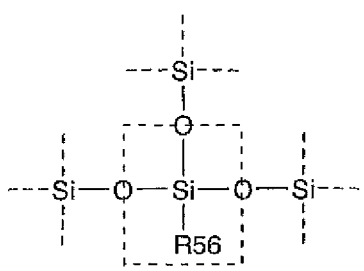

···Formula (51-c)

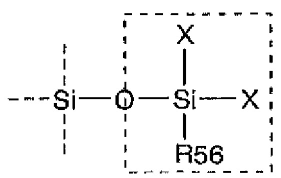

···Formula (51-3-c)

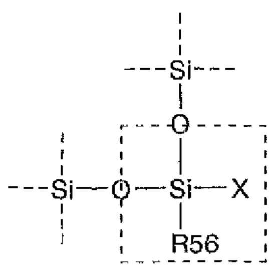

···Formula (51-4-c)

In the formulae (51-3), (51-3-c), (51-4), and (51-4-c), X represents OH or OR, and the OR represents a linear or branched C1 to C4 alkoxy group. R56 in the formulae (51-c), (51-3), (51-3-c), (51-4), and (51-4-c) is the same group as the R56 in the formulae (51A) and (51B).

In the second silicone resin B represented by the formula (51B), the unit represented by ($R57R58R59R60Si_2R61O_{2/2}$) may include a structure represented by formula (51-5) shown below, namely a structure in which one of oxygen atoms bound to a silicon atom in the unit ($R57R58R59R60Si_2R61O_{2/2}$) constitutes an hydroxy group or an alkoxy group.

Formula (51-5) ($R57R58R59R60Si_2R5461XO_{1/2}$

The unit represented by ($R57R58R59R60Si_2R61O_{2/2}$) may include a moiety surrounded by dashed lines of a unit represented by formula (51-d) shown below, and may further include a moiety surrounded by dashed lines of a unit represented by formula (51-5-d) shown below. Namely, a unit including groups represented by R57, R58, R59, R60, and R61, and further including an alkoxy group or a hydroxy group remaining at a terminal position is also included in the unit represented by ($R57R58R59R60Si_2R61O_{2/2}$).

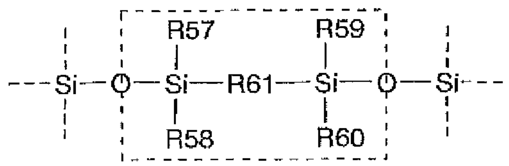

···Formula (51-d)

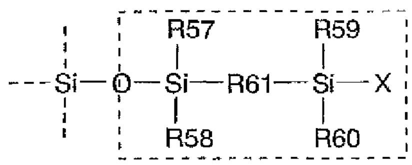

···Formula (51-5-d)

In the formulae (51-5) and (51-5-d), X represents OH or OR, and the OR represents a linear or branched C1 to C4 alkoxy group. R57 to R61 in the formulae (51-d), (51-5), and (51-5-d) are the same groups as the R57 to R61 in the formula (51B).

The linear or branched $C_1$ to $C_4$ alkoxy group in the formulae (51-b) to (51-d), (51-2) to (51-5), (51-2-b), (51-3-c), (51-4-c), and (51-5-d) is not particularly limited, and examples thereof include a methoxy group, an ethoxy group, an n-propoxy group, an n-butoxy group, an isopropoxy group, an isobutoxy group, a sec-butoxy group, and a t-butoxy group.

In the formula (1A), a value of p/(p+q+r) is 0.05 at minimum and 0.50 at maximum. In the case where p/(p+q+r) satisfies the maximum value, the sealant can have further enhanced heat resistance, and can be prevented from peeling off. In the formula (51A), a preferable minimum value of p/(p+q+r) is 0.10, and a preferable maximum value is 0.45.

In the formula (51A), a value of q/(p+q+r) is 0.05 at minimum and 0.50 at maximum. In the case where q/(p+q+r) satisfies the minimum value, the sealant when cured is not too hard, and thus cracking hardly occurs in the sealant. In the case where q/(p+q+r) satisfies the maximum value, the sealant has further enhanced gas barrier property. In the formula (51A), a preferable minimum value of q/(p+q+r) is 0.10, and a preferable maximum value is 0.45.

In the formula (51A), a value of r/(p+q+r) is 0. 20 at minimum an 0.80 at maximum. In the case where r/(p+q+r) satisfies the minimum value, the sealant has higher hardness, becomes more resistant to scars and trash adhesion, and has further enhanced heat resistance. Also, thickness of a cured product of the sealant is less likely to decrease under high temperature conditions. In the case where r/(p+q+r) satisfies the maximum value, the sealant can easily maintain a proper viscosity as sealant, and can have further enhanced adhesion property.

In the formula (51B), a value of p/(p+q+r+s) is 0.05 at minimum and 0.50 at maximum. In the case where p/(p+q+r+s) satisfies the maximum value, the sealant can have further enhanced heat resistance, and can be prevented from peeling off.

In the formula (51B), a value of q/ (p+q+r+s) is 0.05 at minimum and 0.50 at maximum. In the case where q/(p+q+r+s) satisfies the minimum value, a cured product of the sealant is not too hard, and thus cracking is less likely to occur in the sealant. In the case where q/(p+q+r+s) satisfies the maximum value, the sealant has further enhanced gas barrier property.

In the formula (51B), a value of r/ (p+q+r+s) is 0.20 at minimum and 0.80 at maximum. In the case where r/(p+q+r+s) satisfies the maximum value, the sealant can maintain a proper viscosity as sealant, and can have further enhanced adhesion property.

In the formula (51B), a value of s/ (p+q+r+s) is 0.01 at minimum and 0.40 at maximum. In the case where s/(p+q+r+s) satisfies the minimum value and the maximum value, a sealant for an optical semiconductor device can be obtained which has higher gas barrier property against corrosive gas, and is less likely to crack or is less likely to peel off even when used in harsh environments. In terms of obtaining a sealant for an optical semiconductor device which has high gas barrier property, and is far less likely to crack or far less likely to peel off even when used in harsh environments, a preferable minimum value of s/(p+q+r+s) in the formula (51B) is 0.03, more preferably 0.05, and a preferable maximum value of s/(p+q+r+s) is 0.35, more preferably 0.30.

The $^{29}$Si-nuclear magnetic resonance analysis (hereinafter, also referred to as NMR) of the second silicone resins A and B using tetramethylsilane (hereinafter, also referred to as TMS) as standard shows that peaks corresponding to the unit represented by $(R51R52R53SiO_{1/2})_p$ in the formula (51A) and the formula (51B) appear in a range of about +10 to -5 ppm; peaks corresponding to the respective bi-functional units represented by $(R54R55SiO_{2/2})_q$ in the formula (51A) and the formula (51B), and (51-2) appear in a range of about -10 to -50 ppm; peaks corresponding to the respective trifunctional units represented by $(R56SiO_{3/2})_r$ in the formula (51A) and the formula (51B), and (51-3) and (51-4) appear in a range of about -50 to -80 ppm; and peaks corresponding to the respective units represented by $(R57R58R59R60Si_2R61O_{2/2})_s$ in the formula (51B), and (51-5) appear in a range of about 0 to -5 ppm.

By the $^{29}$Si-NMR analysis and comparison of the peak areas of respective signals, the ratios of the respective units in the formula (51A) and the formula (51B) can be determined.

If the $^{29}$Si-NMR analysis using TMS as standard does not identify the units in the formula (51A) and the formula (51B), results of $^{1}$H-NMR analysis are optionally used in addition to the result of the $^{29}$Si-NMR analysis so that the ratios of the respective units in the formula (51A) and the formula (51B) can be determined.

The amount of the second silicone resin component based on 100 parts by weight of the first silicone resin component is preferably not less than 10 parts by weight and preferably not more than 400 parts by weight. The amount of the first silicone resin component and the amount of the second silicone resin component within the above range can provide a sealant having further enhanced gas barrier property. In terms of obtaining a sealant having higher gas barrier property, the minimum amount of the second silicone resin component based on 100 parts by weight of the first silicone resin component is more preferably 30 parts by weight and further preferably 50 parts by weight, and the maximum amount thereof is more preferably 300 parts by weight and further preferably 200 parts by weight.

The term "100 parts by weight of the first silicone resin component" refers to "100 parts by weight of the first silicone resin A" in the case where the sealant contains the first silicone resin A and does not contain the first silicone resin B; "100 parts by weight of the first silicone resin B" in the case where the sealant does not contain the first silicone resin A and contains the first silicone resin B; and "total 100 parts by weight of the first silicone resin A and the first silicone resin B" in the case where the sealant contains both the first silicone resin A and the first silicone resin B.

The term "100 parts by weight of the second silicone resin component" refers to "100 parts by weight of the second silicone resin A" in the case where the sealant contains the second silicone resin A and does not contain the second silicone resin B; "100 parts by weight of the second silicone resin B" in the case where the sealant does not contain the second silicone resin A and contains the second silicone resin B; and "total 100 parts by weight of the second silicone resin A and the second silicone resin B" in the case where the sealant contains both the second silicone resin A and the second silicone resin B.

The term "100 parts by weight of the first silicone resin A" refers to "100 parts by weight of the first silicone resin A-1" in the case where the first silicone resin A contains the first silicone resin A-1 and does not contain the first silicone resin A-2; and "total 100 parts by weight of the first silicone resin A-1 and the first silicone resin A-2" in the case where the first silicone resin A contains both the first silicone resin A-1 and the first silicone resin A-2.

(Other behaviors and production methods of the first and the second silicone resins)

The minimum amount of the alkoxy group in the first and second silicone resin is preferably 0.5 mol% and more preferably 1 mol%, and the maximum amount thereof is preferably 10 mol% and more preferably 5 mol%. The alkoxy content in the preferable ranges can further enhance the adhesion property of the sealant.

The alkoxy content satisfying the preferable minimum amount further enhances the adhesion property of the sealant. The alkoxy content satisfying the preferable maximum amount increases the storage stability of the first and second silicone resins and the sealant, and further enhances the heat resistance of the sealant.

The alkoxy group content refers to the amount of the alkoxy group contained in the average composition formula of the first and second silicone resins.

The first and second silicone resin components each preferably do not contain a silanol group. If the first and second silicone resins each do not contain a silanol group, the storage stability of the first and second silicone resins and the sealant increase. The silanol group can be reduced by heating in vacuo. The silanol group content can be measured by infrared spectroscopy.

The minimum number average molecular weight (Mn) of the first and second silicone resins is preferably 500, more preferably 800, and still more preferably 1000. The maximum number average molecular weight (Mn) of the first and second silicone resins is preferably 50000, and more preferably 15000. The average number weight satisfying the preferable minimum levels reduces volatile components during thermal curing. Thus, the thickness of a cured product

of the sealant is less likely decrease under temperature conditions. The average number weight satisfying the preferable maximum levels leads to easier viscosity control.

The number average molecular weight (Mn) is determined by gel permeation chromatography (GPC) using polystyrene as a standard. The number average molecular weight (Mn) means a value determined using a measuring apparatus produced by Waters (Column: two columns, Shodex GPC LF-804 (length: 300 mm), Temperature: 40°C, Flow rate: 1 mL/min, Solvent: tetrahydrofuran, Standard material: polystyrene).

Methods of synthesizing the first and second silicone resins are not particularly limited, and a method including hydrolysis of an alkoxysilane compound and subsequent condensation reaction, and a method including hydrolysis of a chlorosilane compound and subsequent condensation reaction may be exemplified. In terms of better control of the reactions, a method including hydrolysis of an alkoxysilane compound is preferable.

Examples of the method including hydrolysis of an alkoxysilane compound and subsequent condensation reaction include a method of reacting an alkoxysilane compound in the presence of water and an acidic or basic catalyst. A disiloxane compound may be hydrolyzed and used.

Examples of an organic silicon compound to introduce a phenyl group into the first and second silicone resins include triphenylmethoxysilane, triphenylethoxysilane, diphenyldimethoxysilane, diphenyldiethoxysilane, methyl(phenyl) dimethoxysilane, and phenyl trimethoxysilane.

Examples of an organic silicon compound to introduce ($R7R8R9R10Si_2R11O_{2/2}$) or ($R57R58R59R60Si_2R61O_{2/2}$) into the first and second silicone resins include 1,4-bis(dimethylmethoxysilyl)benzene, 1,4-bis(diethylmethoxysilyl)benzene, 1,4-bis(ethoxyethylmethylsilyl)benzene, 1,6-bis(dimethylmethoxysilyl)hexane, 1,6-bis(diethylmethoxysilyl)hexane, and 1,6-bis(ethoxyethylmethylsilyl)hexane.

Examples of an organic silicon compound to introduce an alkenyl group into the first silicone resin include vinyltrimethoxysilane, vinyltriethoxysilane, vinylmethyldimethoxysilane, methoxydimethylvinylsilane, vinyldimethylethoxysilane, and 1,3-divinyl1,1,3,3-tetramethyldisiloxane.

Examples of an organic silicon compound to introduce a hydroxy atom bound to a silicon atom into the second silicone resin include trimethoxysilane, triethoxysilane, methyldimethoxysilane, methyldiethoxysilane, and 1,1,3,3-tetramethyldisiloxane.

Examples of other organic silicon compounds which can be used to obtain the first and second silicone resins include trimethylmethoxysilane, trimethylethoxysilane, dimethyldimethoxysilane, dimethyldiethoxysilane, isopropyl(methyl)dimethoxysilane, cyclohexyl(methyl)dimethoxysilane, methyltrimethoxysilane, methyltriethoxysilane, ethyltrimethoxysilane, ethyltriethoxysilane, hexyltrimethoxysilane, and octyltrimethoxysilane.

Examples of the acidic catalyst include inorganic acids, organic acids, acid anhydrides of inorganic acids and derivatives thereof, and acid anhydrides of organic acids and derivative thereof.

Examples of the inorganic acids include hydrochloric acid, phosphoric acid, boric acid and carbonic acid. Examples of the organic acids include formic acid, acetic acid, propionic acid, butyric acid, lactic acid, malic acid, tartaric acid, citric acid, oxalic acid, malonic acid, succinic acid, glutaric acid, adipionic acid, fumaric acid, maleic acid, and oleic acid.

Examples of the basic catalyst include alkali metal hydroxides, alkali metal alkoxides, and silanol compounds of alkali metal.

Examples of the alkali metal hydroxide include sodium hydroxide, potassium hydroxide, and cesium hydroxide. Examples of the alkali metal alkoxides include sodium-t-butoxide, potassium-t-butoxide, and cesium-t-butoxide.

Examples of the silanol compounds of the alkali metal include sodium silanolate compounds, potassium silanolate compounds, and cesium silanolate compounds. Potassium catalysts or cesium catalysts are preferable among the examples.

(Catalyst for hydrosilylation reaction)

The catalyst for hydrosilylation reaction contained in the sealant for an optical semiconductor device according to the present invention is a catalyst to promote hydrosilylation reaction between the alkenyl group in the first silicone resin component and the hydrogen atom directly bound to a silicon atom in the second silicone resin component.

As the catalyst for hydrosilylation reaction, various catalyst capable of promoting hydrosilylation reaction can be used. The catalyst for hydrosilylation reaction may be used alone or in combination of two or more kinds thereof.

Examples of the catalyst for hydrosilylation reaction include platinum-based catalysts, rhodium-based catalysts, and palladium-based catalysts. Platinum-based catalysts are preferable because of their ability to increase transparency of the sealant.

Examples of the platinum-based catalysts include platinum powder, chloroplatinic acid, platinum-alkenylsiloxane complex, platinum-olefin, and platinum-carbonyl complex. In particular, platinum-alkenylsiloxane complex or platinum-olefin complex is preferable.

Examples of the alkenylsiloxane in the platinum-alkenylsiloxane complex include 1,3-divinyl-1,1,3,3-tetramethyldisiloxane, and 1,3,5,7-tetramethyl-1,3,5,7-tetravinylcyclotetrasiloxane. Examples of the olefin in the platinum-olefin complex include allyl ether, and 1,6-heptadiene.

Preferably, alkenylsiloxane, organosiloxane oligomer, allyl ether or olefin is added to the platinum-alkenylsiloxane complex or the platinum-olefin complex to improve the stability of the platinum-alkenylsiloxane complex and the platinum-olefin complex. The alkenylsiloxane is preferably 1,3-divinyl-1,1,3,3-tetramehyldisiloxaine. The organosiloxane oligomer is preferably dimethylsiloxane oligomer. The olefin is preferably 1,6-heptadiene.

The amount of the catalyst for hydrosilylation reaction in the sealant containing the first silicone resin component and the second silicone resin component is preferably in a range of 0.01 ppm to 1000 ppm as the weight of metal atoms. The amount of the catalyst for the hydrosilylation reaction of 0.01 ppm or more makes it easier to sufficiently cure the sealant, and can further enhance the gas barrier property of the sealant. The amount of the catalyst for the hydrosilylation reaction of 1000 ppm or less tends not to cause coloring of the cured product. More preferable minimum amount of the catalyst for hydrosilylation reaction is 1 ppm, and more preferable maximum amount thereof is 500 ppm.

(Silicon oxide particles)

Preferably, the sealant for an optical semiconductor device of the present invention further contains silicon oxide particles. Use of the silicon oxide particles can control the viscosity of the sealant before curing in an appropriate range without deteriorating heat resistance and light resistance of a cured product of the sealant. Thus, the handleability of the sealant can be improved.

The minimum primary particle diameter of the silicon oxide particles is preferably 5 nm, more preferably 8nm, and the maximum primary particle diameter thereof is preferably 200 nm, more preferably 150 nm. The primary particle diameter of the silicon oxide particles satisfying the preferable minimum value further enhances the dispersibility of the silicon oxide particles, and further increases the transparency of a cured product of the sealant. The primary particle diameter of the silicon oxide particles satisfying the preferable maximum value sufficiently achieves viscosity-increase effects at a temperature of 25°C, and also prevents the viscosity decrease during raising the temperature.

The primary particle diameter of the silicon oxide particles is determined as follow. A cured product of the sealant for an optical semiconductor device is observed using a transmission electron microscope (Trade name "JEM-2100") produced by JEOL Ltd.). The sizes of respective 100 pieces of the primary particles of the silicon oxide particles in a view site are measured, and an average of the measured values is determined as a primary particle diameter. If the silicon oxide particles have spherical form, the primary particle diameter means the average of the diameters of the silicon oxide particles. If the silicon oxide particles have non-spherical form, the primary particle diameter means the average of the longer diameters of the silicon oxide particles.

The BET surface area of the silicon oxide particles is preferably 30 $m^2/g$ at minimum, and is preferably 400 $m^2/g$ at maximum. The BET surface area of the silicon oxide particles of at least 30 $m^2/g$ can control the viscosity of the sealant at a temperature of 25°C in an appropriate range, and thus prevents the viscosity decrease while raising the temperature. The BET surface area of the silicon oxide particles of 400 $m^2/g$ or less hardly causes agglomeration of the silicon oxide particles. As a result, the dispersibility of the silicon oxide particles can be enhanced, and the transparency of a cured product of the sealant can be further increased.

The silicon oxide particles are not particular limited, and examples thereof include; silica produced by dry method, such as fumed silica and fused silica; and silica produced by wet method, such as colloidal silica, sol-gel silica, and precipitated silica. In terms of obtaining the sealant containing little volatile components and has further increased transparency, fumed silica is preferably used as the silicon oxide particles.

Examples of the fumed silica include Aerosil 50 (surface area: :50 $m^2/g$), Aerosil 90 (surface area: 90 $m^2/g$), Aerosil 130 (surface area: 130 $m^2/g$), Aerosil 200 (surface area: 200 $m^2/g$), Aerosil 300 (surface area: 300 $m^2/g$), and Aerosil 380 (surface area: 380 $m^2/g$) (all produced by Nippon Aerosil Co., Ltd.).

Surface of the silicon oxide particles are preferably treated with an organic silicon compound. The surface treatment significantly increases dispersibility of the silicon oxide particles, and further prevents reduction of the viscosity of the sealant before curing due to temperature increase.

The organic silicon compound is not particularly limited, and examples thereof include a silane-based compound containing an alkyl group, a silicon-based compound containing a siloxane backbone such as dimethylsiloxane, a silicon-based compound containing an amino group, a silicon-based compound containing a (meth) acryloyl group, and a silicon-based compound containing an epoxy group. The (meth)acryloyl group means an acryloyl group and a methacryloyl group.

In terms of further increasing the dispersibility of the silicon oxide particles, the organic silicon compound is preferably at least one selected from the group consisting of an organic silicon compound containing a dimethyl silyl group, an organic silicon compound containing a trimethyl silyl group, and an organic silicon compound containing a polydimethyl siloxane group. In terms of still further increasing the dispersibility of the silicon oxide particles, the organic silicon compound used for the surface treatment is preferably at least one selected from the group consisting of an

organic silicon compound containing a trimethyl silyl group and an organic silicon compound containing a polydimethyl siloxane group.

Examples of the method for the surface treatment with an organic silicon compound include, in the case of using an organic silicon compound containing a dimethyl silyl group or an organic silicon compound containing a trimethyl silyl group, a method of treating the surface of the silicon oxide particles with dichlorodimethylsilane, dimethyldimethoxysilane, hexamethyldisilazane, trimethylsilylchloride, trimethylmethoxysilane, or the like. In the case of using an organic silicon compound containing a polydimethyl siloxane group, a method of treating the surface of the silicon oxide particles with a compound containing a silanol group at a terminal end of the polydimethyl siloxane group, or the like is exemplified.

Examples of commercially available silicon oxide particles surface-treated with the organic silicon compound containing a dimethyl silyl group include R974 (surface area: 170 $m^2/g$), and R964 (surface area: 250 $m^2/g$) (all produced by Nippon Aerosil Co., Ltd.).

Examples of commercially available silicon oxide particles surface-treated with the organic silicon compound containing a trimethyl silyl group include RX200 (surface area: 140 $m^2/g$), and R8200 (surface area: 140 $m^2/g$) (all produced by Nippon Aerosil Co., Ltd.).

Examples of commercially available silicon oxide particles surface-treated with the organic silicon compound containing a polydimethyl siloxane group include RY200 (surface area: 120 $m^2/g$) (produced by Nippon Aerosil Co., Ltd.).

The method for treating the surface of the silicon oxide particles with the organic silicon compound is not particularly limited. Examples of the method include direct processing methods such as a dry method of adding the silicon oxide particles in a mixer and subsequently adding the organic silicon compound under stirring, a slurry method of adding the organic silicon compound in a slurry of the silicon oxide particles, and a spray method of spraying the organic silicon compound to the dried silicon oxide particles. Examples of the mixer used in the dry method include a Henschel mixer, and a V-shape mixer. In the dry method, the organic silicon compound is added directly, or as an alcohol solution, an organic solvent solution, or an aqueous solution.

In the surface treatment of the silicon oxide particles with the organic silicon compound to prepare the sealant for an optical semiconductor device, the silicon oxide particles and a matrix resin including the first and second silicone resin components may be mixed by directly adding the organic silicon compound, i.e., by integral blending method, or the like.

The amount of the silicon oxide particles in total 100 parts by weight of the first silicone resin component and the second silicone resin component is preferably not less than 0.5 parts by weight and preferably not more than 40 parts by weight. A more preferable minimum amount of the silicon oxide particles in total 100 parts by weight of the first silicone resin component and the second silicone resin component is 1 part by weight, and a more preferable maximum amount thereof is 35 parts by weight. The amount of the silicon oxide particles satisfying the minimum value can prevent the viscosity decrease upon curing. The amount of the silicon oxide particles satisfying the maximum value can control the viscosity of the sealant in a more appropriate range, and also further enhance the transparency of the sealant.

Meanwhile, if a light-emitting element emits luminous light, but the light is not efficiently emitted from inside to outside, a sufficient luminance cannot be achieved. In order to maintain a sufficient luminance, a larger electric current needs to pass through the light-emitting element.

The present inventors have found that use of the first and second silicone resin components containing an aryl group or a phenylene group increases the refractive index of a cured product of the sealant, and thereby light emitted from the light-emitting element is efficiently extracted. Accordingly, light with sufficient luminance can be emitted even if the electric current is low.

However, the sealant which includes a phosphor and the first and second silicone resin components containing an aryl group or a phenylene group tends to rapidly decrease its viscosity when exposed to high temperatures before curing. Thus, the phosphor tends to deposit. For this reason, if the sealant upon curing is exposed to high temperatures, the phosphor is locally located around the light-emitting element, causing diffuse reflection of light. As a result, part of light emitted from the light-emitting element is lost in a cured product of the sealant so that the amount of light extracted from the optical semiconductor device problematically decreases.

In the case where the sealant for an optical semiconductor device according to the present invention includes silicon oxide particles surface-treated with the organic silicon compound, the sealant can maintain its viscosity at sufficiently high levels at high temperature, despite the first and second silicone resin components containing an aryl group or a phenylene group contained in the sealant. Accordingly, the viscosity of the sealant can be controlled in an appropriate range when it is heated at high temperatures. And a condition of the sealant in which the phosphor is evenly dispersed can be maintained.

(Phosphor)

The sealant for an optical semiconductor device according to the present invention may further includes a phosphor. The phosphor functions to absorb light emitted from the light-emitting element sealed by the sealant for an

optical semiconductor device and to generate fluorescence so that eventually light having desired color can be provided.

In the case where the sealant for an optical semiconductor device according to the present invention includes the constitution Y in addition to the constitution X, even if the sealant already includes a phosphor, the phosphor tends not to deposit.

The sealant for an optical semiconductor device according to the present invention may not include a phosphor. In this case, a phosphor is added to the sealant upon use and then used. In the case where the sealant for an optical semiconductor device further includes the constitution Y in addition to the constitution X, addition of a phosphor in the sealant tends not to cause deposition of the added phosphor.

For example, in the case where an ultraviolet LED chip is used as light-emitting element to finally provide white light, preferably a blue phosphor, a red phosphor, and a green phosphor are used in combination. In the case where a blue LED chip is used as light-emitting element to finally provide white light, preferably a green phosphor and a red phosphor are used in combination, or preferably a yellow phosphor is used. The phosphor may be used solely or in combination of two or more kinds.

The blue phosphor is not particularly limited, and examples thereof include $(Sr, Ca, Ba, Mg)_{10}(PO_4)_6Cl_2:Eu$, $(Ba, Sr)MgAl_{10}O_{17}:Eu$, and $(Sr, Ba)_3MgSi_2O_8:Eu$.

The red phosphor is not particularly limited, and examples thereof include $(Sr, Ca)S:Eu$, $(Ca, Sr)_2Si_5N_8:Eu$, $CaSiN_2:Eu$, $CaAlSiN_3:Eu$, $Y_2O_2S:Eu$, $La_2O_2S:Eu$, $LiW_2O_8:(Eu, Sm)$, $(Sr, Ca, Bs, Mg)_{10}(PO_4)_8Cl_2:(Eu, Mn)$, and $Ba_3MgSi_2O_8:(Eu, Mn)$.

The green phosphor is not particularly limited, and examples thereof include $Y_3(Al, Ga)_5O_{12}:Ce$, $SrGa_2S_4:Eu$, $Ca_3Sc_2Si_3O_{12}:Ce$, SrSiON:Eu, ZnS: (Cu, Al), $BaMgAl_{10}O_{17}(Eu, Mn)$, and $SrAl_2O_4:E$.

The yellow phosphor is not particularly limited, and examples thereof include $Y_3Al_5O_{12}:Ce$, $(Y, Gd)_3Al_5O_{12}:Ce$, $Tb_3Al_5O_{12}:Ce$, $CaGa_2S_4:Eu$, and $Sr_2SiO_4:Eu$.

Another example of the phosphor include a perylene-based compound, which is an organic phosphor.

The minimum volume average particle diameter of the phosphor is preferably 1 $\mu$m, and more preferably 2 $\mu$m. The maximum volume average particle diameter of the phosphor is preferably 30 $\mu$m, and more preferably 25 $\mu$m.

The phosphor content can be appropriately controlled to provide light having desired colors, and is not particularly limited. The phosphor content is preferably at least 0.1 parts by weight and at most 40 parts by weight based on 100 parts by weight of the sealant for an optical semiconductor device according to the present invention. In the case where the sealant for an optical semiconductor device according to the present invention includes a phosphor, the phosphor content based on 100 parts by weight of the total components, other than the phosphor, of the sealant for an optical semiconductor device according to the present invention is preferably at least 0.1 parts by weight and at most 40 parts by weight.

(Coupling agent)

The sealant for an optical semiconductor device according to the present invention may further include a coupling agent to provide adhesiveness.

The coupling agent is not particularly limited, and may be silane coupling agents or the like. Examples of the silane coupling agents include vinyltriethoxysilane, vinyltrimethoxysilane, 3-glycidoxypropyltrimethoxysilane, 2-(3,4-epoxycyclohexyl)ethyltrimethoxysilane, $\gamma$-methacryloxypropyltrimethoxysilane, $\gamma$-aminopropyltrimethoxysilane, and N-phenyl-3-aminopropyltrimethoxysilane. The coupling agent may be used alone or in combination of two or more kinds thereof.

The amount of the coupling agent based on a total 100 parts by weight of the first silicone resin component and the second silicone resin component is preferably 0.1 parts by weight at minimum, and preferably 5 parts by weight at maximum. The amount of the coupling agent of at least 0.1 parts by weight sufficiently exerts the effect obtainable by adding the coupling agent. The amount of the coupling agent of at most 5 parts by weight prevents evaporation of an excessive portion of the coupling agent. Therefore, when the sealant is cured, thickness of the cured sealant under high temperature conditions is far less likely to decrease.

(Other components)

The sealant for an optical semiconductor device according to the present invention may further include additives, if needed, such as dispersants, antioxidants, defoaming agents, colorants, modifiers, denaturants, leveling agents, light diffusing agents, thermal conductive fillers, and flame retardants.

Solutions respectively containing one kind or two or more kinds of the first silicone resin component, the second silicone resin component, and the catalyst for hydrosilylation reaction may be separately prepared, and the sealant for an optical semiconductor device may be prepared by mixing a plurality of the solutions immediately before use. For example, the sealant for an optical semiconductor device according to the present invention may be prepared, for

example, by separately preparing a solution A containing the first silicone resin component and the catalyst for hydrosilylation reaction and a solution B containing the second silicone resin component, and mixing the solution A and the solution B immediately before use. In this manner, by separately preparing the first solution containing the first silicone resin component and the catalyst for hydrosilylation reaction and the second solution B containing the second silicone resin component, the storage stability can be enhanced. The silicon oxide particles and the phosphor each may be added to the solution A or may be added to the solution B.

(Details and usage of sealant for an optical semiconductor device)

The sealant for an optical semiconductor device according to the present invention preferably has a viscosity $\eta1$ of 1000 mPa·s to 10000 mPa·s measured with an E-type viscometer at 5 rpm at a temperature of 25°C. The viscosity $\eta1$ of the sealant for an optical semiconductor device according to the present invention within the above range can further prevents the phosphor from depositing, can further enhance the dispensability, and can further increase the luminance of the light extracted from an optical semiconductor device.

The ratio ($\eta2/\eta3$) of a viscosity $\eta2$ of the sealant for an optical semiconductor device according to the present invention measured with an E-type viscometer at 1 rpm at a temperature of 25°C relative to a viscosity $\eta3$ of the sealant measured with an E-type viscometer at 10 rpm at a temperature of 25°C is preferably 1.2 to 2.5. The viscosity of the sealant for an optical semiconductor device according to the present invention within the above range can further prevents the phosphor from depositing, can further enhance the dispensability, and can further increase the luminance of the light extracted from an optical semiconductor device.

The term "viscosity" in the first and second silicone resins A, A-1, A-2, B, and the sealant for an optical semiconductor device is a value determined by using an E-type viscometer (TV-22 type, produced by Toki Sangyo Co., Ltd.).

Moreover, the sealant for an optical semiconductor device according to the present invention preferably has a minimum viscosity at a shear rate of 1 $s^{-1}$ of at least 200 mPa·s in a temperature range of 25°C to the curing temperature, when heated in a parallel plate rheometer from 25°C at a temperature increase rate of 20°C/min. The viscosity of the sealant for an optical semiconductor device according to the present invention within the above range can prevents, when a phosphor is added, the phosphor from depositing, and can further increase the luminance of the light extracted from an optical semiconductor device.

If the viscosity $\eta1$ of the sealant for an optical semiconductor device according to the present invention is 1000 mPa·s to 10000 mPa·s at 5 rpm at a temperature of 25°C, the sealant can efficiently seal the light emitted from the light-emitting device formed in the optical semiconductor device. The minimum viscosity $\eta1$ at 5 rpm at a temperature of 25°C is preferably 1200 mPa·s, and more preferably 1500 mPa·s. The maximum viscosity $\eta1$ is preferably 8000 mPa·s, and more preferably 6000 mPa·s.

The minimum viscosity at a shear rate of 1 $s^{-1}$ of at least 200 mPa·s causes almost no deposition of the phosphor during heating for curing of the sealant. For this reason, more luminous light can be extracted from the optical semiconductor device. The minimum viscosity at a shear rate of 1 $s^{-1}$ is more preferably 300 mPa·s, and still more preferably 500 mPa·s.

The minimum viscosity at a shear rate of 1 $s^{-1}$ means a value determined by using a parallel plate rheometer (trade name "DAR-2000", produced by Reologica Instruments AB).

The curing temperature of the sealant for an optical semiconductor device according to the present invention is not particularly limited. The preferable lowest curing temperature of the sealant for an optical semiconductor device according to the present invention is 80°C, more preferably 100°C, and the preferable highest curing temperature is 180°C, more preferably 150°C. The curing temperature satisfying the preferable lowest temperature allows curing of the sealant to sufficiently proceed. The curing temperature satisfying the preferable highest temperature tends not to cause thermal degradation of the package.

The curing method is not particularly limited but is preferably a step-cure method. The step-cure method is a method including temporary curing at a low temperature and subsequent substantial curing at a high temperature. The step-cure method can prevent shrinkage on curing of the sealant.

The production method of the sealant for an optical semiconductor device according to the present invention is not particularly limited. Examples of the production method include a method in which the first silicone resin component, the second silicone resin component, the catalyst for hydrosilylation reaction, and optional other components are mixed by a mixer such as a homodisper, a homomixer, a versatile mixer, a planetarium mixer, a kneader, a three-roll mill, and a beads mill at normal temperature or under heating.

The light-emitting element is not particularly limited as long as the light-emitting element includes a semiconductor. For example, in the case where the light-emitting element is light-emitting diode, examples thereof include a structure in which a semiconductor material for LED style is layered on a substrate. Examples of the semiconductor material in this example include GaAs, GaP, GaAlAs, GaAsP, AlGaInP, GaN, InN, AlN, InGaAlN, and SiC.

Examples of the material for the substrate includes single crystals of sapphire, spinel, SiC, Si, ZnO, and GaN.

A buffer layer may be formed between the substrate and the semiconductor material, if necessary. Examples of the material for the buffer layer include GaN and AlN.

Specific examples of the optical semiconductor device according to the present invention include a light-emitting diode device, a semiconductor laser device, and a photo coupler. The optical semiconductor device of this kind may favorably be used as backlight for a liquid crystal display or the like, lightings, various sensors, light source for printers, photocopiers or the like, light source for vehicle gauze, signal lights, display lights, display devices, light source for sheet radiator, displays, decorations, various lights, and switching elements.

In the optical semiconductor device of the present invention, a cured product of the sealant for an optical semiconductor device of the present invention seals the light-emitting element formed of an optical semiconductor. In the optical semiconductor device of the present invention, a cured product of the sealant for an optical semiconductor device is disposed in a manner to seal the light-emitting element formed of an optical semiconductor such as LED. Therefore, the cured product of the sealant for an optical semiconductor device sealing the light-emitting element is less likely to crack, is less likely to peel from the package, and moreover, can enhance the light transmissivity, heat resistance, weather resistance and gas barrier property.

(Embodiments of optical semiconductor devices)

Fig. 1 shows a front cross-sectional view of an optical semiconductor device according to a first embodiment of the present invention.

An optical semiconductor device 1 of the present embodiment includes a housing 2. An optical semiconductor element 3 formed of an LED is provided in the housing 2. The optical semiconductor element 3 is surrounded by an inner face 2a having the light-reflective property of the housing 2. According to the present embodiment, the optical semiconductor element 3 is used as an light-emitting element formed of an optical semiconductor.

The inner face 2a is formed such that the diameter of the inner face 2a increases towards an opening end. For this reason, a portion of light emitted from the optical semiconductor device 3 and arriving at the inner face 2a is reflected on the inner face 2a and travels to a front side of the optical semiconductor element 3. A region surrounded by the inner face 2a is filled with a sealant for an optical semiconductor device 4 in a manner to seal the optical semiconductor device 3.

The structure shown in Fig. 1 is mere an example of the optical semiconductor device according to the present invention. The implementation structure and the like of the optical semiconductor device may be appropriately modified.

Hereinafter, the present invention will be described in more detail with reference to examples. The present invention is not limited to the examples.

(Synthesis Example 1) Synthesis of first silicone resins A, and A-2 Trimethylmethoxysilane (63 g), dimethyldimethoxysilane (90 g), diphenyldimethoxysilane (183 g), and vinyltrimethoxy silane (133 g) were charged into a 1000 mL separable flask equipped with a thermometer, a dropping appliance, and a stirrer, and were stirred at 50°C. An aqueous solution of 0.8 g potassium hydroxide dissolved in 114 g of water was slowly dropwise added to the mixture, and then stirred for six hours at 50°C for reaction to give a reaction solution. Subsequently, 0.9 g of acetic acid was added to the reaction solution, and volatile components were evaporated in vacuo. Thereafter, potassium acetate was removed by filtration, and thereby a polymer (A) was provided.

The number average molecular weight (Mn) of the polymer (A) was 1700. Result of chemical structure identification using $^{29}$Si-NMR showed that the polymer (A) had a following average composition formula (A1).

Composition formula (A1):

$$(Me_3SiO_{1/2})_{0.19}(Me_2SiO_{2/2})_{0.24}(Ph_2SiO_{2/2})_{0.26}(ViSiO_{3/2})_{0.31}$$

In the formula (A1), Me refers to a methyl group, Ph refers to a phenyl group, and Vi refers to a vinyl group.

A phenyl group content in the polymer (A) was 37 mol%.

The molecular weights of polymers obtained in respective synthesis example 1 and 2 to 16 were determined by adding 1 mL of tetrahydrofuran to each polymer, stirring the mixture until dissolved, followed by analysis by gel permeation chromatography (GPC). In the GPC analysis, a measuring apparatus produced by Waters (Column: two columns, Shodex GPC LF-804 (length: 300 mm) produced by Showa Denko K.K, Temperature: at 40°C, Flow rate: 1 mL/min, Solvent: tetrahydrofuran, Standard material: polystylene) was used.

(Synthesis Example 2) Synthesis of first silicone resins A, and A-2

Dimethyldimethoxysilane (126 g), diphenyldimethoxysilane (183 g), vinylmethyldimethoxysilane (119) g, and 1,6-bis(dimethylmethoxysilyl)hexane (79 g) were charged into a 1000 mL separable flask equipped with a thermometer, a dropping appliance, and a stirrer, and were stirred at 50°C. An aqueous solution of 0.8 g potassium hydroxide dissolved in 108 g of water was slowly dropwise added to the mixture, and then stirred for six hours at 50°C for reaction to give a

reaction solution. Subsequently, 0.9 g of acetic acid was added to the reaction solution, and volatile components were evaporated in vacuo. Thereafter, potassium acetate was removed by filtration, and thereby a polymer (B) was provided.

The number average molecular weight (Mn) of the polymer (B) was 4100. Result of chemical structure identification using $^{29}$Si-NMR showed that the polymer (B) had a following average composition formula (B1).

Composition formula (B1):

$$(Me_2SiO_{2/2})_{0.33}(Ph_2SiO_{2/2})_{0.27}(ViMeSiO_{2/2})_{0.30}(Me_4SiHexO_{2/2})_{0.10}$$

In the formula (B1), Me refers to a methyl group, Ph refers to a phenyl group, Vi refers to a vinyl group, and Hex refers to a hexylene group.

A phenyl group content in the polymer (B) was 33 mol%.

(Synthesis Example 3) Synthesis of first silicone resins A, and A-2

Dimethyldimethoxysilane (60 g), diphenyldimethoxysilane (317 g), vinylmethyldimethoxysilane (119) g, and 1,6-bis(dimethylmethoxysilyl)hexane (79 g) were charged into a 1000 mL separable flask equipped with a thermometer, a dropping appliance, and a stirrer, and were stirred at 50°C. An aqueous solution of 0.8 g potassium hydroxide dissolved in 108 g of water was slowly dropwise added to the mixture, and then stirred for six hours at 50°C for reaction to give a reaction solution. Subsequently, 0.9 g of acetic acid was added to the reaction solution, and volatile components were evaporated in vacuo. Thereafter, potassium acetate was removed by filtration, and thereby a polymer (C) was provided.

The number average molecular weight (Mn) of the polymer (C) was 3600. Result of chemical structure identification using $^{29}$Si-NMR showed that the polymer (C) had a following average composition formula (C1).

Composition formula (C1):

$$(Me_2S_iO_{2/2})_{0.16}(Ph_2SiO_{2/2})_{0.44}(ViMeSiO_{2/2})_{0.30}(Me_4SiHexO_{2/2})_{0.10}$$

In the formula (C1), Me refers to a methyl group, Ph refers to a phenyl group, Vi refers to a vinyl group, and Hex refers to a hexylene group.

The proportion of the diphenyl siloxane unit in 100 mol% of the total siloxane unit of the polymer (C) was 44 mol%. A phenyl group content in the polymer (C) was 33 mol%.

(Synthesis Example 4) Synthesis of first silicone resin B

Dimethyldimethoxysilane (60 g), diphenyldimethoxysilane (317 g), vinylmethyldimethoxysilane (119) g, and 1,4-bis(dimethylmethoxysilyl)benzene (76 g) were charged into a 1000 mL separable flask equipped with a thermometer, a dropping appliance, and a stirrer, and were stirred at 50°C. An aqueous solution of 0.8 g potassium hydroxide dissolved in 108 g of water was slowly dropwise added to the mixture, and then stirred for six hours at 50°C for reaction to give a reaction solution. Subsequently, 0.9 g of acetic acid was added to the reaction solution, and volatile components were evaporated in vacuo. Thereafter, potassium acetate was removed by filtration, and thereby a polymer (D) was provided.

The number average molecular weight (Mn) of the polymer (D) was 3400. Result of chemical structure identification using $^{29}$Si-NMR showed that the polymer (D) had a following average composition formula (D1).

Composition formula (D1):

$$(Me_2SiO_{2/2})_{0.16}(Ph_2SiO_{2/2})_{0.44}(ViMeSiO_{2/2})_{0.30}(Me_4SiPheO_{2/2})_{0.10}$$

In the formula (D1), Me refers to a methyl group, Ph refers to a phenyl group, Vi refers to a vinyl group, and Phe refers to a phenylene group.

The proportion of the diphenyl siloxane unit in 100 mol% of the total siloxane unit of the polymer (D) was 44 mol%. A phenyl group content in the polymer (D) was 52 mol%.

(Synthesis Example 5) Synthesis of second silicone resin A

Trimethylmethoxysilane (31 g), 1,1,3,3-tetramethyldisiloxane (50 g), dimethyldimethoxysilane (108 g), and phenyltrimethoxy silane (208 g) were charged into a 1000 mL separable flask equipped with a thermometer, a dropping appliance, and a stirrer, and were stirred at 50°C. An aqueous solution of 1.4 g hydrochloric acid in 101 g of water was slowly dropwise added to the mixture, and then stirred for six hours at 50°C for reaction to give a reaction solution. Subsequently, volatile components were evaporated in vacuo, and thereby a polymer was provided. To the polymer were added 150 g of hexane and 150 g of ethylacetate. The resulting mixture was washed 10 times with 300 g of ion-exchange water, and then volatile components were evaporated in vacuo. Thereby, a polymer (E) was provided.

The number average molecular weight (Mn) of the polymer (E) was 1000. Result of chemical structure identification using $^{29}$Si-NMR showed that the polymer (E) had a following average composition formula (E1).

Composition formula (E1):

$$(Me_3SiO_{1/2})_{0.09}(HMe_2SiO_{1/2})_{0.23}(Me_2SiO_{2/2})_{0.27}(PhSiO_{3/2})_{0.41}$$

In the formula (E1), Me refers to a methyl group, and Ph refers to a phenyl group.

A phenyl group content in the polymer (E) was 33 mol%.

(Synthesis Example 6) Synthesis of second silicone resin A

Trimethylmethoxysilane (16 g), 1,1,3,3-tetramethyldisiloxane (50 g), dimethyldimethoxysilane (36 g), diphenyldimethoxysilane (183 g), phenyltrimethoxysilane (149 g), and vinyltrimethoxy silane (45 g) were charged into a 1000 mL separable flask equipped with a thermometer, a dropping appliance, and a stirrer, and were stirred at 50°C. An aqueous solution of 1. 4 g hydrochloric acid in 104 g of water was slowly dropwise added to the mixture, and then stirred for six hours at 50°C for reaction to give a reaction solution. Subsequently, volatile components were evaporated in vacuo, and thereby a polymer was provided. To the polymer were added 150 g of hexane and 150 g of ethylacetate. The resulting mixture was washed 10 times with 300 g of ion-exchange water, and then volatile components were evaporated in vacuo. Thereby, a polymer (F) was provided.

The number average molecular weight (Mn) of the polymer (F) was 1000. Result of chemical structure identification using $^{29}$Si-NMR showed that the polymer (F) had a following average composition formula (F1).

Composition formula (F1):

$$(Me_3SiO_{1/2})_{0.05}(HMe_2SiO_{1/2})_{0.23}(Me_2SiO_{2/2})_{0.09}(Ph_2SiO_{2/2})_{0.26}(P\ hSiO_{3/2})_{0.27}(ViSiO_{3/2})_{0.10}$$

In the formula (F1), Me refers to a methyl group, Ph refers to a phenyl group, and Vi refers to a vinyl group.

The proportion of a unit corresponding to the unit represented by the formula (51-a) in 100 mol% of the total siloxane unit of the polymer (F) was 23 mol%. A phenyl group content in the polymer (F) was 51 mol%.

(Synthesis Example 7) Synthesis of second silicone resin A

Trimethylmethoxysilane (31 g), 1,1,3,3-tetramethyldisiloxane (40 g), diphenyldimethoxysilane (110 g), phenyltrimethoxysilane (268 g), and vinyltrimethoxy silane (45 g) were charged into a 1000 mL separable flask equipped with a thermometer, a dropping appliance, and a stirrer, and were stirred at 50°C. An aqueous solution of 1.4 g hydrochloric acid in 116 g of water was slowly dropwise added to the mixture, and then stirred for six hours at 50°C for reaction to give a reaction solution. Subsequently, volatile components were evaporated in vacuo, and thereby a polymer was provided. To the polymer were added 150 g of hexane and 150 g of ethylacetate. The resulting mixture was washed 10 times with 300 g of ion-exchange water, and then volatile components were evaporated in vacuo. Thereby, a polymer (G) was provided.

The number average molecular weight (Mn) of the polymer (G) was 1100. Result of chemical structure identification using $^{29}$Si-NMR showed that the polymer (G) had a following average composition formula (G1).

Composition formula (G1):

$$(Me_3SiO_{1/2})_{0.09}(HMe_2SiO_{1/2})_{0.19}(Ph_2SiO_{2/2})_{0.16}(PhSiO_{3/2})_{0.46}(Vi\ SiO_{3/2})_{0.10}$$

In the formula (G1), Me refers to a methyl group, Ph refers to a phenyl group, and Vi refers to a vinyl group.

The proportion of a unit corresponding to the unit represented by the formula (51-a) in 100 mol% of the total siloxane unit of the polymer (G) was 19 mol%. A phenyl group content in the polymer (G) was 51 mol%.

(Synthesis Example 8) Synthesis of second silicone resin B

Trimethylmethoxysilane (31 g), 1,1,3,3-tetramethyldisiloxane (40 g), diphenyldimethoxysilane (183 g), phenyltrimethoxysilane (149 g), vinyltrimethoxy silane (45 g), and 1,4-bis (dimethylmethoxysilyl) benzene (76 g) were charged into a 1000 mL separable flask equipped with a thermometer, a dropping appliance, and a stirrer, and were stirred at 50°C. An aqueous solution of 1.4 g hydrochloric acid in 105 g of water was slowly dropwise added to the mixture, and then stirred for six hours at 50°C for reaction to give a reaction solution. Subsequently, volatile components were evaporated in vacuo, and thereby a polymer was provided. To the polymer were added 150 g of hexane and 150 g of

ethylacetate. The resulting mixture was washed 10 times with 300 g of ion-exchange water, and then volatile components were evaporated in vacuo. Thereby, a polymer (H) was provided.

The number average molecular weight (Mn) of the polymer (H) was 1100. Result of chemical structure identification using $^{29}$Si-NMR showed that the polymer (H) had a following average composition formula (H1).

Composition formula (H1):

$$(Me_3SiO_{1/2})_{0.09}(HMe_2SiO_{1/2})_{0.19}(Ph_2SiO_{2/2})_{0.26}(PhSiO_{3/2})_{0.26}(Vi\ SiO_{3/2})_{0.10}(Me_4SiPheO_{2/2})_{0.10}$$

In the formula (H1), Me refers to a methyl group, Ph refers to a phenyl group, Vi refers to a vinyl group, and Phe refers to a phenylene group.

The proportion of a unit corresponding to the unit represented by the formula (51-a) in 100 mol% of the total siloxane unit of the polymer (H) was 19 mol%. A phenyl group content in the polymer (H) was 51 mol%.

(Synthesis Example 9) Synthesis of silicone resin similar to the first silicone resin (for Comparative Example)

Trimethylmethoxysilane (94 g), dimethyldimethoxysilane (99 g), diphenyldimethoxysilane (92 g), and vinyltrimethoxy silane (133 g) were charged into a 1000 mL separable flask equipped with a thermometer, a dropping appliance, and a stirrer, and were stirred at 50°C. An aqueous solution of 0.8 g potassium hydroxide dissolved in 108 g of water was slowly dropwise added to the mixture, and then stirred for six hours at 50°C for reaction to give a reaction solution. Subsequently, 0.9 g of acetic acid was added to the reaction solution, and volatile components were evaporated in vacuo. Thereafter, potassium acetate was removed by filtration, and thereby a polymer (I) was provided.

The number average molecular weight (Mn) of the polymer (I) was 1800. Result of chemical structure identification using $^{29}$Si-NMR showed that the polymer (I) had a following average composition formula (I1).

Composition formula (I1):

$$(Me_3SiO_{1/2})_{0.29}(Me_2SiO_{2/2})_{0.27}(Ph_2SiO_{2/2})_{0.13}(ViSiO_{3/2})_{0.31}$$

In the formula (I1), Me refers to a methyl group, Ph refers to a phenyl group, and Vi refers to a vinyl group.

A phenyl group content in the polymer (I) was 21 mol%.

(Synthesis Example 10) Synthesis of silicone resin similar to the second silicone resin (for Comparative Example)

Dimethyldimethoxysilane (180 g), diphenyldimethoxysilane (73 g), vinylmethyldimethoxysilane (119 g), and 1,4-bis(dimethylmethoxysilyl)benzene (76 g) were charged into a 1000 mL separable flask equipped with a thermometer, a dropping appliance, and a stirrer, and were stirred at 50°C. An aqueous solution of 0.8 g potassium hydroxide dissolved in 108 g of water was slowly dropwise added to the mixture, and then stirred for six hours at 50°C for reaction to give a reaction solution. Subsequently, 0.9 g of acetic acid was added to the reaction solution, and volatile components were evaporated in vacuo. Thereafter, potassium acetate was removed by filtration, and thereby a polymer (J) was provided.

The number average molecular weight (Mn) of the polymer (J) was 3400. Result of chemical structure identification using $^{29}$Si-NMR showed that the polymer (J) had a following average composition formula (J1).

Composition formula (J1):

$$(Me_2SiO_{2/2})_{0.49}(Ph_2SiO_{2/2})_{0.10}(ViMeSiO_{2/2})_{0.31}(Me_4SiPheO_{2/2})_{0.10}$$

In the formula (J1), Me refers to a methyl group, Ph refers to a phenyl group, Vi refers to a vinyl group, and Phe refers to a phenylene group.

A phenyl group content in the polymer (J) was 22 mol%.

(Synthesis Example 11) Synthesis of silicone resin similar to the second silicone resin (for Comparative Example) Trimethylmethoxysilane (31 g), 1,1,3,3-hexamethyldisiloxane (50 g), dimethyldimethoxysilane (140 g), diphenyldimethoxysilane (59 g), phenyltrimethoxy silane (48 g), and vinyltrimethoxysilane (45 g) were charged into a 1000 mL separable flask equipped with a thermometer, a dropping appliance, and a stirrer, and were stirred at 50°C. An aqueous solution of 1.4 g hydrochloric acid in 92 g of water was slowly dropwise added to the mixture, and then stirred for six hours at 50°C for reaction to give a reaction solution. Subsequently, volatile components were evaporated in vacuo, and thereby a polymer was provided. To the polymer were added 150 g of hexane and 150 g of ethylacetate. The resulting mixture was washed 10 times with 300 g of ion-exchange water, and then volatile components were evaporated in vacuo. Thereby, a polymer (K) was provided.

The number average molecular weight (Mn) of the polymer (K) was 600. Result of chemical structure identification using $^{29}$Si-NMR showed that the polymer (K) had a following average composition formula (K1).

Composition formula (K1):

$$(Me_3SiO_{1/2})_{0.09}(HMe_2SiO_{1/2})_{0.24}(Me_2SiO_{2/2})_{0.38}(Ph_2SiO_{2/2})_{0.08}(P hSiO_{3/2})_{0.10}(ViSiO_{3/2})_{0.10}$$

In the formula (K1), Me refers to a methyl group, Ph refers to a phenyl group, and Vi refers to a vinyl group.
A phenyl group content in the polymer (K) was 23 mol%.

(Synthesis Example 12) Synthesis of first silicone resins A, and A-2

Dimethyldimethoxysilane (96 g), diphenyldimethoxysilane (318 g), and vinylmethyldimethoxysilane (119 g) were charged into a 1000 mL separable flask equipped with a thermometer, a dropping appliance, and a stirrer, and were stirred at 50°C. An aqueous solution of 0.8 g potassium hydroxide dissolved in 108 g of water was slowly dropwise added to the mixture, and then stirred for six hours at 50°C for reaction to give a reaction solution. Subsequently, 0.9 g of acetic acid was added to the reaction solution, and volatile components were evaporated in vacuo. Thereafter, potassium acetate was removed by filtration, and thereby a polymer (L) was provided.
The number average molecular weight (Mn) of the polymer (L) was 5300. Result of chemical structure identification using $^{29}$Si-NMR showed that the polymer (L) had a following average composition formula (L1).
Composition formula (L1):

$$(Me_2SiO_{2/2})_{0.25}(Ph_2SiO_{2/2})_{0.45}(ViMeSiO_{2/2})_{0.30}$$

In the formula (L1), Me refers to a methyl group, Ph refers to a phenyl group, and Vi refers to a vinyl group.
The proportion of the diphenyl siloxane unit in 100 mol% of the total siloxane unit of the polymer (L) was 45 mol%. A phenyl group content in the polymer (L) was 52 mol%.

(Synthesis Example 13) Synthesis of first silicone resins A, and A-1

Methylphenyldimethoxysilane (383 g), and vinylmethyldimethoxysilane (119 g) were charged into a 1000 mL separable flask equipped with a thermometer, a dropping appliance, and a stirrer, and were stirred at 50°C. An aqueous solution of 0.8 g potassium hydroxide dissolved in 108 g of water was slowly dropwise added to the mixture, and then stirred for six hours at 50°C for reaction to give a reaction solution. Subsequently, 0.9 g of acetic acid was added to the reaction solution, and volatile components were evaporated in vacuo. Thereafter, potassium acetate was removed by filtration, and thereby a polymer (M) was provided.
The number average molecular weight (Mn) of the polymer (M) was 5300. Result of chemical structure identification using $^{29}$Si-NMR showed that the polymer (M) had a following average composition formula (M1).
Composition formula (M1):

$$(MePhSiO_{2/2})_{0.7}(ViMeSiO_{2/2})_{0.30}$$

In the formula (M1), Me refers to a methyl group, Ph refers to a phenyl group, and Vi refers to a vinyl group.
A phenyl group content in the polymer (M) was 45 mol%.

(Synthesis Example 14) Synthesis of first silicone resins A, and A-1

Vinyldimethylethoxysilane (98 g), dimethyldimethoxysilane (180 g), and diphenyldimethoxysilane (183 g) were charged into a 1000 mL separable flask equipped with a thermometer, a dropping appliance, and a stirrer, and were stirred at 50°C. An aqueous solution of 0.8 g potassium hydroxide dissolved in 95 g of water was slowly dropwise added to the mixture, and then stirred for six hours at 50°C for reaction to give a reaction solution. Subsequently, 0.9 g of acetic acid was added to the reaction solution, and volatile components were evaporated in vacuo. Thereafter, potassium acetate was removed by filtration, and thereby a polymer (N) was provided.
The number average molecular weight (Mn) of the polymer (N) was 1200. Result of chemical structure identification using $^{29}$Si-NMR showed that the polymer (N) had a following average composition formula (N1).
Composition formula (N1):

$$(ViMe_2SiO_{1/2})_{0.23}(Me_2SiO_{2/2})_{0.48}(Ph_2SiO_{2/2})_{0.29}$$

In the formula (N1), Me refers to a methyl group, Ph refers to a phenyl group, and Vi refers to a vinyl group.
A phenyl group content in the polymer (N) was 39 mol%.

(Synthesis Example 15) Synthesis of first silicone resins A, and A-1

Vinyldimethylethoxysilane (98 g), dimethyldimethoxysilane (90 g), and diphenyldimethoxysilane (367 g) were charged into a 1000 mL separable flask equipped with a thermometer, a dropping appliance, and a stirrer, and were stirred at 50°C. An aqueous solution of 0.8 g potassium hydroxide dissolved in 95 g of water was slowly dropwise added to the mixture, and then stirred for six hours at 50°C for reaction to give a reaction solution. Subsequently, 0.9 g of acetic acid was added to the reaction solution, and volatile components were evaporated in vacuo. Thereafter, potassium acetate was removed by filtration, and thereby a polymer (O) was provided.
The number average molecular weight (Mn) of the polymer (O) was 1300. Result of chemical structure identification using $^{29}$Si-NMR showed that the polymer (O) had a following average composition formula (01).
Composition formula (O1):

$$(ViMe_2SiO_{1/2})_{0.22}(Me_2SiO_{2/2})_{0.23}(Ph_2SiO_{2/2})_{0.55}$$

In the formula (O1), Me refers to a methyl group, Ph refers to a phenyl group, and Vi refers to a vinyl group.
A phenyl group content in the polymer (O) was 58 mol%.

(Synthesis Example 16) Synthesis of first silicone resins A, and A-1

Vinyldimethylethoxysilane (59 g), dimethyldimethoxysilane (126 g), and diphenyldimethoxysilane (367 g) were charged into a 1000 mL separable flask equipped with a thermometer, a dropping appliance, and a stirrer, and were stirred at 50°C. An aqueous solution of 0.8 g potassium hydroxide dissolved in 100 g of water was slowly dropwise added to the mixture, and then stirred for six hours at 50°C for reaction to give a reaction solution. Subsequently, 0.9 g of acetic acid was added to the reaction solution, and volatile components were evaporated in vacuo. Thereafter, potassium acetate was removed by filtration, and thereby a polymer (P) was provided.
The number average molecular weight (Mn) of the polymer (P) was 2700. Result of chemical structure identification using $^{29}$Si-NMR showed that the polymer (P) had a following average composition formula (P1).
Composition formula (P1):

$$(ViMe_2SiO_{1/2})_{0.12}(Me_2SiO_{2/2})_{0.32}(Ph_2SiO_{2/2})_{0.56}$$

In the formula (P1), Me refers to a methyl group, Ph refers to a phenyl group, and Vi refers to a vinyl group.
A phenyl group content in the polymer (P) was 59 mol%.

(Example 1)

The polymer A (10 g), the polymer E (10 g), and a platinum 1,3-divinyl-1,1,3,3-tetramethyldisiloxane complex (in an amount such that the platinum content by weight in a sealant was 10 ppm) were mixed and then defoamed so that a sealant for an optical semiconductor device was provided.

(Example 2)

The polymer B (10 g), the polymer E (10 g), and a platinum 1,3-divinyl-1,1,3,3-tetramethyldisiloxane complex (in an amount such that the platinum content by weight in a sealant was 10 ppm) were mixed and then defoamed so that a sealant for an optical semiconductor device was provided.

(Example 3)

The polymer C (10 g), the polymer E (10 g), and a platinum 1,3-divinyl-1,1,3,3-tetramethyldisiloxane complex (in an amount such that the platinum content by weight in a sealant was 10 ppm) were mixed and then defoamed so that a sealant for an optical semiconductor device was provided.

(Example 4)

The polymer C (10 g), the polymer E (10 g), a platinum 1,3-divinyl-1,1,3,3-tetramethyldisiloxane complex (in an amount such that the platinum content by weight in a sealant was 10 ppm), and silicon oxide particles (AEROSIL RY200, silicon oxide particles surface-treated with an organic silicon compound containing a polydimethyl siloxane group, surface area: 120 $m^2/g$, produced by Nippon Aerosil Co., Ltd.) (0.4 g) were mixed and then defoamed so that a

sealant for an optical semiconductor device was provided.

(Example 5)

The polymer C (10 g), the polymer E (10 g), a platinum 1,3-divinyl-1,1,3,3-tetramethyldisiloxane complex (in an amount such that the platinum content by weight in a sealant was 10 ppm), and silicon oxide particles (AEROSIL R8200, silicon oxide particles surface-treated with an organic silicon compound containing a trimethylsilyl group, surface area: 140 $m^2$/g, produced by Nippon Aerosil Co., Ltd.) (2 g) were mixed and then defoamed so that a sealant for an optical semiconductor device was provided.

(Example 6)

The polymer C (10 g), the polymer F (10 g), a platinum 1,3-divinyl-1,1,3,3-tetramethyldisiloxane complex (in an amount such that the platinum content by weight in a sealant was 10 ppm), and silicon oxide particles (AEROSIL RY200, silicon oxide particles surface-treated with an organic silicon compound containing a polydimethyl siloxane group, surface area: 120 $m^2$/g, produced by Nippon Aerosil Co., Ltd.) (0.4 g) were mixed and then defoamed so that a sealant for an optical semiconductor device was provided.

(Example 7)

The polymer C (10 g), the polymer G (10 g), a platinum 1,3-divinyl-1,1,3,3-tetramethyldisiloxane complex (in an amount such that the platinum content by weight in a sealant was 10 ppm), and silicon oxide particles (AEROSIL RY200, silicon oxide particles surface-treated with an organic silicon compound containing a polydimethyl siloxane group, surface area: 120 $m^2$/g, produced by Nippon Aerosil Co., Ltd.) (0.4 g) were mixed and then defoamed so that a sealant for an optical semiconductor device was provided.

(Example 8)

The polymer C (10 g), the polymer H (10 g), a platinum 1,3-divinyl-1,1,3,3-tetramethyldisiloxane complex (in an amount such that the platinum content by weight in a sealant was 10 ppm), and silicon oxide particles (AEROSIL RY200, silicon oxide particles surface-treated with an organic silicon compound containing a polydimethyl siloxane group, surface area: 120 $m^2$/g, produced by Nippon Aerosil Co., Ltd.) (0.4 g) were mixed and then defoamed so that a sealant for an optical semiconductor device was provided.

(Example 9)

The polymer D (10 g), the polymer E (10 g), a platinum 1,3-divinyl-1,1,3,3-tetramethyldisiloxane complex (in an amount such that the platinum content by weight in a sealant was 10 ppm), and silicon oxide particles (AEROSIL RY200, silicon oxide particles surface-treated with an organic silicon compound containing a polydimethyl siloxane group, surface area: 120 $m^2$/g, produced by Nippon Aerosil Co., Ltd.) (0.4 g) were mixed and then defoamed so that a sealant for an optical semiconductor device was provided.

(Example 10)

The polymer D (10 g), the polymer F (10 g), a platinum 1,3-divinyl-1,1,3,3-tetramethyldisiloxane complex (in an amount such that the platinum content by weight in a sealant was 10 ppm), and silicon oxide particles (AEROSIL RY200, silicon oxide particles surface-treated with an organic silicon compound containing a polydimethyl siloxane group, surface area: 120 $m^2$/g, produced by Nippon Aerosil Co., Ltd.) (0.4 g) were mixed and then defoamed so that a sealant for an optical semiconductor device was provided.

(Example 11)

The polymer D (10 g), the polymer G (10 g), a platinum 1,3-divinyl-1,1,3,3-tetramethyldisiloxane complex (in an amount such that the platinum content by weight in a sealant was 10 ppm), and silicon oxide particles (AEROSIL RY200, silicon oxide particles surface-treated with an organic silicon compound containing a polydimethyl siloxane group, surface area: 120 $m^2$/g, produced by Nippon Aerosil Co., Ltd.) (0.4 g) were mixed and then defoamed so that a sealant for an optical semiconductor device was provided.

(Example 12)

The polymer D (10 g), the polymer H (10 g), a platinum 1,3-divinyl-1,1,3,3-tetramethyldisiloxane complex (in an amount such that the platinum content by weight in a sealant was 10 ppm), and silicon oxide particles (AEROSIL RY200, silicon oxide particles surface-treated with an organic silicon compound containing a polydimethyl siloxane group, surface area: 120 $m^2$/g, produced by Nippon Aerosil Co., Ltd.) (0.4 g) were mixed and then defoamed so that a sealant for an optical semiconductor device was provided.

(Example 13)

The polymer C (10 g), the polymer E (10 g), a platinum 1,3-divinyl-1,1,3,3-tetramethyldisiloxane complex (in an amount such that the platinum content by weight in a sealant was 10 ppm), and silicon oxide particles (R974, silicon oxide particles surface-treated with an organic silicon compound containing a dimethyl siloxane group, surface area: 170 $m^2$/g, produced by Nippon Aerosil Co., Ltd.) (1.0 g) were mixed and then defoamed so that a sealant for an optical semiconductor device was provided.

(Comparative Example 1)

The polymer I (10 g), the polymer E (10 g), and a platinum 1,3-divinyl-1,1,3,3-tetramethyldisiloxane complex (in an amount such that the platinum content by weight in a sealant was 10 ppm) were mixed and then defoamed so that a sealant for an optical semiconductor device was provided.

(Comparative Example 2)

The polymer J (10 g), the polymer E (10 g), and a platinum 1,3-divinyl-1,1,3,3-tetramethyldisiloxane complex (in an amount such that the platinum content by weight in a sealant was 10 ppm) were mixed and then defoamed so that a sealant for an optical semiconductor device was provided.

(Comparative Example 3)

The polymer A (10 g), the polymer K (10 g), and a platinum 1,3-divinyl-1,1,3,3-tetramethyldisiloxane complex (in an amount such that the platinum content by weight in a sealant was 10 ppm) were mixed and then defoamed so that a sealant for an optical semiconductor device was provided.

(Evaluation on Examples 1 to 13 and Comparative Examples 1 to 3)

(Production of optical semiconductor device)

An optical semiconductor device was produced as follows: An element was prepared in which a light-emitting element having a main emission peak of 460 nm was mounted through die bond on a polyphthalamide housing material having a silver-plated lead electrode, with the lead electrode connected to the light-emitting element by a gold wire. Next, the sealant for an optical semiconductor device was charged into the element, and then heated at 150°C for two hours to cure the sealant. The resultant optical semiconductor device was examined by a gas corrosion test and a heat shock test mentioned below.

(Gas corrosion test)

The optical semiconductor device was placed in a chamber under a relative humidity atmosphere of 90% at 40°C. Then, the chamber was filled with gases such that hydrogen sulfide gas concentration and sulfur dioxide gas concentration reached 5 ppm and 15 ppm, respectively. Eye observation of the silver-plated lead electrode was performed 24 hours, 48 hours, 96 hours, 168 hours, and 500 hours after the gas filling.

The results were evaluated as follows: "○○" in the case where no tarnish was observed in the silver plating; "○" in the case where a few parts of the silver plating was tarnished brownish-red; "Δ" in the case where almost all the silver plating was tarnished brown; and "×" in the case where almost all the silver plating was tarnished black.

(Heat shock test)

Using a liquid-to-liquid thermal shock chamber (trade name "TSB-51", produced by ESPEC CORP), a thermal

cycle test in which a single cycle consisted of keeping at -50°C for five minutes, heating to 135°C, keeping at 135°C for five minutes, and cooling to -50°C was performed on the optical semiconductor device. Twenty pieces of each sample were taken out after 500 cycles, 1000 cycles, and 1500 cycles.

The samples were observed using a stereoscopic microscope (trade name "SMZ-10", produced by Nikon Corporation) to check occurrence of cracks in the 20 pieces of the samples, to check peeling of the sealant for an optical semiconductor device from the package or the electrode, and to count the number of samples (number of NG) in which cracking or peeling occurred.

(Measurement of viscosity at 25°C)

The viscosity of the sealant for an optical semiconductor device at 5 rpm at 25°C was measured with an E-type viscometer (TV-22 type, produced by Toki Sangyo Co., Ltd.).

(Measurement of minimum viscosity during heating)

The minimum viscosity (mPa·s) of the sealant for an optical semiconductor device at a shear rate of 1 $s^{-1}$ in a temperature range of 25°C to the curing temperature was determined by using a parallel plate rheometer (trade name "DAR-2000", produced by Reologica Instruments AB). Heating rate was 20°C/min from 25°C to the curing temperature, and thereafter, the measurement the continued at the curing temperature until significant viscosity increase occurred.

(Production of phosphor-containing sealant)

To 10 parts by weight of the respective sealants for an optical semiconductor device was added 0.8 parts by weight of phosphor powder (volume average particle diameter: 17 μm, specific gravity: 4.7, trade name "EY4254", produced by Intematix Corporation), and the mixture was stirred and defoamed. Thereby, a sealant for an optical semiconductor device (hereinafter, also referred to as a phosphor-containing sealant) was provided.

(Deposition property of phosphor)

The thus-obtained phosphor-containing sealant was placed in a transparent glass container, and heated at 150°C for two hours to cure the sealant. Thereafter, the phosphor in a cured product of the sealant was observed by eye. The results were evaluated as follows: "○" in the case where no phosphor deposited; "Δ" in the case where the phosphor deposited; and "×" in the case where the phosphor significantly deposited.

(Luminance evaluation)

The phosphor-containing sealant was charged into an optical semiconductor element in which a light-emitting element having a main emission peak of 460 nm was mounted through die bond on a polyphthalamide housing material having a silver-plated lead electrode, with the lead electrode connected to the light-emitting element by a gold wire. Next, heating was performed at 150°C for two hours to cure the sealant, and thereby 50 pieces of optical semiconductor devices were prepared.

At 23°C, a 60 mA current was passed through each of the light-emitting elements in the 50 pieces of the optical semiconductor devices, and the luminance was measured using a light measuring device (trade name: OL770, produced by Optronic Laboratories). The results were evaluated as follows: "o" in the case where the average luminance value of the 50 pieces of the optical semiconductor devices was 5.3 cd or more, and "×" in the case the average luminance value was less than 5.3 cd.

Tables 1 and 2 below show the results.

[Table 1]

| | | Ex. 1 | Ex. 2 | Ex. 3 | Ex. 4 | Ex. 5 | Ex. 6 | Ex. 7 | Ex. 8 |
|---|---|---|---|---|---|---|---|---|---|
| Gas corrosion test | 24 hours later | ○○ | ○○ | ○○ | ○○ | ○○ | ○○ | ○○ | ○○ |
| | 48 hours later | ○○ | ○○ | ○○ | ○○ | ○○ | ○○ | ○○ | ○○ |
| | 96 hours later | ○ | ○○ | ○○ | ○○ | ○○ | ○○ | ○○ | ○○ |
| | 168 hours later | ○ | ○ | ○ | ○○ | ○○ | ○○ | ○○ | ○○ |
| | 500 hours later | Δ | Δ | ○ | ○ | ○ | ○ | ○ | ○○ |
| Heat shock test (Number of NG) | 500 cycles | 0/20 | 0/20 | 0/20 | 0/20 | 0/20 | 0/20 | 0/20 | 0/20 |
| | 1000 cycles | 0/20 | 0/20 | 0/20 | 0/20 | 0/20 | 0/20 | 0/20 | 0/20 |
| | 1500 cycles | 4/20 | 0/20 | 0/20 | 0/20 | 0/20 | 0/20 | 0/20 | 0/20 |
| Viscosity at 25°C (mPa·s) | | 3,200 | 1,500 | 2,000 | 2,400 | 3,000 | 3,300 | 5,600 | 3,800 |
| Minimum viscosity during heating(mPa·s) | | 100 | 80 | 80 | 1,000 | 800 | 1,200 | 1,500 | 1,300 |
| Deposition property of phosphor | | × | × | × | ○ | ○ | ○ | ○ | ○ |
| Luminance evaluation | | × | × | × | ○ | ○ | ○ | ○ | ○ |

[Table 2]

| | | Ex. 9 | Ex.10 | Ex. 11 | Ex. 12 | Ex. 13 | Comp. Ex. 1 | Comp. Ex. 2 | Comp. Ex. 3 |
|---|---|---|---|---|---|---|---|---|---|
| Gas corrosion test | 24 hours later | ○○ | ○○ | ○○ | ○○ | ○○ | ○ | ○ | ○ |
| | 48 hours later | ○○ | ○○ | ○○ | ○○ | ○○ | Δ | ○ | Δ |
| | 96 hours later | ○○ | ○○ | ○○ | ○○ | ○○ | Δ | Δ | Δ |
| | 168 hours later | ○○ | ○○ | ○○ | ○○ | ○○ | × | × | × |
| | 500 hours later | ○○ | ○○ | ○○ | ○○ | ○ | × | × | × |

(continued)

| | | Ex. 9 | Ex.10 | Ex. 11 | Ex. 12 | Ex. 13 | Comp. Ex. 1 | Comp. Ex. 2 | Comp. Ex. 3 |
|---|---|---|---|---|---|---|---|---|---|
| Heat shock test (Number of NG) | 500 cycles | 0/20 | 0/20 | 0/20 | 0/20 | 0/20 | 0/20 | 0/20 | 0/20 |
| | 1000 cycles | 0/20 | 0/20 | 0/20 | 0/20 | 0/20 | 4/20 | 0/20 | 0/20 |
| | 1500 cycles | 0/20 | 0/20 | 0/20 | 0/20 | 0/20 | 9/20 | 0/20 | 3/20 |
| Viscosity at 25°C (mPa·s) | | 3,500 | 4,400 | 6,300 | 4,900 | 4,300 | 1,500 | 700 | 1,000 |
| Minimum viscosity during heating (mPa·s) | | 1,200 | 1,300 | 1,700 | 1,400 | 400 | 80 | 70 | 80 |
| Deposition property of phosphor | | ○ | ○ | ○ | ○ | ○ | × | × | × |
| Luminance evaluation | | ○ | ○ | ○ | ○ | ○ | × | × | × |

(Example 14)

The polymer L (10 g), the polymer E (10 g), a platinum 1,3-divinyl-1,1,3,3-tetramethyldisiloxane complex (in an amount such that the platinum content by weight in a sealant was 10 ppm), and silicon oxide particles (AEROSIL RY200, silicon oxide particles surface-treated with an organic silicon compound containing a polydimethyl siloxane group, surface area: 120 $m^2$/g, produced by Nippon Aerosil Co., Ltd.) (0.4 g) were mixed and then defoamed so that a sealant for an optical semiconductor device was provided.

(Example 15)

The polymer L (10 g), the polymer E (10 g), a platinum 1,3-divinyl-1,1,3,3-tetramethyldisiloxane complex (in an amount such that the platinum content by weight in a sealant was 10 ppm), and silicon oxide particles (AEROSIL R8200, silicon oxide particles surface-treated with an organic silicon compound containing a trimethylsilyl group, surface area: 140 $m^2$/g, produced by Nippon Aerosil Co., Ltd.) (1. 5 g) were mixed and then defoamed so that a sealant for an optical semiconductor device was provided.

(Example 16)

The polymer L (10 g), the polymer F (10 g), a platinum 1,3-divinyl-1,1,3,3-tetramethyldisiloxane complex (in an amount such that the platinum content by weight in a sealant was 10 ppm), and silicon oxide particles (AEROSIL RY200, silicon oxide particles surface-treated with an organic silicon compound containing a polydimethyl siloxane group, surface area: 120 $m^2$/g, produced by Nippon Aerosil Co., Ltd.) (0.4 g) were mixed and then defoamed so that a sealant for an optical semiconductor device was provided.

(Example 17)

The polymer L (10 g), the polymer G (10 g), a platinum 1,3-divinyl-1,1,3,3-tetramethyldisiloxane complex (in an amount such that the platinum content by weight in a sealant was 10 ppm), and silicon oxide particles (AEROSIL RY200, silicon oxide particles surface-treated with an organic silicon compound containing a polydimethyl siloxane group, surface area: 120 $m^2$/g, produced by Nippon Aerosil Co., Ltd.) (0.4 g) were mixed and then defoamed so that a sealant for an optical semiconductor device was provided.

(Example 18)

The polymer C (10 g), the polymer H (10 g), a platinum 1,3-divinyl-1,1,3,3-tetramethyldisiloxane complex (in an amount such that the platinum content by weight in a sealant was 10 ppm), and silicon oxide particles (AEROSIL RY200, silicon oxide particles surface-treated with an organic silicon compound containing a polydimethyl siloxane

group, surface area: 120 $m^2/g$, produced by Nippon Aerosil Co., Ltd.) (0.8 g) were mixed and then defoamed so that a sealant for an optical semiconductor device was provided.

(Example 19)

The polymer L (10 g), the polymer E (10 g), and a platinum 1,3-divinyl-1,1,3,3-tetramethyldisiloxane complex (in an amount such that the platinum content by weight in a sealant was 10 ppm) were mixed and then defoamed so that a sealant for an optical semiconductor device was provided.

(Example 20)

The polymer M (10 g), the polymer F (10 g), a platinum 1,3-divinyl-1,1,3,3-tetramethyldisiloxane complex (in an amount such that the platinum content by weight in a sealant was 10 ppm), and silicon oxide particles (AEROSIL RY200, silicon oxide particles surface-treated with an organic silicon compound containing a polydimethyl siloxane group, surface area: 120 $m^2/g$, produced by Nippon Aerosil Co., Ltd.) (0.4 g) were mixed and then defoamed so that a sealant for an optical semiconductor device was provided.

(Example 21)

The polymer M (10 g), the polymer F (10 g), and a platinum 1,3-divinyl-1,1,3,3-tetramethyldisiloxane complex (in an amount such that the platinum content by weight in a sealant was 10 ppm) were mixed and then defoamed so that a sealant for an optical semiconductor device was provided.

(Evaluation on Examples 6, 10, 14 to 21)

(Production of optical semiconductor device)

An optical semiconductor device was produced as follows: An element was prepared in which a light-emitting element having a main emission peak of 460 nm was mounted through die bond on a polyphthalamide housing material having a silver-plated lead electrode, with the lead electrode connected to the light-emitting element by a gold wire. Next, the sealant for an optical semiconductor device was charged into the element, and then heated at 150°C for two hours to cure the sealant. The resultant optical semiconductor device was examined for the evaluation items mentioned below.

(Gas corrosion test)

The optical semiconductor device was placed in a chamber under a relative humidity atmosphere of 90% at 40°C. Then, the chamber was filled with gases such that hydrogen sulfide gas concentration and sulfur dioxide gas concentration reached 5 ppm and 15 ppm, respectively. Eye observation of the silver-plated lead electrode was performed 24 hours, 48 hours, 96 hours, 168 hours, and 500 hours after the gas filling.

The results were evaluated as follows: "○○" in the case where no tarnish was observed in the silver plating; "○" in the case where a few parts of the silver plating was tarnished brownish-red; "Δ" in the case where almost all the silver plating was tarnished brown; and "×" in the case where almost all the silver plating was tarnished black.

(Heat shock test)

Using a liquid-to-liquid thermal shock chamber (trade name "TSB-51", produced by ESPEC CORP), a thermal cycle test in which a single cycle consisted of keeping at -50°C for five minutes, heating to 135°C, keeping at 135°C for five minutes, and cooling to -50°C was performed on the optical semiconductor device. Twenty pieces of each sample were taken out after 500 cycles, 1000 cycles, and 1500 cycles.

The samples were observed using a stereoscopic microscope (trade name "SMZ-10", produced by Nikon Corporation) to check occurrence of cracks in the 20 pieces of the samples, to check peeling of the sealant for an optical semiconductor device from the package or the electrode, and to count the number of samples (number of NG) in which cracking or peeling occurred.

(Production of phosphor-containing sealant)

To 10 parts by weight of the respective sealants for an optical semiconductor device provided in Examples and

Comparative Examples was added 0.8 parts by weight of phosphor powder (volume average particle diameter: 17 μm, specific gravity: 4.7, trade name "EY4453", produced by Intematix Corporation), and the mixture was stirred and defoamed. Thereby, a sealant for an optical semiconductor device (hereinafter, also referred to as a phosphor-containing sealant) was provided.

(Measurement of viscosity at 25°C)

The viscosities of the first organosiloxane and the second organosiloxane used for the sealant for an optical semiconductor device at 5 rpm at 25°C were measured with an E-type viscometer (TV-22 type, produced by Toki Sangyo Co., Ltd.). The viscosity (mPa·s) of the sealant for an optical semiconductor device at 5 rpm, 1 rpm, and 10 rpm at 25°C, and also the viscosity (mPa·s) of the phosphor-containing sealant at 5 rpm, 1 rpm, and 10 rpm at 25°C were measured with an E-type viscometer (TV-22 type, produced by Toki Sangyo Co., Ltd.).

(Measurement of minimum viscosity during heating)

The minimum viscosity (mPa·s) of the sealant for an optical semiconductor device at a shear rate of 1 $s^{-1}$ in a temperature range of 25°C to the curing temperature was determined by using a parallel plate rheometer (trade name "DAR-2000", produced by Reologica Instruments AB). Heating rate was 20°C/min from 25°C to the curing temperature, and thereafter, the measurement the continued at the curing temperature until significant viscosity increase occurred. The same evaluation was performed on the sealants containing a phosphor as well.

(Dispensability)

The phosphor-containing sealant was charged with a dispenser (trade name "SHOTMASTER-300", produced by Musashi Engineering Inc.) into an element in which a light-emitting element having a main emission peak of 460 nm was mounted through die bond on a polyphthalamide housing material having a silver-plated lead electrode, with the lead electrode connected to the light-emitting element by a gold wire. The above sample was observed using a stereoscopic microscope (trade name "SMZ-10", produced by Nikon Corporation). The results were evaluated as follows: "○" in the case where no variation was found in the filling amount of the sealant; and "x" in the case where the filling amount was varied.

(Deposition property of phosphor) Stability of phosphor in uncured state

The phosphor-containing sealant was placed in a transparent glass container, and was allowed to stand at 23°C for 24 hours. Thereafter, the state of the phosphor in the uncured sealant was observed by eye. The results were evaluated as follows: "○" in the case where no phosphor deposited; "Δ" in the case where the phosphor deposited; and "×" in the case where the phosphor significantly deposited.

(Deposition property of phosphor) Stability of phosphor in cured state

The phosphor-containing sealant was placed in a transparent glass container, and was heated at 100°C for three hours and subsequently at 130°C for three hours to cure the sealant. Thereafter, the state of the phosphor in the cured sealant was observed by eye. The results were evaluated as follows: "○" in the case where no phosphor deposited; "Δ" in the case where the phosphor deposited; and "×" in the case where the phosphor significantly deposited.

(Luminance evaluation)

The phosphor-containing sealant was charged into an optical semiconductor element in which a light-emitting element having a main emission peak of 460 nm was mounted through die bond on a polyphthalamide housing material having a silver-plated lead electrode, with the lead electrode connected to the light-emitting element by a gold wire. Next, heating was performed at 100°C for three hours and subsequently at 130 °C for three hours to cure the sealant, and thereby 50 pieces of optical semiconductor devices were prepared.

At 23°C, a 60 mA current was passed through each of the light-emitting elements in the 50 pieces of the optical semiconductor devices, and the luminance was measured using a light measuring device (trade name: OL770, produced by Optronic Laboratories). The results were evaluated as follows: "○" in the case where the average luminance value of the 50 pieces of the optical semiconductor devices was 5.3 cd or more, and "×" in the case where the average luminance value was less than 5.3 cd.
Table 3 below shows the results.

[Table 3]

| | | Ex. 14 | Ex. 15 | Ex. 16 | Ex. 17 | Ex. 18 | Ex. 6 | Ex. 10 | Ex. 19 | Ex. 20 | Ex. 21 |
|---|---|---|---|---|---|---|---|---|---|---|---|
| Gas corrosion test | 24 hours later | ○○ | ○○ | ○○ | ○○ | ○○ | ○○ | ○○ | ○○ | ○○ | ○○ |
| | 48 hours later | ○○ | ○○ | ○○ | ○○ | ○○ | ○○ | ○○ | ○○ | ○○ | ○○ |
| | 96 hours later | ○○ | ○○ | ○○ | ○○ | ○○ | ○○ | ○○ | ○○ | ○○ | ○○ |
| | 168 hours later | ○○ | ○○ | ○○ | ○○ | ○○ | ○○ | ○○ | ○ | ○○ | ○ |
| | 500 hours later | ○ | ○ | ○ | ○ | ○ | ○ | ○○ | Δ | ○ | Δ |
| Heat shock test (Number of NG) | 500 cycles | 0/20 | 0/20 | 0/20 | 0/20 | 0/20 | 0/20 | 0/20 | 0/20 | 0/20 | 0/20 |
| | 1000 cycles | 0/20 | 0/20 | 0/20 | 0/20 | 0/20 | 0/20 | 0/20 | 0/20 | 0/20 | 0/20 |
| | 1500 cycles | 0/20 | 0/20 | 0/20 | 0/20 | 0/20 | 0/20 | 0/20 | 0/20 | 0/20 | 0/20 |
| Viscosity of the first silicone resin at 5 rpm at 25°C (mPa·s) | | 9200 | 9200 | 9200 | 9200 | 9200 | 6000 | 13000 | 9200 | 28000 | 28000 |
| Viscosity of the second silicone resin at 5 rpm at 25°C (mPa·s) | | 600 | 600 | 1100 | 3200 | 2700 | 1100 | 1100 | 600 | 1100 | 1100 |
| Viscosity η1 of sealant containing no phosphor at 5 rpm at 25°C (mPa·s) | | 3000 | 2500 | 3800 | 6000 | 8200 | 3300 | 4400 | 2.100 | 15000 | 11000 |
| Viscosity η2 of sealant containing no phosphor at 1 rpm at 25°C (mPa·s) | | 4100 | 2900 | 5200 | 8100 | 14000 | 4500 | 6000 | 2.100 | 20100 | 11000 |
| Viscosity η3 of sealant containing no phosphor at 10 rpm at 25°C (mPa·s) | | 2700 | 2300 | 3500 | 5400 | 6800 | 3000 | 4100 | 2.100 | 13500 | 11000 |
| Viscosity ratio (η2/η3) of sealants containing no phosphor | | 1.52 | 1.26 | 1.49 | 1.50 | 2.06 | 1.50 | 1.46 | 1.00 | 1.49 | 1.00 |

(continued)

| | Ex. 14 | Ex. 15 | Ex. 16 | Ex. 17 | Ex. 18 | Ex. 6 | Ex. 10 | Ex. 19 | Ex. 20 | Ex. 21 |
|---|---|---|---|---|---|---|---|---|---|---|
| Viscosity η1 of phosphor-containing sealant at 5 rpm at 25°C (mPa·s) | 3100 | 2600 | 4000 | 6300 | 8500 | 3400 | 4600 | 2200 | 15500 | 11500 |
| Viscosity η2 of phosphor-containing sealant at 1 rpm at 25°C (mPa·s) | 4200 | 3000 | 5400 | 8300 | 14800 | 4600 | 6300 | 2200 | 21200 | 11500 |
| Viscosity η3 of phosphor-containing sealant at 10 rpm at 25°C (mPa·s) | 2800 | 2400 | 3600 | 5600 | 7000 | 3100 | 4200 | 2100 | 14000 | 11300 |
| Viscosity ratio (η2/η3) of phosphor-containing sealants | 1.50 | 1.25 | 1.50 | 1.48 | 2.11 | 1.48 | 1.50 | 1.05 | 1.51 | 1.02 |
| Minimum viscosity of sealant containing no phosphor during heating(mPa·s) | 1100 | 500 | 1200 | 1500 | 1700 | 1200 | 1300 | 100 | 2100 | 500 |
| Minimum viscosity of phosphor-containing sealant upon heating (mPa·s) | 1100 | 500 | 1200 | 1500 | 1700 | 1200 | 1300 | 100 | 2100 | 500 |
| Dispensability | ○ | ○ | ○ | ○ | ○ | ○ | ○ | ○ | × | × |
| Deposition property of phosphor (uncured) | ○ | ○ | ○ | ○ | ○ | ○ | ○ | × | ○ | Δ |
| Deposition property of phosphor (cured) | ○ | ○ | ○ | ○ | ○ | ○ | ○ | × | ○ | ○ |
| Luminance evaluation | ○ | ○ | ○ | ○ | ○ | ○ | ○ | × | ○ | ○ |

(Example 22)

The polymer A (9 g), the polymer N (1 g), the polymer E (10 g), and a platinum 1,3-divinyl-1,1,3,3-tetramethyldisiloxane complex (in an amount such that the platinum content by weight in a sealant was 10 ppm) were mixed and then defoamed so that a sealant for an optical semiconductor device was provided.

(Example 23)

The polymer L (9 g), the polymer N (1 g), the polymer E (10 g), and a platinum 1,3-divinyl-1,1,3,3-tetramethyldisiloxane complex (in an amount such that the platinum content by weight in a sealant was 10 ppm) were mixed and then defoamed so that a sealant for an optical semiconductor device was provided.

(Example 24)

The polymer L (9 g), the polymer N (1 g), the polymer F (10 g), and a platinum 1,3-divinyl-1,1,3,3-tetramethyldisiloxane complex (in an amount such that the platinum content by weight in a sealant was 10 ppm) were mixed and then defoamed so that a sealant for an optical semiconductor device was provided.

(Example 25)

The polymer L (9 g), the polymer N (1 g), the polymer F (10 g), and a platinum 1,3-divinyl-1,1,3,3-tetramethyldisiloxane complex (in an amount such that the platinum content by weight in a sealant was 10 ppm), and silicon oxide particles (AEROSIL RY200, silicon oxide particles surface-treated with an organic silicon compound containing a polydimethyl siloxane group, surface area: 120 $m^2/g$, produced by Nippon Aerosil Co., Ltd.) (0.4 g) were mixed and then defoamed so that a sealant for an optical semiconductor device was provided.

(Example 26)

The polymer L (9 g), the polymer N (1 g), the polymer G (10 g), and a platinum 1,3-divinyl-1,1,3,3-tetramethyldisiloxane complex (in an amount such that the platinum content by weight in a sealant was 10 ppm), and silicon oxide particles (AEROSIL RY200, silicon oxide particles surface-treated with an organic silicon compound containing a polydimethyl siloxane group, surface area: 120 $m^2/g$, produced by Nippon Aerosil Co., Ltd.) (0.4 g) were mixed and then defoamed so that a sealant for an optical semiconductor device was provided.

(Example 27)

The polymer A (10 g), the polymer E (10 g), and a platinum 1,3-divinyl-1,1,3,3-tetramethyldisiloxane complex (in an amount such that the platinum content by weight in a sealant was 10 ppm) were mixed and then defoamed so that a sealant for an optical semiconductor device was provided.

(Comparative Example 4)

The polymer I (9 g), the polymer N (1 g), the polymer E (10 g), and a platinum 1,3-divinyl-1,1,3,3-tetramethyldisiloxane complex (in an amount such that the platinum content by weight in a sealant was 10 ppm) were mixed and then defoamed so that a sealant for an optical semiconductor device was provided.

(Comparative Example 5)

The polymer A (9 g), the polymer N (1 g), the polymer K (10 g), and a platinum 1,3-divinyl-1,1,3,3-tetramethyldisiloxane complex (in an amount such that the platinum content by weight in a sealant was 10 ppm) were mixed and then defoamed so that a sealant for an optical semiconductor device was provided.

(Example 28)

The polymer N (10 g), the polymer F (20 g), and a platinum 1,3-divinyl-1,1,3,3-tetramethyldisiloxane complex (in an amount such that the platinum content by weight in a sealant was 10 ppm) were mixed and then defoamed so that a sealant for an optical semiconductor device was provided.

(Example 29)

The polymer N (10 g), the polymer G (20 g), and a platinum 1,3-divinyl-1,1,3,3-tetramethyldisiloxane complex (in an amount such that the platinum content by weight in a sealant was 10 ppm) were mixed and then defoamed so that a sealant for an optical semiconductor device was provided.

(Example 30)

The polymer O (10 g), the polymer F (20 g), a platinum 1,3-divinyl-1,1,3,3-tetramethyldisiloxane complex (in an amount such that the platinum content by weight in a sealant was 10 ppm), and silicon oxide particles (AEROSIL 200, surface area: 200 $m^2/g$, produced by Nippon Aerosil Co., Ltd.) (1 g) were mixed and then defoamed so that a sealant for an optical semiconductor device was provided.

(Example 31)

The polymer O (10 g), the polymer G (20 g), a platinum 1,3-divinyl-1,1,3,3-tetramethyldisiloxane complex (in an amount such that the platinum content by weight in a sealant was 10 ppm), and silicon oxide particles (AEROSIL 200, surface area: 200 $m^2/g$, produced by Nippon Aerosil Co., Ltd.) (1 g) were mixed and then defoamed so that a

sealant for an optical semiconductor device was provided.

(Example 32)

The polymer P (10 g), the polymer F (20 g), and a platinum 1,3-divinyl-1,1,3,3-tetramethyldisiloxane complex (in an amount such that the platinum content by weight in a sealant was 10 ppm) were mixed and then defoamed so that a sealant for an optical semiconductor device was provided.

(Example 33)

The polymer P (10 g), the polymer G (20 g), and a platinum 1,3-divinyl-1,1,3,3-tetramethyldisiloxane complex (in an amount such that the platinum content by weight in a sealant was 10 ppm) were mixed and then defoamed so that a sealant for an optical semiconductor device was provided.

(Evaluation on Examples 22 to 33 and Comparative Examples 4, 5)

(Production of optical semiconductor device)

An optical semiconductor device was produced as follows: An element was prepared in which a light-emitting element having a main emission peak of 460 nm was mounted through die bond on a polyphthalamide housing material having a silver-plated lead electrode, with the lead electrode connected to the light-emitting element by a gold wire. Next, the sealant for an optical semiconductor device was charged into the element, and then heated at 150°C for two hours to cure the sealant. The resultant optical semiconductor device was examined for the evaluation items mentioned below.

(Gas corrosion test)

The optical semiconductor device was placed in a chamber under a relative humidity atmosphere of 90% at 40°C. Then, the chamber was filled with gases such that hydrogen sulfide gas concentration and sulfur dioxide gas concentration reached 5 ppm and 15 ppm, respectively. Eye observation of the silver-plated lead electrode was performed 24 hours, 48 hours, 96 hours, 168 hours, and 500 hours after the gas filling.

The results were evaluated as follows: "○○" in the case where no tarnish was observed in the silver plating; "○" in the case where a few parts of the silver plating were tarnished brownish-red; "Δ" in the case where almost all the silver plating was tarnished brown; and "×" in the case where almost all the silver plating was tarnished black.

(Heat shock test)

Using a liquid-to-liquid thermal shock chamber (trade name "TSB-51", produced by ESPEC CORP), a thermal cycle test in which a single cycle consisted of keeping at -50°C for five minutes, heating to 135°C, keeping at 135°C for five minutes, and cooling to -50°C was performed on the optical semiconductor device. Twenty pieces of each sample were taken out after 500 cycles, 1000 cycles, 1500 cycles, and 2000 cycles.

The samples were observed using a stereoscopic microscope (trade name "SMZ-10", produced by Nikon Corporation) to check occurrence of cracks in the 20 pieces of the samples, to check peeling of the sealant for an optical semiconductor device from the package or the electrode, and to count the number of samples (number of NG) in which cracking or peeling occurred.

(Evaluation on adhesiveness (stickiness) on the surface of cured product of sealant for an optical semiconductor device)

The optical semiconductor device was allowed to stand for 24 hours under a relative humidity atmosphere of 50% at 23°C. Immediately after finishing the 24-hour standing, adhesiveness (stickiness) on the surface of a cured product of the sealant for an optical semiconductor device was examined by touching the cured product with a finger. The results were evaluated as follows: "○" in the case of no adhesiveness with almost no sense of adhesive (sticky) feeling upon touching the cured sealant with a finger; and "×" in the case of adhesiveness with a sense of adhesive (sticky) feeling upon touching the surface.

(Humidity-resistance reliability test)

The luminance of the optical semiconductor device upon passing a 20 mA current through the light-emitting

element (hereinafter referred to as "initial luminance") at 23°C was measured using a light measuring device (trade name: OL770, produced by Optronic Laboratories).

Next, the optical semiconductor device, in which a 20 mA current was still passed through the light-emitting element, was placed in a chamber under a relative humidity atmosphere of 85% at 110°C, and was allowed to stand for 500 hours. After 1000 hours, the luminance of the optical semiconductor device upon passing a 20 mA current through the light-emitting element at 23°C was measured using a light measuring device (trade name: OL770, produced by Optronic Laboratories). The reduction rate of the luminance relative to the initial luminance was calculated. The results were evaluated as follows: "○○" in the case where the luminance reduction rate was less than 5%; "○" in the case where the reduction rate was not less than 5% and less than 10%; "Δ" in the case where the reduction rate was not less than 10% and less than 20%; and "×" in the case where the reduction rate was not less than 30%.

Table 4 below shows the results.

[Table 4]

| | | Ex. 22 | Ex. 23 | Ex. 24 | Ex. 25 | Ex. 26 | Ex. 27 | Comp. Ex. 4 | Comp. Ex. 5 |
|---|---|---|---|---|---|---|---|---|---|
| Gas corrosion test | 24 hours later | ○○ | ○○ | ○○ | ○○ | ○○ | ○○ | ○ | ○ |
| | 48 hours later | ○○ | ○○ | ○○ | ○○ | ○○ | ○○ | Δ | Δ |
| | 96 hours later | ○ | ○○ | ○○ | ○○ | ○○ | ○ | Δ | Δ |
| | 168 hours later | ○ | ○ | ○ | ○○ | ○○ | ○ | × | × |
| | 500 hours later | Δ | ○ | ○ | ○ | ○ | Δ | × | × |
| Heat shock test (Number of NG) | 500 cycles | 0/20 | 0/20 | 0/20 | 0/20 | 0/20 | 0/20 | 0/20 | 0/20 |
| | 1000 cycles | 0/20 | 0/20 | 0/20 | 0/20 | 0/20 | 0/20 | 2/20 | 0/20 |
| | 1500 cycles | 4/20 | 0/20 | 0/20 | 0/20 | 0/20 | 6/20 | 8/20 | 2/20 |
| | 2000 cycles | 12/20 | 0/20 | 0/20 | 0/20 | 0/20 | 18/20 | 20/20 | 10/20 |
| Adhesiveness (stickiness) on the surface | | ○ | ○ | ○ | ○ | ○ | × | ○ | ○ |
| Humidity-resistance reliability test | | ○ | ○ | ○ | ○ | ○ | × | Δ | Δ |

(continued)

| | | Ex. 28 | Ex. 29 | Ex. 30 | Ex. 31 | Ex. 32 | Ex. 33 |
|---|---|---|---|---|---|---|---|
| Gas corrosion test | 24 hours later | ○○ | ○○ | ○○ | ○○ | ○○ | ○○ |
| | 48 hours later | ○○ | ○○ | ○○ | ○○ | ○○ | ○○ |
| | 96 hours later | ○○ | ○○ | ○○ | ○○ | ○○ | ○○ |
| | 168 hours later | ○ | ○ | ○○ | ○○ | ○ | ○ |
| | 500 hours later | ○ | ○ | ○ | ○ | ○ | ○ |
| Heat shock test (Number of NG) | 500 cycles | 0/20 | 0/20 | 0/20 | 0/20 | 0/20 | 0/20 |
| | 1000 cycles | 0/20 | 0/20 | 0/20 | 0/20 | 0/20 | 0/20 |
| | 1500 cycles | 0/20 | 0/20 | 0/20 | 0/20 | 0/20 | 0/20 |
| | 2000 cycles | 1/20 | 2/20 | 1/20 | 2/20 | 2/20 | 3/20 |
| Adhesiveness (stickiness) on the surface | | ○ | ○ | ○ | ○ | ○ | ○ |
| Humidity-resistance reliability test | | ○○ | ○○ | ○○ | ○○ | ○○ | ○○ |

## Claims

**1.** A sealant for an optical semiconductor device, comprising:

a first silicone resin component including at least one of a first silicone resin A represented by formula (1A) shown below and a first silicone resin B represented by formula (1B) shown below,
the first silicone resin A not containing a hydrogen atom bound to a silicon atom, but containing an aryl group and an alkenyl group,
the first silicone resin B not containing a hydrogen atom bound to a silicon atom, but containing an aryl group and an alkenyl group;
a second silicone resin component including at least one of a second silicone resin A represented by formula (51A) shown below and a second silicone resin B represented by formula (51B) shown below,
the second silicone resin A containing an aryl group and a hydrogen atom directly bound to a silicon atom,
the second silicone resin B containing an aryl group and a hydrogen atom directly bound to a silicon atom; and
a catalyst for hydrosilylation reaction,
wherein
an aryl group content in the first silicone resin A calculated based on formula (a1) shown below is from 30 mol% to 70 mol%,
a total content of the aryl group and a phenylene group in the first silicone resin B calculated based on formula (b1) shown below is from 30 mol% to 70 mol%,
an aryl group content in the second silicone resin A calculated based on formula (a51) shown below is from 30 mol% to 70 mol%, and
a total content of the aryl group and a phenylene group in the second silicone resin B calculated based on formula (b1) shown below is from 30 mol% to 70 mol%;

**[Chem. 1]**

$$(R1R2R3SiO_{1/2})_a(R4R5SiO_{2/2})_b(R6SiO_{3/2})_c \quad \text{Formula(1A)}$$

In the formula (1A), a, b, and c satisfy the following equations: a/(a+b+c) = 0 to 0.50, b/(a+b+c) = 0. 40 to 1.0, and c/(a+b+c) = 0 to 0.50; and

at least one of R1 to R6 represents a phenyl group corresponding to an aryl group, at least one of R1 to R6 represents an alkenyl group, and the rest of the R1 to R6 other than phenyl groups and alkenyl groups represent $C_1$ to $C_8$ hydrocarbon groups;

**[Chem. 2]**

$$(R1R2R3SiO_{1/2})_a(R4R5SiO_{2/2})_b(R6SiO_{3/2})_c(R7R8R9R10Si_2R11O_{2/2})_d \quad \text{Formula (1B)}$$

In the formula (1B), a, b, c and d satisfy the following equations: a/(a+b+c+d) = 0 to 0.40, b/(a+b+c+d) = 0. 40 to 0. 99, c/(a+b+c+d) = 0 to 0.50, and d/(a+b+c+d) = 0.01 to 0.40; and

at least one of R1 to R6 represents a phenyl group corresponding to an aryl group, at least one of R1 to R6 represents an alkenyl group, and the rest of the R1 to R6 other than phenyl groups and alkenyl groups represents $C_1$ to $C_8$ hydrocarbon groups, R7 to R10 each represent a $C_1$ to $C_8$ hydrocarbon group, and R11 represents a $C_1$ to $C_8$ bivalent hydrocarbon group;

**[Chem. 3]**

$$(R51R52R53SiO_{1/2})_p(R54R55SiO_{2/2})_q(R56SiO_{3/2})_r \quad \text{Formula(51A)}$$

In the formula (51A), p, q, and r satisfy the following equations: p/(p+q+r) = 0.05 to 0.50, q/(p+q+r) = 0.05 to 0.50, and r/(p+q+r) = 0.20 to 0.80; and

at least one of R51 to R56 represents a phenyl group corresponding to an aryl group, at least one of R51 to R56 represents a hydrogen atom directly bound to a silicon atom, and the rest of the R51 to R56 other than phenyl groups and hydrogen atoms directly bound to a silicon atom represent $C_1$ to $C_8$ hydrocarbon groups;

**[Chem. 4]**

$$(R51R52R53SiO_{1/2})_p(R54R55SiO_{2/2})_q(R56SiO_{3/2})_r(R57R58R59R60Si_2R61O_{2/2})_s \quad \text{Formula(51B)}$$

In the formula (51B), p, q, r and s satisfy the following equations: p/(p+q+r+s) = 0.05 to 0.50, q/(p+q+r+s) = 0.05 to 0. 50, r/(p+q+r+s) = 0.20 to 0.80, and s/(p+q+r+s) = 0.01 to 0.40; and

at least one of R51 to R56 represents a phenyl group corresponding to an aryl group, at least one of R51 to R56 represents a hydrogen atom directly bound to a silicon atom, and the rest of the R51 to R56 other than phenyl groups and hydrogen atoms directly bound to a silicon atom represent $C_1$ to $C_8$ hydrocarbon groups, R57 to R60 each represent a $C_1$ to $C_8$ hydrocarbon group, and R61 represents a $C_1$ to $C_8$ bivalent hydrocarbon group;

(Formula a1)

[Aryl group content (mol%)] = [(Average number of aryl group included in one molecule of the first silicone resin A × Molecular weight of the aryl group) / (Number average molecular weight of the first silicone resin A)] × 100

(Formula b1)

[A total content of aryl group and phenylene group (mol%)] = [(Average number of aryl group included in one molecule of the first silicone resin B × Molecular weight of the aryl group + Average number of phenylene group included in one molecule of the first silicone resin B × Molecular weight of the phenylene group)/(Number average molecular weight of the first silicone resin B)] × 100

(Formula a51)

[Aryl group content (mol%)] = [(Average number of aryl group included in one molecule of the second silicone resin A × Molecular weight of the aryl group)/(Number average molecular weight of the second silicone resin A)] × 100

(Formula b51)

[A total content of aryl group and phenylene group (mol%)] = [(Average number of aryl group included in one molecule of the second silicone resin B × Molecular weight of the aryl group + Average number of phenylene group included in one molecule of the second silicone resin B × Molecular weight of the phenylene group)/(Number average molecular weight of the second silicone resin B)] × 100

**2.** The sealant for an optical semiconductor device according to claim 1, comprising at least one of the first silicone resin B and the second silicone resin B.

**3.** The sealant for an optical semiconductor device according to claim 1,
wherein the first silicone resin component is the first silicone resin A,
the first silicone resin A contains a first silicone resin A-1 represented by formula (1A-1) shown below,
the first silicone resin A-1 not containing a hydrogen atom bound to a silicon atom, but containing an aryl group and an alkenyl group, and
an aryl group content in the first silicone resin A-1 calculated based on formula (a1-1) shown below is from 30 mol% to 70 mol%;

**[Chem. 5]**

$$(R1R2R3SiO_{1/2})_a(R4R5SiO_{2/2})_b \qquad \text{Formula(1A-1)}$$

In the formula (1A-1), a, and b satisfy the following equations: a/(a+b) = 0.05 to 0.50, and b/(a+b) = 0.50 to 0.95, at least one of R1 to R5 represents a phenyl group corresponding to an aryl group, at least one of R1 to R5 represents an alkenyl group, and the rest of the R1 to R5 other than phenyl groups and alkenyl groups represent $C_1$ to $C_8$ hydrocarbon groups, provided that, a unit represented by ($R1R2R3SiO_{1/2}$) in the formula (1B) includes a unit in which R1 represents an alkenyl group, R2 and R3 each represent an alkenyl group, an aryl group, or a $C_1$ to $C_8$ hydrocarbon group;

(Formula a1-1)

[Aryl group content (mol%)] = [(Average number of aryl group included in one molecule of the first silicone resin A-1 × Molecular weight of the aryl group) / (Number average molecular weight of the first silicone resin A-1)] × 100

**4.** The sealant for an optical semiconductor device according to claim 3,
wherein the first silicone resin A includes the first silicone resin A-1, and optionally includes a first silicone resin A-2 represented by formula (1A-2) shown below,
the first silicone resin A-2 not being equivalent to the first silicone resin A-1, not containing a hydrogen atom bound to a silicon atom, but containing an aryl group and an alkenyl group,
the aryl group content, in the case where the first silicone resin A-2 is included, in the first silicone resin A-2 calculated based on formula (a1-2) shown below is from 30 mol% to 70 mol%, and
the amount of the first silicone resin A-1 in a total 100 wt% of the first silicone resin A-1 and the first silicone resin A-2 is more than 50 wt% and not more than 100 wt%;
**[Chem. 6]**

$$(R1R2R3SiO_{1/2})_a(R4R5SiO_{2/2})_b(R6SiO_{3/2})_c \qquad \text{Formula(1A-2)}$$

In the formula (1A-2), a, b and c satisfy the following equations: a/(a+b+c) = 0 to 0.50, b/(a+b+c) = 0.40 to 1.0, and c/(a+b+c) = 0 to 0.50, at least one of R1 to R6 represents a phenyl group corresponding to an aryl group, at least one of R4 to R6 represents an alkenyl group, and the rest of the R1 to R6 other than phenyl groups and alkenyl groups represent $C_1$ to $C_8$ hydrocarbon groups;

(Formula a1-2)

[Aryl group content (mol%)] = [(Average number of aryl group included in one molecule of the first silicone resin A-2 × Molecular weight of the aryl group) / (Number average molecular weight of the first silicone resin A-2)] × 100

**5.** The sealant for an optical semiconductor device according to claim 3 or 4,
wherein the first silicone resin A includes the first silicone resin A-1 and the first silicone resin A-2 represented by the formula (1A-2) shown below,
the first silicone resin A-2 not being equivalent to the first silicone resin A-1, not containing a hydrogen atom bound to a silicon atom, but containing an aryl group and an alkenyl group, and

the aryl group content in the first silicone resin A-2 calculated based on the formula (a1-2) shown below is from 30 mol% to 70 mol%;

**[Chem. 7]**

$$(R1R2R3SiO_{1/2})_a(R4R5SiO_{2/2})_b(R6SiO_{3/2})_c \quad \text{Formula(1A-2)}$$

In the formula (1A-2), a, b and c satisfy the following equations: a/(a+b+c) = 0 to 0.50, b/(a+b+c) = 0.40 to 1.0, and c/(a+b+c) = 0 to 0.50, at least one of R1 to R6 represents a phenyl group corresponding to an aryl group, at least one of R4 to R6 represents an alkenyl group, and the rest of the R1 to R6 other than phenyl groups and alkenyl groups represent $C_1$ to $C_8$ hydrocarbon groups;

(Formula a1-2)

[Aryl group content (mol%)] = [(Average number of aryl group included in one molecule of the first silicone resin A-2 × Molecular weight of the aryl group) / (Number average molecular weight of the first silicone resin A-2)] × 100

**6.** The sealant for an optical semiconductor device according to claim 4 or 5,
wherein the first silicone resin A include the first silicone resin A-1 and the first silicone resin A-2, and
the amount of the first silicone resin A-1 based on 100 parts by weight of the first silicone resin A-2 is from 5 parts by weight to 100 parts by weight.

**7.** The sealant for an optical semiconductor device according to any one of claims 1 to 6,
wherein the second silicone resin component is the second silicone resin A.

**8.** The sealant for an optical semiconductor device according to any one of claims 1 to 7,
wherein, a unit represented by $(R51R52R53SiO_{1/2})$ in the formula (51A) includes a unit in which R1 represents a hydrogen atom bound to a silicon atom, and R52 and R53 each represent a hydrogen atom, a phenyl group, or a $C_1$ to $C_8$ hydrocarbon group.

**9.** The sealant for an optical semiconductor device according to any one of claims 1 to 8,
wherein the first silicone resin A and the second silicone resin B each include a diphenyl siloxane unit comprising one silicon atom and two phenyl groups bound to the silicon atom, and
the proportion of the diphenyl siloxane unit comprising one silicon atom and two diphenyl groups bound to the silicon atom in 100 mol% of the total siloxane unit of the first silicone resin A and the second silicone resin B is at least 30 mol%.

**10.** The sealant for an optical semiconductor device according to any one of claims 1 to 9,
wherein the second silicone resin A and the second silicone resin B each include a unit represented by formula (51-a) shown below, and
the proportion of the unit represented by the formula (51-a) in 100 mol% of the total siloxane unit of the second silicone resin A and the second silicone resin B is at least 5 mol%;

**[Chem. 8]**

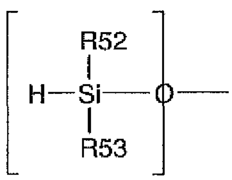

···Formula (51-a)

In the formula (51-a), R52 and R53 each represent a hydrogen atom, a phenyl group, or a $C_1$ to $C_8$ hydrocarbon group.

**11.** The sealant for an optical semiconductor device according to any one of claims 1 to 10, further comprising silicon oxide particles.

**12.** The sealant for an optical semiconductor device according to claim 11,
wherein the silicon oxide particles have undergone a surface treatment with an organic silicon compound.

**13.** The sealant for an optical semiconductor device according to claim 12,
wherein the organic silicon compound is at least one selected from the group consisting of an organic silicon compound containing a dimethyl silyl group, an organic silicon compound containing a trimethyl silyl group, and an organic silicon compound containing a polydimethyl siloxane group.

**14.** The sealant for an optical semiconductor device according to any one of claims 1 to 13,
wherein each of the first silicone resin A and the first silicone resin B has a viscosity of 500 mPa·s to 20000 mPa·s measured with an E-type viscometer at 5 rpm at a temperature of 25°C, and
each of the second silicone resin A and the second silicone resin B has a viscosity of 500 mPa·s to 5000 mPa·s measured with an E-type viscometer at 5 rpm at a temperature of 25°C.

**15.** The sealant for an optical semiconductor device according to any one of claims 1 to 14,
wherein the sealant has a viscosity of 1000 mPa·s to 10000 mPa·s measured with an E-type viscometer at 5 rpm at a temperature of 25°C.

**16.** The sealant for an optical semiconductor device according to any one of claims 1 to 15,
wherein the sealant has a minimum viscosity at a shear rate of 1 $s^{-1}$ of at least 200 mPa·s in a temperature range of 25°C to the curing temperature, when heated in a parallel plate rheometer from 25°C at a temperature increase rate of 20°C/min.

**17.** The sealant for an optical semiconductor device according to any one of claims 1 to 16,
wherein the ratio of the viscosity of the sealant measured with an E-type viscometer at 1 rpm at a temperature of 25°C relative to the viscosity of the sealant measured with an E-type viscometer at 10 rpm at a temperature of 25°C is 1.2 to 2.5.

**18.** The sealant for an optical semiconductor device according to any one of claims 1 to 17, further comprising a phosphor.

**19.** An optical semiconductor device, comprising an optical semiconductor element, and
the sealant for an optical semiconductor device according to any one of claims 1 to 18, which is provided to seal the optical semiconductor element.

[FIG. 1]

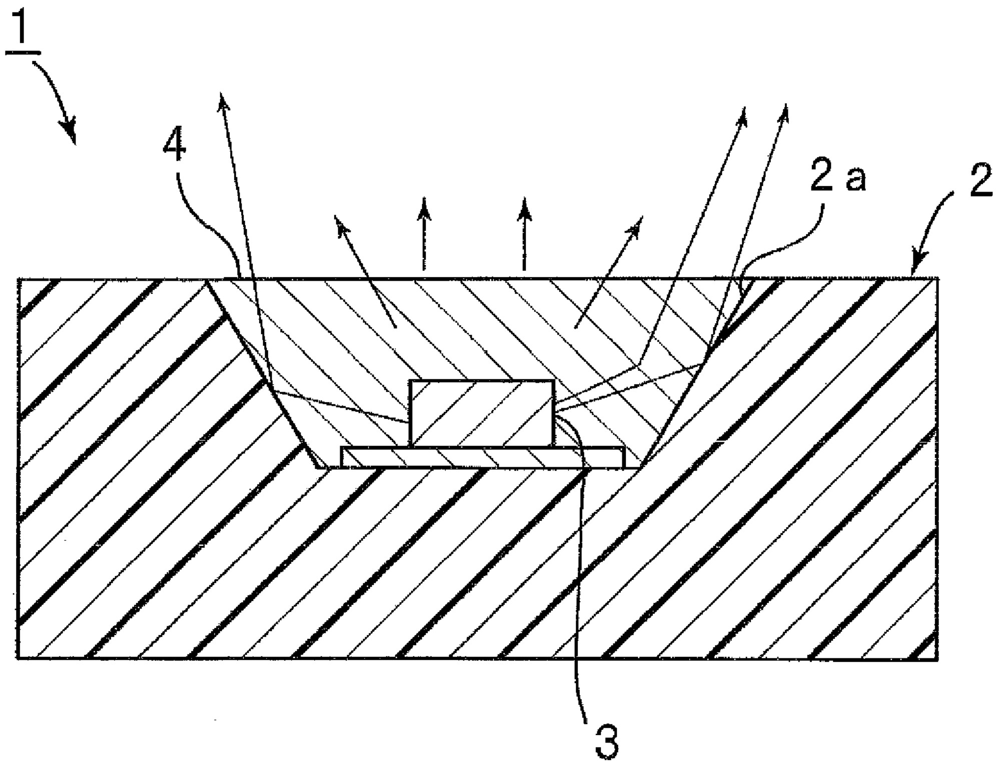

**INTERNATIONAL SEARCH REPORT**

International application No.
PCT/JP2011/056595

A. CLASSIFICATION OF SUBJECT MATTER
*C08L83/07*(2006.01)i, *C08L83/05*(2006.01)i, *C08L83/14*(2006.01)i, *H01L23/29*(2006.01)i, *H01L23/31*(2006.01)i, *H01L33/56*(2010.01)i

According to International Patent Classification (IPC) or to both national classification and IPC

B. FIELDS SEARCHED

Minimum documentation searched (classification system followed by classification symbols)
C08L83/00-83/16, C09K3/10, H01L23/28-23/31, H01L33/52-33/56

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)
CA/REGISTRY(STN)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2006-519896 A (Nusil Technology L.L.C.), 31 August 2006 (31.08.2006), claims; paragraphs [0046] to [0070](examples 1 to 4) & US 2004/0198924 A1 & EP 1599747 A & WO 2004/074885 A1 | 1,3-19<br>2,3-6,8-10 |
| X<br>Y | JP 2004-359756 A (WACKER ASAHIKASEI SILICONE CO., LTD.), 24 December 2004 (24.12.2004), claims; examples & US 2006/0081864 A1 & EP 1651724 A & WO 2004/107458 A2 | 1,7,11-19<br>2,3-6,8-10 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 14 June, 2011 (14.06.11) | 05 July, 2011 (05.07.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2011/056595

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2008-111117 A (Rohm and Haas Co.), 15 May 2008 (15.05.2008), claims; example 2 & US 2008/0090986 A1 & EP 1914262 A1 | 2 |
| Y | JP 2005-105217 A (Dow Corning Toray Silicone Co., Ltd.), 21 April 2005 (21.04.2005), claims; examples & US 2007/0112147 A1 & EP 1670863 A & WO 2005/033207 A1 | 3-6,8-10 |
| Y | JP 2005-76003 A (GE Toshiba Silicones Co., Ltd.), 24 March 2005 (24.03.2005), claims; examples (Family: none) | 3-6,8-10 |
| A | JP 2010-508377 A (Dow Corning Corp.), 18 March 2010 (18.03.2010), claims; examples & EP 2069829 A & WO 2008/027280 A2 | 1-19 |
| A | JP 2009-523856 A (Dow Corning Corp.), 25 June 2009 (25.06.2009), claims; examples & US 2009/0146175 A1 & EP 1973963 A & WO 2007/086987 A1 | 1-19 |
| A | WO 2007/125785 A1 (Enikolopov Institute of Synthetic Polymeric Materials (ISPM) of the Russian Academy of Sciences), 08 November 2007 (08.11.2007), claims; examples & US 2009/0105395 A1 | 1-19 |
| A | JP 2010-13503 A (Showa Highpolymer Co., Ltd.), 21 January 2010 (21.01.2010), claims; examples (Family: none) | 1-19 |
| A | WO 2008/065786 A1 (Matsushita Electric Works, Ltd.), 05 June 2008 (05.06.2008), claims & JP 2007-251121 A & JP 2007-251122 A | 1-19 |
| A | JP 2009-263433 A (Dow Corning Toray Co., Ltd.), 12 November 2009 (12.11.2009), claims & WO 2009/131023 A1 | 1-19 |

Form PCT/ISA/210 (continuation of second sheet) (July 2009)

INTERNATIONAL SEARCH REPORT

International application No.
PCT/JP2011/056595

C (Continuation). DOCUMENTS CONSIDERED TO BE RELEVANT

| Category* | Citation of document, with indication, where appropriate, of the relevant passages | Relevant to claim No. |
|---|---|---|
| A | JP 2008-274185 A (Shin-Etsu Chemical Co., Ltd.), 13 November 2008 (13.11.2008), claims & US 2008/0281056 A1 & EP 1990367 A2 | 1-19 |
| P,A | JP 2010-180323 A (Shin-Etsu Chemical Co., Ltd.), 19 August 2010 (19.08.2010), claims (Family: none) | 1-19 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2003073452 A
- JP 2009227849 A
- JP 2002314142 A